(19) Europäisches Patentamt
European Patent Office
Office européen des brevets

(11) **EP 4 501 629 A1**

(12) **EUROPEAN PATENT APPLICATION**
published in accordance with Art. 153(4) EPC

(43) Date of publication:
**05.02.2025 Bulletin 2025/06**

(21) Application number: **23779344.3**

(22) Date of filing: **08.03.2023**

(51) International Patent Classification (IPC):
**B32B 27/00** (2006.01)     **B32B 7/023** (2019.01)

(52) Cooperative Patent Classification (CPC):
**B32B 7/023; B32B 27/00**

(86) International application number:
**PCT/JP2023/008766**

(87) International publication number:
**WO 2023/189317 (05.10.2023 Gazette 2023/40)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **28.03.2022   JP 2022051261**

(71) Applicant: **Toray Industries, Inc.**
**Tokyo 103-8666 (JP)**

(72) Inventors:
• **MATSUI, Hisato**
  **Otsu-shi, Shiga 520-8558 (JP)**
• **TAMURA, Mayumi**
  **Otsu-shi, Shiga 520-8558 (JP)**
• **UTO, Takayuki**
  **Otsu-shi, Shiga 520-8558 (JP)**
• **GOUDA, Wataru**
  **Otsu-shi, Shiga 520-8558 (JP)**

(74) Representative: **Mewburn Ellis LLP**
**Aurora Building**
**Counterslip**
**Bristol BS1 6BX (GB)**

(54) **LAMINATED FILM**

(57)     An object of the present invention is to provide a laminated film that exhibits superior reflective properties with respect to visible light without occurrence of inter-layer peeling even in long-term continuous use, and the gist of the present invention is a laminated film that continuously includes three or more ordered arrays composed of thermoplastic resin layers of three different types and satisfies the following conditions X and Y simultaneously, Condition X: where thermoplastic resin layers of three different types are denoted by layer A, layer B, and layer C, the thickness ratio A/B of the layer A to the layer B in an ordered array is 0.60 or more and 5.00 or less, and a thickness ratio C/B of the layer C to the layer B in an ordered array is 0.70 or more and 5.00 or less; Condition Y: a maximum reflectance at a wavelength of 400 to 800 nm is 35% or more and 100% or less.

【FIG. 1】

**Description**

TECHNICAL FIELD

The present invention relates to a laminated film that can reduce interlayer peeling even in long-term continuous use and exhibits superior reflective properties with respect to visible light.

BACKGROUND ART

Light control films capable of selectively shielding and allowing to permeate a light beam in a specific wavelength band have been put into practical use in a wide variety of fields for the purpose of preventing deterioration of the internal environment and components of a product from environmental factors such as light and heat rays and extracting only a light beam in a specific wavelength band to develop a desired color tone. In particular, in the field of electronic information devices, there is a high need for light control films, and with the recent trend of reducing the thickness of displays, there is an increasing demand for reducing the thickness of a light control film, which is one of constituent members. In addition, also in the automobile field, when the development of electric vehicles progresses, replacement of members that have been conventionally made of metal with resin molded articles or sheets that exhibit a metallic tone has also progressed for the purpose of weight reduction, and metallic-tone films or sheets that exhibit high visible light reflectance like metal have also attracted attention.

As a technique for selectively shielding a light beam in a specific wavelength band, an absorption type light control film in which a light absorber such as a dye, a pigment, an ultraviolet ray/heat ray absorber is added to a resin constituting the film is widely used (Patent Document 1). However, the light absorption characteristics of such an absorption type light control film depend on the product of the addition concentration of the light absorber and the film thickness, and it is necessary to increase the addition concentration of the light absorber in order to thin the film. However, if the amount of the light absorber is increased in order to maintain the light absorption characteristics, surface deposition becomes remarkable depending on the type of the light absorber, and film defects due to the film forming step pollution become a problem. On the other hand, if the amount of the light absorber is reduced in order to avoid the above problem, there is a problem that the light absorber is insufficient and light absorption characteristics are deteriorated. Furthermore, since the light absorber needs to be selected in accordance with the wavelength band to be shielded, when a wide wavelength band is shielded, a considerable amount of addition is required by using a plurality of types of light absorbers in combination. In addition, when a dye or a pigment is selected, the former is poor in light resistance, and the latter is disadvantageous in that color tone selectivity cannot be obtained due to a wide range of absorption performance.

As a light control film that solves such drawbacks of the absorption type, a reflection type light control film in which layers differing in refractive index are laminated in the film thickness direction and interference reflection based on a light interference theory is utilized has attracted attention. As one example of a method for producing a reflection type light control film, a method of repeatedly laminating metal thin film layers differing in refractive index by a sputtering/vapor deposition technique is known. However, in order to obtain a light control film by such a method, it is necessary to repeatedly laminate a plurality of different metal layers in order, and thus the manufacturing cost increases by executing a considerable number of steps. In addition, such a light control film has a problem that reflection characteristics are impaired due to cleavage or peeling of the sputter/deposited film from fatigue in applications requiring bending.

Then, as different light control films of reflection type, light control films in which thermoplastic resin layers differing in refractive index are laminated instead of metal thin film layers are actively studied. The light control film in which thermoplastic resin layers differing in refractive index are laminated is obtained by laminating thermoplastic resins derived from different extruders over several tens to several hundreds of layers at once in a desired array by using a special laminating device such as a square mixer or a feed block. Unlike a film formed of a laminate including a metal thin film layer, such a light control film has an advantage that a target reflection band can be easily changed only by changing the thickness of the film through a stretching step or the like.

Among them, many known techniques have been reported for a light control film having an (AB)x configuration (x is a natural number representing the number of repetitions) in which two types of thermoplastic resin layers (layer A, layer B) differing in refractive index are alternately laminated. For example, there have been reported a plurality of techniques such as a technique of reflecting a light beam in a wide wavelength band by continuously imparting an inclined distribution to a layer thickness, a technique of designing an optical thickness to be 1/4 of a wavelength in order to suppress an unnecessary reflection band on a short wavelength side (this is referred to as higher order reflection) generated in a wavelength band other than a desired wavelength band (Patent Documents 2 and 3), and a technique of performing special layer thickness patterning having a ratio of 1 : 7 : 1 (Patent Documents 4 and 5).

PRIOR ART DOCUMENT

PATENT DOCUMENTS

Patent Document 1: Japanese Patent Laid-open Publication No. 2013-210598
Patent Document 2: Japanese Patent Laid-open Publication (Translation of PCT Application) No. 2004-503402
Patent Document 3: Japanese Patent Laid-open Publication (Translation of PCT Application) No. H08-503312
Patent Document 4: US Patent No. 5,360,659
Patent Document 5: Japanese Patent Laid-open Publication No. 2018-205615

SUMMARY OF THE INVENTION

PROBLEMS TO BE SOLVED BY THE INVENTION

However, in the reflection type light control films having the (AB)x configuration (x is a natural number representing the number of repetitions) disclosed in Patent Documents 2 to 5, in order to extend the reflection band (wide band) or increase the reflectance (high reflectance), it is necessary to increase the number of laminated layers or to increase the difference in refractive index between the thermoplastic resin layers of two types. In the former case, since the film becomes thicker as the number of layers increases, an aspect going against the recent thinning tendency is obtained. On the other hand, in the latter case, since it is required to laminate thermoplastic resin layers using thermoplastic resins having greatly different molecular skeleton structures, interlayer peeling is prone to occur at the interface between adjacent different thermoplastic resin layers. As a result, as in the case of the metal thin film layer, there is a problem that the laminated film cannot maintain the original laminated configuration and the inherent performance, namely wide band and high reflectance, is impaired due to fatigue in repeated use such as bending or long-term use in a severe environment. Therefore, the reflection type light control films having the (AB)x configuration disclosed in Patent Documents 2 to 5 are difficult to apply to applications requiring wide band and high reflectance although being thin films.
Accordingly, an object of the present invention is to provide a laminated film that can reduce interlayer peeling even in long-term continuous use and can maintain optical characteristics of wide band and high reflectance for a long period of time.

SOLUTIONS TO THE PROBLEMS

In order to solve the above problems, a first laminated film of the present invention, a second laminated film of the present invention, and a third laminated film of the present invention have the following configurations.
A first laminated film of the present invention is a laminated film continuously including three or more ordered arrays composed of thermoplastic resin layers of three different types, in which the laminated film simultaneously satisfies the following conditions X and Y,

Condition X: where thermoplastic resin layers of three different types are denoted by layer A, layer B, and layer C, the thickness ratio A/B of the layer A to the layer B in an ordered array is 0.60 or more and 5.00 or less, and a thickness ratio C/B of the layer C to the layer B in an ordered array is 0.70 or more and 5.00 or less;
Condition Y: a maximum reflectance at a wavelength of 400 to 800 nm is 35% or more and 100% or less.

A second laminated film of the present invention is a laminated film continuously including three or more ordered arrays each composed of thermoplastic resin layers of three types differing in refractive index, in which where the three types of thermoplastic resin layers are denoted by layer a, layer b, and layer c in descending order with respect to refractive index, ordered arrays exhibiting a thickness ratio a/b of the layer a to the layer b of 1.40 or more and a thickness ratio c/b of the layer c to the layer b of 1.40 or more exist 90% or more in all the ordered arrays, and the laminate film has a reflection band that exhibits a reflectance of 20% or more continuously over 100 nm or more in a wavelength range of 300 to 2600 nm.
A third laminated film of the present invention is a laminated film continuously including three or more ordered arrays each composed of thermoplastic resin layers of three different types, in which the laminated film has a reflection band continuously exhibiting a reflectance of 75% or more over 100 nm or more in a wavelength range of 400 to 800 nm, and thermoplastic resin layers having a layer thickness of 1 nm or more and 25 nm or less account for 30% or more and 80% or less in number of all the thermoplastic resin layers constituting the ordered arrays.

EFFECTS OF THE INVENTION

By the present invention, interlayer peeling is greatly reduced even when thermoplastic resin layers differing in molecular skeleton structure that exhibit interlayer peeling when laminated adjacent to each other are applied, and as a result, it is possible to obtain a laminated film capable of maintaining optical characteristics of wide band and high reflectance in a visible light region for a longer period of time due to the utilization of a difference in refractive index between these thermoplastic resin layers.

BRIEF DESCRIPTION OF THE DRAWINGS

Fig. 1 is a schematic diagram showing a relationship between a depth in a thickness direction and a contrast difference (gray level) in a sectional observation image of one aspect of a laminated film having an ordered array of (ABCB)x.
Fig. 2 is a schematic diagram showing a relationship between a depth in a thickness direction and a contrast difference (gray level) in a sectional observation image of one aspect (a different aspect from Fig. 1) of a laminated film having an ordered array of (ABCB)x.
Fig. 3 is a schematic diagram showing a relationship between a depth in a thickness direction and a contrast difference (gray level) in a sectional observation image of a laminated film having an (AB)x alternately laminated array.
Fig. 4 is a schematic diagram showing a wavelength band $\Pi$, a reflection bandwidth $\lambda$, and a maximum reflectance in a reflection optical spectrum of a laminated film according to one embodiment of the present invention.
Fig. 5 is a schematic diagram showing a wavelength band $\Pi$, a reflection bandwidth $\lambda$, and a maximum reflectance in a reflection optical spectrum of a laminated film according to one embodiment (a different aspect from Fig. 4) of the present invention.
Fig. 6 is a schematic diagram showing a wavelength band $\Pi$, a reflection bandwidth $\lambda$, and a maximum reflectance in a reflection optical spectrum of a laminated film according to one aspect (a different aspect from Figs. 4 and 5) of the present invention.
Fig. 7 is a schematic diagram showing a wavelength band $\Pi$, a reflection bandwidth $\lambda$, and a maximum reflectance in a reflection optical spectrum of a laminated film according to one embodiment (a different aspect from Figs. 4, 5 and 6) of the present invention.
Fig. 8 is a schematic diagram showing a loss tangent $\tan\delta$ spectrum obtained in dynamic viscoelasticity measurement of a laminated film of the present invention.

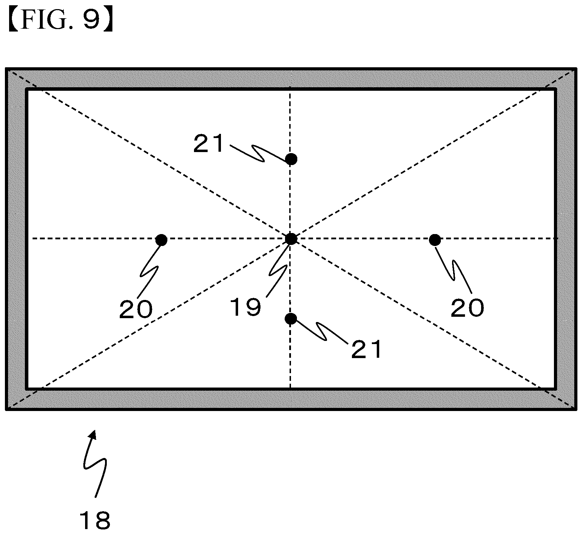

Fig. 9 is a schematic view showing measurement points used when a laminated film of the present invention is mounted on a light source unit and evaluated.

EMBODIMENTS OF THE INVENTION

Laminated films according to the present invention will be described in detail below. The laminated films of the present invention include a first laminated film of the present invention, a second laminated film of the present invention, and a third laminated film of the present invention. Hereinafter, the "laminated film of the present invention" shall refer to all of them unless otherwise specified. In addition, to describe the layer configuration of the laminated film of the present invention, such expressions as (ABCB)x, (abcb)x, and ($\alpha\beta\gamma\beta$)x may be used and, in such expressions, the reference sign in parentheses is an ordered array, and x is a natural number representing repeating units. For example, (ABCB)x means a layer configuration in which x ordered arrays in which the layer A, the layer B, the layer C, and the layer B are located in this order are repeated. In the present invention, the "refractive index" refers to a refractive index in an in-plane direction (in-plane refractive index), and a method for the measurement thereof will be described later.
A first laminated film of the present invention is a laminated film continuously including three or more ordered arrays composed of thermoplastic resin layers of three different types, in which the laminated film simultaneously satisfies the following conditions X and Y,
[0018]    Condition X: where thermoplastic resin layers of three different types are denoted by layer A, layer B, and layer C, the thickness ratio A/B of the layer A to the layer B in an ordered array is 0.60 or more and 5.00 or less, and a thickness ratio C/B of the layer C to the layer B in an ordered array is 0.70 or more and 5.00 or less;
Condition Y: a maximum reflectance at a wavelength of 400 to 800 nm is 35% or more and 100% or less.
A second laminated film of the present invention is a laminated film continuously including three or more ordered arrays each composed of thermoplastic resin layers of three types differing in refractive index, in which where the three types of thermoplastic resin layers are denoted by layer a, layer b, and layer c in descending order with respect to refractive index, ordered arrays exhibiting a thickness ratio a/b of the layer a to the layer b of 1.40 or more and a thickness ratio c/b of the layer c to the layer b of 1.40 or more exist 90% or more in all the ordered arrays, and the laminate film has a reflection band that exhibits a reflectance of 20% or more continuously over 100 nm or more in a wavelength range of 300 to 2600 nm.

A third laminated film of the present invention is a laminated film continuously including three or more ordered arrays each composed of thermoplastic resin layers of three different types, in which the laminated film has a reflection band continuously exhibiting a reflectance of 75% or more over 100 nm or more in a wavelength range of 400 to 800 nm, and thermoplastic resin layers having a layer thickness of 1 nm or more and 25 nm or less account for 30% or more and 80% or less in number of all the thermoplastic resin layers constituting the ordered arrays.

The first and third laminated films of the present invention are each required to have thermoplastic resin layers of three different types. In these laminated films of the present invention, the phrase that the thermoplastic resin layers are "different" refers to a case corresponding to at least one of the following: (1) different in composition, (2) different in glass transition temperature or melting point in differential scanning calorimetry (DSC), and (3) different in contrast between images taken after dyeing when observed in section by transmission electron microscope observation (TEM).

The phrase "different in composition" means that it does not satisfy the following condition that is regarded as "the same in composition". The phrase "the same in composition" refers to a case where repeating units of the chemical structures of the thermoplastic resins constituting the respective thermoplastic resin layers are common at 95 mol% or more and 100 mol% or less, or a case where components are common at 95 mass% 100 mass% or less when components of the respective thermoplastic resin layers are compared.

In the former case, for example, polyethylene terephthalate has, as a main constituent unit, a constituent unit (ethylene terephthalate unit) in which an ethylene glycol unit and a terephthalic acid unit are linked via an ester linkage, but as in a combination of a layer formed of homopolyethylene terephthalate and a layer formed of polyethylene terephthalate copolymerized with 10 mol% of isophthalic acid, when the amount of a copolymerization component exceeds 5 mol% while the resins constituting the layers have a common chemical structure of polyethylene terephthalate, these layers are regarded to be different in composition. In the latter case, as in a combination of a layer formed only of homopolyethylene terephthalate and a layer containing 90 mass% of homopolyethylene terephthalate and the remaining 10 mass% of which is another component, when the layers contain the same component as a main component but the components more than 5 mass% are different from each other, these layers are regarded to be different in composition. The repeating unit structure of a specific composition/chemical structure of each thermoplastic resin layer can be identified using infrared spectroscopy (FT-IR method or nano IR method), a gas chromatography/mass spectrometer (GC-MS), a nuclear magnetic resonance device (NMR), or the like by grasping the layer thickness of each thermoplastic resin layer according to the method described in the layer configuration of the measurement method described later, and then cutting out the thermoplastic resin layer, or cutting out the layer to obtain the outermost layer.

On the other hand, when it is difficult to identify the compositions by the above method after extraction for each thermoplastic resin layer, it can be determined that the thermoplastic resin layers constituting the laminated film are "different" when the layers exhibit different melting points and/or glass transition points in differential scanning calorimetry (DSC). In the first and third laminated films of the present invention, exhibiting different melting points and different glass transition temperatures means that the melting point and the glass transition point are different by 0.1°C or more, preferably 2.0°C or more (in other words, it means that the difference in melting point and the difference in glass transition point of the thermoplastic resin layers are 0.1°C or more, and preferably 2.0°C or more). The most easily interpreted example is a case where any one of glass transition point, crystallization temperature (exothermic peak), and melting point (endothermic peak) is confirmed at three different temperatures when the laminated film is subjected to differential scanning calorimetry. On the other hand, in the measurement temperature range of 25°C or more and 300°C or less described in the section of differential scanning calorimetry (DSC) in the measurement method described later, the thermoplastic resins exhibit neither a glass transition temperature nor a melting point in some cases. When one thermoplastic resin layer exhibits a glass transition temperature or a melting point and the other thermoplastic resin layer exhibits neither a glass transition temperature nor a melting point, it cannot be calculated as a difference in melting point, but it is interpreted that the thermoplastic resin layers are different. For example, when three glass transition points are observed while only two melting points are observed, it can be interpreted that one type of thermoplastic resin layer among the three types of thermoplastic resin layers is made of an amorphous thermoplastic resin having no melting point. As another aspect, when the melting point can be confirmed at three points, but the glass transition temperature or the crystallization temperature can be confirmed at only two points or less within the above temperature range, it can be interpreted that the thermoplastic resin layers include a thermoplastic resin layer having a glass transition temperature or a crystallization temperature in a low temperature region outside that temperature range. In the present invention, the measurement by DSC can be performed in accordance with the method of JIS-K-7122 (1987), and the details will be described later.

In the above two methods, it is necessary to separate the corresponding thermoplastic resin layer from the film for analysis, and determination of the composition may be difficult. Thus, in the first and third laminated films of the present invention, for convenience, when a layer interface due to a contrast difference can be recognized in a sectional image observed by transmission electron microscope observation, and when it can be confirmed by the method described in the section of the layer interface (contrast difference) in the measurement method to be described later that a difference between average values of brightness of two adjacent layers is larger than any of standard deviations of brightness in each layer of the adjacent thermoplastic resin layers, it is determined that the contrast of the image after dyeing is different, and the compositions of the adjacent thermoplastic resin layers are "different".

This contrast difference is caused by difference in scattering of electron beams, crystal diffraction, and the like between thermoplastic resin layers. Thus, when the compositions of the thermoplastic resin layers are different in accordance with the above-described criteria, the crystallinity and the electron density state are different depending on the type of the thermoplastic resin constituting each thermoplastic resin layer and the copolymerization amounts of the thermoplastic resins to be combined, and the electron dyeing state is also different. For this reason, when thermoplastic resin layers having different compositions are provided, each thermoplastic resin layer can be visually recognized as a layer structure having a contrast difference in a sectional image of the laminated film.

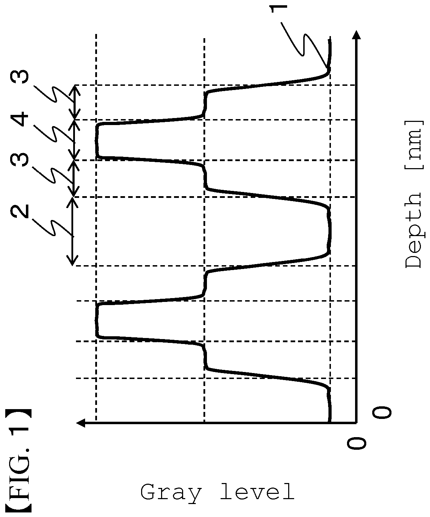

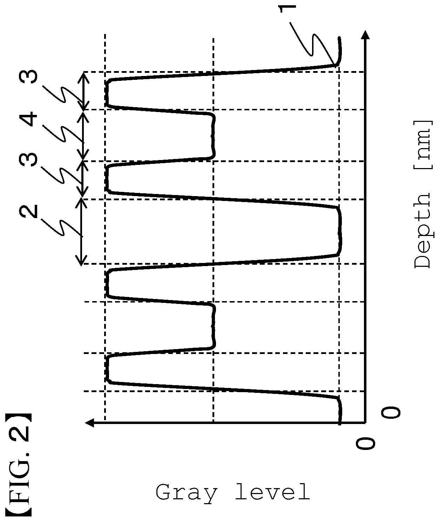

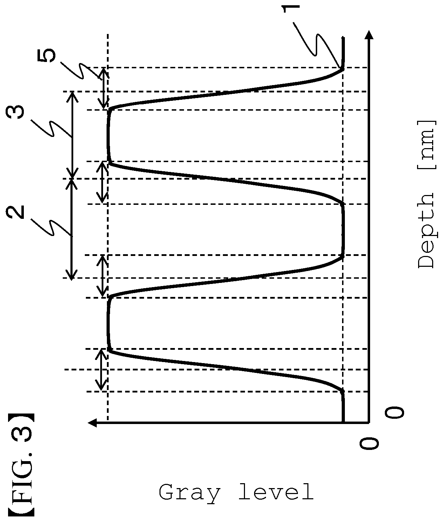

In the case of a laminated film having thermoplastic resin layers of three different types as in the first and third laminated films of the present invention, since constant brightness is exhibited in each thermoplastic resin layer, when the depth in the thickness direction is represented by the horizontal axis and the brightness/contrast (gray level in gray scale display) at each point is represented by the vertical axis, a graph in which the brightness changes stepwise as shown in Figs. 1 and 2 is obtained. Figs. 1 and 2 are schematic diagrams showing the relationship between the depth in the thickness direction and the contrast difference (gray level) in a sectional observation image of one aspect of a laminated film having an ordered array of (ABCB)x, and Fig. 3 is a schematic diagram showing the relationship between the depth in the thickness direction and the contrast difference (gray level) in a sectional observation image of a laminated film having an (AB)x alternately laminated array. In Figs. 1 to 3, reference signs 1 to 5 denote in order a spectrum showing the relationship between the depth in the thickness direction and the contrast (gray level) change of a laminated film having an ABCB ordered array, the layer thickness of the layer A, the layer thickness of the layer B, the layer thickness of the layer C, and the layer thickness of the interface layer of a laminated film having an AB alternately laminated array.

In a case where a laminated film is composed of two types of thermoplastic resin layers showing a conventional ordered array of (AB)x, a graph that repeats going up and down between two points of brightness as shown in Fig. 3. In the diagram, there is also an idea that a region where brightness varies between the two points indicated by reference sign 5 is defined as an interface layer and three types of thermoplastic resin layers are included, but in the first and third laminated films of the present invention, such an aspect is not dealt as having thermoplastic resin layers of three different types. That is, in these inventions, it is determined whether or not there are thermoplastic resin layers of three different types depending on the definition of the interface layer by the contrast difference described above and the like. The presence or absence of the contrast difference can be evaluated by a method described later.

The second laminated film of the present invention is required to have thermoplastic resin layers of three types differing in refractive index. The thermoplastic resin layers different in refractive index are determined from the dielectric constants of the respective thermoplastic resin layers obtained by electron energy loss spectroscopy (EELS measurement) in accordance with the method described in the measurement method section described later. More specifically, the determination can be made by the following procedure. First, the main orientation axis direction of a section of the laminated film is specified with a retardation measuring device KOBRA-WPR manufactured by Oji Scientific Instruments Co., Ltd. (for example, KOBRA-21ADH can perform similar measurement, and this may be used), and a section sample of the laminated film is acquired with the main orientation axis direction and the thickness direction of the laminated film included. Next, each of the thermoplastic resin layers in the section sample is irradiated with an electron beam, and the dielectric constant thereof is analyzed to read the dielectric constant at loss energy of 2.5eV. When the difference between the obtained dielectric constants of the thermoplastic resin layers is 0.01 or more, it is determined that the thermoplastic resin layers is "different" in refractive index. According to Maxwell's electromagnetic theory, the dielectric constant is generally equal to the square of the refractive index with a non-magnetic substance that hardly absorbs light, such as a thermoplastic resin (described later) that can be suitably used in the laminated film of the present invention. Therefore, it can be determined that the thermoplastic resin layers are different in refractive index on the basis of the fact that the thermoplastic resin layers are different in dielectric constant, and the magnitude relationship on dielectric constant of the thermoplastic resin layers coincides with the magnitude relationship on refractive index of the thermoplastic resin layers. Although details will be described later, the magnitude relationship on refractive index in the EELS measurement can also be applied to the first and third laminated films of the present invention.

Representative thermoplastic resins to be used for forming the thermoplastic resin layers of the laminated film of the present invention are shown below, but the thermoplastic resins that can be used in the present invention is not limited to those described below. Examples thereof include polyolefin resins represented by polyethylene, polypropylene, poly(1-butene), poly(4-methylpentene), polyisobutylene, polyisoprene, polybutadiene, polyvinylcyclohexane, polystyrene, poly($\alpha$-methylstyrene), poly(p-methylstyrene), polynorbornene, polycyclopentene and the like, polyamide resins represented by nylon 6, nylon 11, nylon 12, nylon 66 and the like, copolymer resins of vinyl monomers represented by ethylene/propylene copolymer, ethylene/vinyl cyclohexane copolymer, ethylene/vinyl cyclohexene copolymer, ethylene/alkyl acrylate copolymer, ethylene/acrylic methacrylate copolymer, ethylene/norbornene copolymer, ethylene/vinyl acetate copolymer, propylene/butadiene copolymer, isobutylene/isoprene copolymer, vinyl chloride/vinyl acetate copolymer and the like, acrylic resins represented by polyacrylate, polyisobutyl methacrylate, polymethacrylate, polymethyl methacrylate, polybutyl acrylate, polyacrylamide, polyacrylonitrile and the like, polyester resins represented by polyethylene terephthalate, polypropylene terephthalate, polybutylene terephthalate, polyethylene-2,6-naphthalate and the like, biodegradable polymers represented by polylactic acid, polybutyl succinate and the like, and polyvinyl chloride, polyvinylidene chloride, polyvinyl alcohol, polyvinyl butyral, polyacetal, polyglucholic acid, polycarbonate, polyketone, polyether sulfone, polyether ether ketone, modified polyphenylene ether, polyphenylene sulfide, polyether imide, polyimide, polysiloxane, tetrafluoroethylene resin, trifluoroethylene chloride resin, ethylene tetrafluoride-6 propylene fluoride copolymer, and polyvinylidene fluoride.

Hereinafter, although the laminated film including three different thermoplastic resin layers will be described in detail, three quite different thermoplastic resins can be combined, but, on the assumption that alloying, blending, copolymerization, or the like is performed, three types of different thermoplastic resins are formed using two types of different thermoplastic resins, or alternatively, three types of different thermoplastic resin layers can be formed by adopting an aspect using one type of thermoplastic resin as a base with different copolymerization components.

When thermoplastic resins of two or three different types are used, different thermoplastic resins coexist in the laminating device as will be described for the production method, and therefore, the thermoplastic resins are required to have similar heat resistance and lamination property (viscosity, compatibility, etc.), and it is preferable to use thermoplastic resins having transparency and strength as required for a laminated film to be obtained. When two types of different thermoplastic resins are used, examples of a combination of resins to be laminated include a polyester resin and a polycarbonate resin, a polyester resin and a polyamide resin, a polyester resin and a polyolefin resin such as polypropylene, a polyester resin and an acrylic resin, a polyester resin and a polyvinylidene fluoride resin, a polycarbonate resin and an acrylic resin, a polycarbonate resin and a polyvinylidene fluoride resin, and a polylactic acid and a polyvinylidene fluoride resin. When three types of different thermoplastic resins are used, combinations of a polyester resin, a polycarbonate resin, and an acrylic resin; a polyester resin, a polystyrene resin, and an acrylic resin; a polycarbonate resin, a polystyrene resin, and an acrylic resin; and a polycarbonate resin, an acrylic resin, and a polyvinylidene fluoride resin can be used.

Furthermore, in order to obtain the characteristics such as high reflectance, transparency, and interlayer adhesion of the laminated film of the present invention, as a preferable combination of thermoplastic resins, a combination in which a single type of thermoplastic resin is contained as a base and three types of thermoplastic resins are different in copolymerization component; in the case of using two types of thermoplastic resins as a base, a combination of a polyester resin, a copolymer of a polyester resin, and an acrylic resin; a combination of a polyester resin, a copolymer of a polyester resin, and a polyamide resin; and a combination of a polyester resin, a copolymer of a polyester resin, and a polyolefin resin; in the case of using three types of thermoplastic resins as a base, a combination of a polyester resin, a polycarbonate resin, and an acrylic resin; a combination of a polyester resin, a polystyrene resin, and an acrylic resin; and a combination of a polycarbonate resin, a polystyrene resin, and an acrylic resin can be preferably used.

In each thermoplastic resin layer, one type of these thermoplastic resins may be used alone, or two or more types of thermoplastic resins may be used as a blend or alloy. By performing blending or alloying, physical/chemical properties that cannot be obtained from one type of thermoplastic resin can be obtained, and in lamination of thermoplastic resin layers greatly different in skeleton structure, when the thermoplastic resin layer on one side of thermoplastic resin layers adjacent to each other can be provided with a component common to the polymer skeleton structure contained in the thermoplastic resin layer on the other side as a copolymerization component, interlayer adhesion at the interface can be improved.

In each of the thermoplastic resin layers constituting the laminated film of the present invention, the thermoplastic resin for forming the thermoplastic resin layer is preferably selected especially from among a polyolefin resin, a polyester resin, an acrylic resin, a polycarbonate resin, and a polyamide resin from the viewpoint of the rheological characteristics related to strength, heat resistance, transparency, and lamination properties. Among them, from the aforementioned viewpoint, a polyester resin is more preferably used, and a polyester resin obtained via polymerization of a monomer including an aromatic dicarboxylic acid or an aliphatic dicarboxylic acid and a diol as main components is still more preferable.

Here, examples of the aromatic dicarboxylic acid include terephthalic acid, isophthalic acid, phthalic acid, 1,4-naphthalene dicarboxylic acid, 1,5-naphthalene dicarboxylic acid, 2,6-naphthalene dicarboxylic acid, 4,4'-diphenyl dicarboxylic acid, 4,4'-diphenyl ether dicarboxylic acid, and 4,4'-diphenyl sulfone dicarboxylic acid. Examples of the aliphatic dicarboxylic acid include adipic acid, suberic acid, sebacic acid, dimer acid, dodecanedioic acid, cyclohexanedicarboxylic acid, and ester derivatives thereof. Among them, terephthalic acid and 2,6-naphthalenedicarboxylic acid are preferable. These acid components may be used alone or in combination of two or more, and may be partially copolymerized with an oxyacid such as hydroxybenzoic acid.

Examples of the diol include ethylene glycol, 1,2-propanediol, 1,3-propanediol, neopentyl glycol, 1,3-butanediol, 1,4-butanediol, 1,5-pentanediol, 1,6-hexanediol, 1,2-cyclohexanedimethanol, 1,3-cyclohexanedimethanol, 1,4-cyclohexanedimethanol, diethylene glycol, triethylene glycol, polyalkylene glycol, 2,2-bis(4-hydroxyethoxyphenyl)propane, isosorbate, and spiroglycol. In particular, the use of ethylene glycol is preferred. These diol components may be used singly or two or more thereof may be used in combination.

In each of the thermoplastic resin layers constituting the laminated film of the present invention, among the polyester resins recited above, it is particularly preferable to use a polyester resin selected from among polyethylene terephthalate and a copolymer thereof, polyethylene naphthalate and a copolymer thereof, polybutylene terephthalate and a copolymer thereof, polybutylene naphthalate and a copolymer thereof, polyhexamethylene terephthalate and a copolymer thereof, and polyhexamethylene naphthalate and a copolymer thereof.

The laminated film of the present invention is required to continuously have three or more ordered arrays composed of thermoplastic resin layers of three different types (in the cases of the first and third laminated films of the present invention) or three or more ordered arrays composed of thermoplastic resin layers of three types differing in refractive index (in the case of the second laminated film of the present invention). Specifically, the "ordered array composed of three types of thermoplastic resin layers" refers to, in accordance with the above definition, a laminated configuration in which three types of thermoplastic resin layers "different" in the first and third laminated films of the present invention are laminated in accordance with a certain ordered array. In addition, the "ordered array composed of thermoplastic resin layers of three types differing in refractive index" refers to, in accordance with the above definition, a laminated configuration in which three types of thermoplastic resin layers "different in refractive index" in the second laminated film of the present invention are laminated in accordance with a certain ordered array. In this case, in the "thermoplastic resin layers of three different types" or the "thermoplastic resin layers of three types differing in refractive index", the respective thermoplastic resin layers may be formed of thermoplastic resins having different skeleton structures, or in an alternative possible design, thermoplastic resins having two different skeleton structures are used and the three thermoplastic resin layers are different in mixing ratios or copolymerization amounts of the thermoplastic resins.

In the first laminated film of the present invention, different thermoplastic resin layers are defined as layer A, layer B, and layer C in the alphabetical order in the order in which they appear first when viewed from the outermost surface of the laminated film, and the thermoplastic resins as the main components of the respective thermoplastic resin layers are defined as thermoplastic resin A, thermoplastic resin B, and thermoplastic resin C.

In the second laminated film of the present invention, in accordance with the magnitude relationship on dielectric constant at a loss energy of 2.5 eV obtained by the EELS measurement described above, thermoplastic resin layers of three types differing in refractive index are defined as layer a, layer b, and layer c in descending order of refractive index (dielectric constant), and the thermoplastic resins as the main components of the respective thermoplastic resin layers are defined as thermoplastic resin a, thermoplastic resin b, and thermoplastic resin c.

In the third laminated film of the present invention, the presence of three types of thermoplastic resins is determined in accordance with the definition of "different" thermoplastic resin layers in the first laminated film of the present invention. In addition, in accordance with the magnitude relationship on dielectric constant in the EELS measurement described above, the thermoplastic resin layers are defined as layer $\alpha$, layer $\beta$, and layer $\gamma$ in descending order of dielectric constant (refractive index), and the thermoplastic resins as the main components of the respective thermoplastic resin layers can be defined as thermoplastic resin $\alpha$, thermoplastic resin $\beta$, and thermoplastic resin $\gamma$. The third laminated film of the present invention is different from the first laminated film of the present invention in that the thermoplastic resin layers are not necessarily defined as layer $\alpha$, layer $\beta$, and layer $\gamma$ in order from the outermost layer. That is, in the third laminated film of the present invention, the outermost layer may be any of the layer $\alpha$, the layer $\beta$, and the layer $\gamma$, and additionally, it is just required that three or more ordered arrays composed of the layer $\alpha$, the layer $\beta$, and the layer $\gamma$ are continuously provided in the laminated film.

The main component described herein refers to a component contained in the layer in an amount of more than 50 mass% and 100 mass% or less. Examples of the accessory component that is not the main component include an inorganic component, a low molecular organic component other than the thermoplastic resin, and the like, and specific examples thereof include a light absorber (ultraviolet absorber, dye, pigment, and heat ray absorber), an antioxidant, a light stabilizer, a quencher, a heat resistant stabilizer, a weather resistant stabilizer, an organic lubricant, a filler, an antistatic agent, a nucleating agent, and a flame retardant. These accessory components may be freely added to each layer to such an extent that the physical properties and functions inherent to the film are not impaired.

Among these accessory components, an ultraviolet absorber is preferably included for the purpose of suppressing photodegradation by reaction competition since deterioration may be promoted by absorbing ultraviolet rays having strong energy depending on the type of thermoplastic resin constituting each thermoplastic resin layer. Further, the light absorber itself may be affected by degradation due to heat or oxygen or photodegradation due to reaction with ultraviolet rays or oxygen in the resin extrusion process. Thus, an antioxidant for the former, and a light stabilizer or a quencher for the latter, both as additives, may be added to a layer containing a thermoplastic resin that may be degraded, to such an extent that the physical properties and functions inherent to the film are not impaired.

In the first laminated film of the present invention, where the different thermoplastic resin layers are defined as layer A, layer B, and layer C in the order from the outermost surface of the laminated film, examples of the ordered array of the laminated film of the present invention include (ABC)x, (ABCB)x, (ABAC)x, (ABCAB)x, (ABCAC)x, (ABABC)x, and (ABCBCB)x. This can be similarly interpreted with respect to the layer a, the layer b, and the layer c in the second laminated film of the present invention and the layer $\alpha$, the layer $\beta$, and the layer $\gamma$ in the third laminated film of the present invention with replacement from the layer A, the layer B, and the layer C, respectively. In the second and third laminated films of the present invention, an ordered array in which the layer a or the layer $\alpha$ is not necessarily located on the outermost surface may be employed.

In order for the laminated film using thermoplastic resins different in skeleton structure or physical/chemical properties such as viscoelasticity/viscosity characteristics to maintain a laminated structure without interfacial peeling for a long period of time and not to impair a necessary function, it is necessary to consider a combination of thermoplastic resin layers having good relations (compatibility, surface free energy, etc.) with respect to adjacent thermoplastic resin layers forming different thermoplastic resin layer interfaces contained in the laminated film.

Therefore, in order not to complicate the overall resin design of the laminated film, it is preferable that the number of types of combinations of interfaces formed by adjacent thermoplastic resin layers is smaller. Specifically, in, for example, the first laminated film of the present invention, although examples of the interface formed by three types of different thermoplastic resin layers include three types, namely, A-B interface, B-C interface, and C-A interface, among the ordered arrays recited above, (ABCB)x and (ABCBCB)x are preferred in that there are only two types of interfaces, namely, A-B interface and B-C interface. In such an aspect, it is just required to make resin design such that interlayer peeling hardly occurs between the layer A and the layer B and between the layer B and the layer C, and a combination of the layer A and the layer C does not need to be considered much. This point also applies to the second and third laminated films of the present invention.

That is, in such an aspect, when a resin design is made such that interlayer peeling between the layer A and the layer B and between the layer B and the layer C hardly occur, the layer B serves as a buffer layer between the layer A and the layer C. As a result, interlayer peeling is less likely to occur in the entire laminated film, and even when the laminated film is used for a long period of time, the optical characteristics and physical properties inherent to the laminated film can be maintained. In addition, the laminated film of the present invention allows a hard coat layer, an easily adhesive layer, a gas barrier layer, a tacky layer, and the like to be separately provided as a functional layer on the outermost surface, and accordingly, an interface is formed between the functional layer and the outermost thermoplastic resin layer constituting the laminated film. However, the interface referred to in the present invention indicates only an interface constituting an ordered array of the laminated film.

Furthermore, in order to enhance the reflection characteristics of the laminated film of the present invention, the number of the ordered arrays contained in the laminated film is important, and as the number of the ordered arrays increases, optical characteristics such as high reflectance and wide band can be enhanced. Therefore, among the ordered arrays recited above, a laminated film having an ordered array of (ABCB)x, that is, having an array in which the layer A, the layer B, the layer C, and the layer B are located in this order is most preferable because target optical characteristics can be obtained while reducing the thickness of the laminated film with a small number of lamination (an ordered array in which the same layer is located every other layer, such as (abcb)x in the case of the second laminated film of the present invention and $(\alpha\beta\gamma\beta)$x in the case of the third laminated film of the present invention, corresponds to this). Such an array can be achieved by designing a resin distribution channel of a laminating device used when a laminated film is produced.

When the laminate film has such an ordered array, interference reflection can be controlled by the optical geometric arrangement formed by the refractive index and the layer thickness of the thermoplastic resin layer, so that the reflectance of the laminated film can be improved or the reflection wavelength band can be extended. In addition, for example, when amorphous thermoplastic resins are used as thermoplastic resins different in viscosity or viscoelastic characteristics for some thermoplastic resin layers, the thermoplastic resins are easily co-stretched following the stretchability of the crystalline thermoplastic resin repeatedly present in the laminated film, and the lamination uniformity in the plane of the produced film can be enhanced. As a result, the layer interface state is also improved in the film plane, and peeling at the interface hardly occurs, so that it becomes easy to obtain a laminated film suitable for long-term use, which is the aim of the present invention.

In order for the laminated film of the present invention to realize the interference reflection, the number of the ordered arrays continuously included is required to be 3 or more, and is preferably 20 or more, more preferably 50 or more, and still more preferably 100 or more. The larger the number of such ordered arrays is, the more preferable it is from the viewpoint of uniform stretching and optical performance of the laminated film, but it is realistic that the number of the ordered arrays is 500 or less in consideration of an increase in manufacturing cost due to an increase in size of a manufacturing device, lamination disorder due to an increase in complexity of the lamination step, deterioration in handleability due to an increase in film thickness, and the like. Regarding the ordered array, a prescribed number of ordered arrays may be constructed at once in the laminating device, or after a laminate of a prescribed number of ordered arrays is constructed in the laminating device, the number of ordered arrays can be increased by doubling the number of laminated layers using a known square mixer.

In the second laminated film of the present invention, where layers are defined as layer a, layer b, and layer c in descending order of refractive index, layers b are preferably located every other layer in the thickness direction of the laminated film. By arranging the layer b in such a manner, which is the layer having the second highest refractive index among the three types of thermoplastic resin layers, the layer b plays a role of optically buffering the layer a and the layer c. Usually, the refractive index of a thermoplastic resin layer greatly depends on the properties of the polymer, such as the molecular structure, the orientation state of the main chain skeleton, the polarizability, and the flexibility of the main chain of the thermoplastic resin constituting the thermoplastic resin layer. That is, the property of the thermoplastic resin constituting the layer b having the second highest refractive index is intermediate between that of the thermoplastic resin constituting the layer a and that of the thermoplastic resin constituting the layer c. Such a layer configuration can be realized by adjusting the configuration of a laminating device such as a feed block.

In order for the laminated film of the present invention to exhibit preferable optical characteristics for a long period of time, it is important that the three types of thermoplastic resin layers exhibit a good adhesion relationship at each interface as described above. For this purpose, it is preferable that the layer b exhibiting a role as an intermediate buffer layer is always present adjacent to the thermoplastic resin layer a or c different from the layer b regardless of the arrangement of ordered arrays. For this reason, it is preferable that the layers b are located every other layer in the thickness direction of the laminated film, and examples of a preferable ordered array capable of indicating such a state include (abcb)x and (abcbcb)x, and also (cbab)x and (cbabab)x, in which the layer a and the layer c are interchanged in the preceding examples. Such an ordered array can be achieved by using a multimanifold-type or slit-type feed block to be used when a laminated film is formed, and performing design of a polymer flow path in which three types of thermoplastic resins are to be arranged into the ordered array.

The laminated film of the present invention preferably has an aspect in which the same thermoplastic resin layer is disposed as the outermost layer on both surface layers while having the ordered array. Taking a preferable ordered array in the first laminated film of the present invention as an example, it is an aspect represented by a laminated pattern such as (AB)xA, (ABCB)xA, and (ABCBCB)xA. Since both surface layers are formed of a thermoplastic resin layer containing the same thermoplastic resin as a main component, in the production method described later, it is not necessary to finely adjust the roll temperature, the material, or the like in accordance with the thermal characteristics of the thermoplastic resin layer in contact with the roll to prevent sticking between the roll and the film during roll stretching, and it is possible to set various conditions in accordance with the thermal characteristics of the thermoplastic resin constituting the thermoplastic resin layers disposed as both the outermost layers. That is, an aspect in which the same thermoplastic resin layer is disposed as both the surface layers as the outermost layers is preferable because a laminated film can be obtained under the same film formation conditions as in the case of forming a single layer film containing the thermoplastic resin of the outermost layers as a main component.

In the first laminated film of the present invention, the dielectric constant at a loss energy of 2.5 eV determined by EELS measurement is preferably larger in the order of the layer A, the layer B, and the layer C. By adopting such an aspect, for example, when a laminated pattern such as (ABCB)xA or (ABCBCB)xA is formed, the layer B plays a role of improving the interlayer adhesion of the laminated film. In addition, when the dielectric constant is large in the order of the layer A, the layer B, and the layer C, and has, for example, the ordered array as described above, the layer B located between the layer A and the layer C is present in a thinner state under the layer thickness ratio condition (described later) that is preferable for realizing a high reflectance of the first laminated film of the present invention. Therefore, the layer B, which is usually believed to affect the reflection characteristics due to a difference in refractive index at the interface with the layer A or the layer C, has an optically negligible thickness, and the influence of reflection at the interface between the layer A and the layer B or between the layer B and the layer C is extremely small. As a result, only the optical reflection characteristics due to the layer A and the layer C, which afford the largest difference in refractive index, appear as the optical characteristics of the laminated film, and it becomes possible to exhibit high reflectance characteristics that cannot be normally achieved as the laminated film. In addition, also in the third laminated film of the present invention, from the same viewpoint, where the three types of thermoplastic resin layers are defined as layer $\alpha$, layer $\beta$, and layer $\gamma$, the dielectric constants at a loss energy of 2.5 eV determined by EELS measurement are preferably larger in the order of the layer $\alpha$, the layer $\beta$, and the layer $\gamma$.

The above-described contents regarding the first laminated film of the present invention are established even when the magnitude relationship on dielectric constant between the layer A and the layer C is reversed, but in the first laminated film of the present invention in which the outermost layer is the layer A, it is appropriate that the refractive index is higher in the order of the layer A, the layer B, and the layer C in consideration of the stability of the production method. This is because a crystalline thermoplastic resin layer usually has a high dielectric constant, and thus film formation is facilitated due to the fact that the layer A is a layer highest in dielectric constant.

In the laminated film of the present invention, the dielectric constant ratio between the thermoplastic resin layer having the highest refractive index and the thermoplastic resin layer having the lowest refractive index at a loss energy of 2.5 eV determined by EELS measurement is preferably 1.10 or more and 1.60 or less. In order to increase the reflectance of the laminated film of the present invention, it is important to increase the difference in refractive index between the layer having the maximum refractive index and the layer having the minimum refractive index among the thermoplastic resin layers constituting the ordered array. However, the refractive index of a thermoplastic resin layer is influenced to some extent by the composition, the basic skeleton, or the like of the thermoplastic resin constituting the layer. That is, in order to increase the difference in refractive index between the layer having the maximum refractive index and the layer having the minimum refractive index among the thermoplastic resin layers, it is necessary to make the compositions of the thermoplastic resins constituting these layers largely different or make the basic skeletons different. More specifically, for example, in order to increase the refractive index of a thermoplastic resin layer, a thermoplastic resin having a constituent unit including an aromatic ring and exhibiting crystallinity can be applied as the thermoplastic resin constituting the layer. On the other hand, in order to achieve reduction in the refractive index of a thermoplastic resin layer, for example, a resin composition containing an amorphous and aliphatic-derived constituent unit as a main constituent unit, or containing a constituent unit containing an aromatic ring as a main constituent unit and containing an aliphatic-derived constituent unit at a copolymerization amount of 20mol% or more and less than 50mol% can be employed. Here, the main constituent unit refers to a constituent unit contained in the largest amount among the constituent units of a thermoplastic resin. On the other hand, if there is a large difference in the composition, basic skeleton, or the like of the thermoplastic resins constituting the thermoplastic resin layers as described above, the interlayer adhesion will be poor. Therefore, in a conventional laminated film mainly having an alternately laminated structure of two types of thermoplastic resins, it is difficult to simultaneously achieve improvement in interlayer adhesion and high reflectance. On the other hand, in the laminated film of the present invention, by use of three types of different thermoplastic resins including a resin thermoplastic resin layer having intermediate characteristics, the thermoplastic resin layers can be easily laminated even in a combination in which the dielectric constant ratio between the thermoplastic resin layer having the highest refractive index and the thermoplastic resin layer having the lowest refractive index is 1.10 or more, which is usually difficult to laminate, so that both of these characteristics can be achieved. The upper limit of the dielectric constant ratio is preferably 1.60. Even if a buffer layer having an intermediate property is provided, if the dielectric constant ratio between the thermoplastic resin layer having the highest dielectric constant and the thermoplastic resin layer having the lowest dielectric constant exceeds a certain level, the dielectric constant ratio between these layers and the buffer layer having an intermediate property also increases proportionally, so that interlayer adhesion may be impaired. However, by suppressing the dielectric constant to 1.60 or less, sufficient interlayer adhesion can be secured.

The dielectric constant ratio is preferably 1.10 or more and 1.60 or less, more preferably 1.20 or more and 1.50 or less, and still more preferably 1.30 or more and 1.50 or less from the viewpoint of achieving both improvement in interlayer adhesion and high reflectance. Examples of a means by which the thermoplastic resin layer having the highest refractive index and the thermoplastic resin layer having the lowest refractive index satisfy such a preferable dielectric constant ratio include a method involving making an aspect in which at least one preferable thermoplastic resin to be described later is included and a thermoplastic resin being a main component of the thermoplastic resin layer having the highest dielectric constant is different from a thermoplastic resin being a main component of the thermoplastic resin layer having the lowest dielectric constant.

In the laminated film of the present invention, at least one of the thermoplastic resin layers of three different types is preferably a thermoplastic resin layer exhibiting crystallinity (in the second laminated film of the present invention, "thermoplastic resin layers of three different types" refers to "thermoplastic resin layers of three types differing in refractive index"). When all the thermoplastic resins forming the thermoplastic resin layers constituting the laminated film are amorphous resins, stress is not generated and stretching unevenness of the laminated film occurs when stretching is performed in the production method described later, so that the uniformity of physical properties of the laminated film may be greatly impaired. Therefore, at least one thermoplastic resin layer is preferably a crystalline thermoplastic resin layer capable of physically gripping and co-stretching other thermoplastic resin layers laminated simultaneously. Crystallinity can be determined by cutting and extracting the thermoplastic resin layer, and checking the presence or absence of a melting point (an endothermic peak) using a differential scanning calorimetry (DSC) device. In particular, in the laminated film of the present invention, a thermoplastic resin layer having an enthalpy of fusion of 10 J/g or more, the enthalpy of fusion being integral with the baseline at the endothermic peak of the melting point, is defined as a crystalline thermoplastic resin layer.

The thermoplastic resin layer exhibiting crystallinity is preferably used for the thermoplastic resin layer located as the outermost layer (layer A in the case of the first laminated film of the present invention). When the thermoplastic resin layer located as the outermost layer is made of an amorphous thermoplastic resin, the laminated film tends to adhere to a roll, a clip, or the like, and stretching failure or deterioration of the surface state may occur due to adhesion to the production equipment.

Furthermore, the thermoplastic resin layers of three different types forming the laminated film of the present invention are preferably a combination of thermoplastic resin layers exhibiting crystallinity/semi-crystallinity/amorphousness or crystallinity/amorphousness/amorphousness (in the second laminated film of the present invention, "thermoplastic resin layers of three different types" refers to "thermoplastic resin layers of three types differing in refractive index"). The crystallinity, the semi-crystallinity, and the amorphousness described herein can be determined using a differential scanning calorimetry (DSC) device. The thermoplastic resins constituting the crystalline and semi-crystalline thermoplastic resin layers are characterized by exhibiting three points of glass transition temperature, enthalpy of crystallization, which is an endothermic peak, and enthalpy of fusion, which is an exothermic peak. Depending on the type of the crystalline thermoplastic resin, the glass transition temperature may not fall within the measurement range described later, and thus the degree of crystallinity is determined from the magnitude of the enthalpy of fusion. As described above, in the laminated film of the present invention, crystalline is defined as a case where the enthalpy of fusion is 10 J/g or more, and semi-crystalline is defined as a case where the enthalpy of fusion is 0.1 J/g or more and less than 10 J/g. In addition, amorphous is defined as a case corresponding to neither of the above.

By adopting the combination of crystallinity/semi-crystallinity/amorphousness or crystallinity/amorphousness/amorphousness described herein, for example, even when thermoplastic resin layers having a large difference in refractive index and having completely different skeleton structures are laminated in order to enhance reflection characteristics, the semi-crystalline or amorphous thermoplastic resin layer disposed therebetween can guide entanglement of molecular chains or a reaction between functional groups at an interface, and a laminated film in which interlayer peeling hardly occurs can be afforded. The semi-crystalline or amorphous thermoplastic resin layer disposed therebetween can be formed, for example, by melt-extruding a thermoplastic resin exhibiting target semi-crystalline or amorphous properties from an extruder and laminating the thermoplastic resin. As another method, it is also possible to use a method of extruding a thermoplastic resin having higher crystallinity and melting a crystal phase by heat treatment in a lateral stretching step to form a thermoplastic resin layer exhibiting desired semi-crystalline or amorphous properties.

Especially in the latter case, as the crystalline thermoplastic resin layer, it is necessary to use a thermoplastic resin layer exhibiting a melting point higher than that of the thermoplastic resin layer exhibiting semi-crystallinity or amorphousness. The thermoplastic resin to be used for such a crystalline thermoplastic resin layer is particularly preferably selected from polyethylene terephthalate having few methylene chains as a polyol component and a copolymer thereof, and polyethylene naphthalate and a copolymer thereof among the preferable polyester resins described above from the viewpoints of, in addition to extrudability, stretchability, and versatility, the magnitude of the refractive index of the thermoplastic resin layer when crystallized, which is important for enhanced reflectance of the laminated film, and the melt viscosity behavior regarding lamination accuracy. From the above viewpoints, as a method of combining crystallinity/semi-crystallinity/amorphousness or crystallinity/amorphousness/amorphousness, even if any of the above methods is adopted, an aspect in which the thermoplastic resin as the main component of the thermoplastic resin layer exhibiting crystallinity is polyethylene terephthalate or polyethylene naphthalate is particularly preferable.

In the laminated film of the present invention, it is preferable that the thermoplastic resin layer exhibiting amorphousness preferably contains either acrylic or polyester having an alicyclic structure as a main component. The amorphous thermoplastic resin that can be preferably used in the laminated film of the present invention is preferably a thermoplastic resin that has a large difference in refractive index from the polyester resin in order to increase reflectance, and exhibits melt viscosity characteristics the same as or similar to those of the polyester resin in order to afford a laminated film exhibiting good lamination properties, and among the thermoplastic resins described above, it is preferable to select one from an acrylic resin and a polyester resin exhibiting an alicyclic structure. The acrylic resin itself is an amorphous resin and exhibits a refractive index of 1.49, and the polyester resin having an alicyclic structure is an amorphous resin exhibiting a refractive index of 1.52 to 1.55 when it is of a copolymerized type. By laminating a thermoplastic resin layer containing an amorphous thermoplastic resin having such a refractive index as a main component, the refractive index difference can be widened to about 0.25 to 0.30 at the maximum in the ordered array, and a laminated film exhibiting a high reflectance that could not be realized because of difficulty in lamination due to interfacial peeling in the conventional alternate lamination technique can be realized.

Examples of the polyester resin exhibiting an amorphous alicyclic structure that can be preferably used as a main component of the thermoplastic resin layer exhibiting amorphousness of the laminated film of the present invention include polyester resins copolymerized with structures such as cyclohexanedicarboxylic acid, 1,2-cyclohexanedimethanol, 1,3-cyclohexanedimethanol, 1,4-cyclohexanedimethanol, isosorbate, and spiroglycol as an alicyclic structure.

Although not recited as a preferable resin in consideration of stretchability and film formability because of its high glass transition temperature, an amorphous polyamide resin can also be used as a main component of the thermoplastic resin layer exhibiting amorphousness. Examples of the amorphous polyamide resin that can be used include polyamide PA12/MACMI (PA12/3,3-dimethyl-4,4-diaminocyclohexylmethane, isophthalic acid), PA12/MACMT (PA12/3,3-dimethyl-4,4-diaminocyclohexylmethane, terephthalic acid), PA MACM 12 (3,3-dimethyl-4,4-diaminocyclohexylmethane, decanedicarboxylic acid or laurolactam), PA MC 12 (PA12, 1,3-bis(aminomethyl)cyclohexane), PA6I/6T, and PA6I/6T/-MACMI.

In the first laminated film of the present invention, it is important that, where thermoplastic resin layers of three different types are defined as layer A, layer B, and layer C, the thickness ratio A/B of the layer A to the layer B in the ordered array is 0.60 or more and 5.00 or less, and the thickness ratio C/B of the layer C to the layer B in the ordered array is 0.70 or more and 5.00 or less. Here, the layer A, the layer B, and the layer C are defined in the order of being disposed from the outermost surface of the laminated film as described above. In order to increase the reflectance of the laminated film, determination is roughly made on the basis of the difference in refractive index between the thermoplastic resin layer having the highest refractive index and the thermoplastic resin layer having the lowest refractive index among the thermoplastic resins included in the ordered array. As having been described above as the preferable conditions, it is hereinafter described that the layer A, the layer B, and the layer C are larger in dielectric constant in this order, and the layer A and the layer C correspond to the thermoplastic resin layer highest in refractive index and the thermoplastic resin layer lowest in refractive index, respectively. However, the place where light is actually reflected is the interface between the thermoplastic resin layers, and ideally, a configuration in which the thermoplastic resin layers having a high difference in refractive index are adjacent to each other, that is, the layer A and the layer C are adjacent to each other is preferable. However, in a case of achieving both light reflection and interface adhesion, such a laminate design is very difficult. Therefore, the presence of a thermoplastic resin layer (layer B) having a role of a buffer layer, which can exhibit high reflection characteristics for a long period of time while enhancing interface adhesion as in the present invention is important. Although the reflectance of the laminated film is generally determined by the largest difference in refractive index among the thermoplastic resin layers in the ordered array, the difference in refractive index between the adjacent thermoplastic resin layers is reduced by interposing the thermoplastic resin layer corresponding to a buffer layer, so that the reflectance of the laminated film is also a somewhat small value.

Therefore, in the first laminated film of the present invention, by designing the layer thickness of the thermoplastic resin layer (layer B) disposed in the middle corresponding to the buffer layer among the thermoplastic resin layers of three different types so as to be thinner than the phase (wavelength value) of the light to be reflected, the influence of the refractive index difference at the interface with the thermoplastic resin layer corresponding to a buffer layer on the reflection characteristics can be reduced. By adopting such an aspect, since the influence of the reflection characteristics given by the layer B is suppressed, the reflectance can be increased as in a case where there is an interface between thermoplastic resin layers having the largest difference in refractive index (the interface between the layer A and the layer C). In order to realize this, it is important to design the thickness ratio A/B of layer A/layer B and the thickness ratio C/B of layer C/layer B based on the thermoplastic resin layer (layer B) corresponding to a buffer layer.

When the thickness ratio A/B is less than 0.60 or the thickness ratio C/B is less than 0.70, the thermoplastic resin layer (layer B) corresponding to an intermediate buffer layer is sufficiently thick with respect to a target reflection wavelength, so that the layer A/layer B interface and the layer B/layer C interface having a small refractive index difference function as interfaces that reflect light, and the laminated film cannot exhibit sufficient reflectance that can be expected from the refractive indexes of the laminated thermoplastic resin layers. In particular, the reflectance may decrease by about 10% as compared with a case where each thickness ratio indicates 1.0.

On the other hand, when the thickness ratio A/B or the thickness ratio C/B exceeds 5.00, the layer thickness of the layer B serving as an intermediate buffer layer is reduced, so that an increase in reflectance is expected, but the layer is readily affected by disturbance of resin flow, and it becomes very difficult to maintain the laminated structure. In particular, when a non-Newtonian resin exhibiting shear dependency of the melt viscosity is used as the thermoplastic resin for forming the intermediate buffer layer, the disturbance becomes more remarkable. The thickness ratio A/B is preferably 0.90 or more, more preferably 1.30 or more, particularly preferably more than 1.3, and most preferably 1.50 or more since the thickness of the intermediate buffer layer, namely, the layer B is thinner as the thickness ratio is a higher value, and high reflectance can be realized. The thickness ratio C/B is preferably 1.00 or more, more preferably more than 1.30, and particularly preferably 1.50 or more.

Furthermore, in the first laminated film of the present invention, in addition to the thickness ratio relationship described above, the thickness ratio A/C of the layer A to the layer C in the ordered array is preferably 0.70 or more and 1.40 or less. Controlling the layer A, which is the crystalline thermoplastic resin layer having the highest refractive index, and the layer C, which is the amorphous thermoplastic resin layer having the lowest refractive index, within that range of the thickness ratio means that the thicknesses of both the thermoplastic resin layers are substantially uniform, but this makes it possible to design a laminated configuration such that phases of light reflected at an interface between the thermoplastic resin layers are aligned and light reflected at different interfaces strongly interfere with each other, so that a laminated film exhibiting a high reflectance can be obtained. From the above viewpoint, the thickness ratio A/C of the layer A to the layer C is more preferably 0.80 or more and 1.25 or less, still more preferably 0.80 or more and 1.20 or less, and particularly preferably 0.80 or more and 1.00 or less.

The thickness ratios A/B, C/B, and A/C can be achieved by adjusting the discharge amount ratio from each extruder in consideration of the specific gravity of each thermoplastic different resin in addition to the slit design (slit thickness, gap) in the laminating device. In addition, these thickness ratios can be determined by analyzing an observation image by a transmission electron microscope, and details thereof will be described later (the same applies to items regarding other layer configurations (the number of laminated layers, ordered arrays, the layer thickness of each layer, the distribution of layer thickness)).

In order for the first laminated film of the present invention to exhibit a metallic-tone film appearance, in addition to setting the thickness ratios A/B and C/B within the above ranges, the maximum reflectance at a wavelength of 400 nm to 800 nm is required to be 35% or more and 100% or less. The maximum reflectance described herein is calculated, as described later in Examples, by reading it from a reflection optical spectrum obtained by measuring at a pitch of 1 nm in an absolute reflection measurement mode using specular reflection with a spectrophotometer. The fact that the maximum reflectance at a wavelength of 400 nm to 800 nm corresponding to the visible light region is less than 35% means that the laminated film has a light transmittance as high as the background is visually recognized when the laminated film is viewed. Alternatively, when the transmittance in the visible light region is low and the maximum reflectance is also low, the visible light is absorbed and a black appearance is exhibited. The maximum reflectance can be measured with a known spectrophotometer, and details of the measurement will be described later (hereinafter, the same applies to other parameters representing reflection characteristics including those of the second and third laminated films of the present invention).

In order for the laminated film to exhibit a metallic-tone appearance to such an extent that it is difficult to visually recognize the background, the maximum reflectance at a wavelength of 400 nm to 800 nm is required to be 35% or more. From the above viewpoint, the maximum reflectance is preferably 50% or more, more preferably 80% or more, still more preferably 85% or more, and most preferably 90% or more. In the case of absolute reflection measurement, since measurement is performed with a state in which light emitted from a light source is guided to a detector without being diffused by specular reflection as 100%, it is impossible in principle that the reflectance of the measurement sample exceeds 100%, and the upper limit of the reflectance of the laminated film of the present invention is 100%. In order to set the maximum reflectance of the laminated film at a wavelength of 400 to 800 nm to 35% or more or within the above preferable range, the number of layers that reflect a target wavelength band may be increased by increasing the number of ordered arrays, the inclination of the layer thickness distribution may be made gentle, and a combination of thermoplastic resins as the main components of the layer A and the layer C may be selected so as to achieve an increased difference in refractive index (these measures may be used appropriately in combination). In addition, it is also effective to set the thickness ratios A/B, C/B, and A/C within suitable ranges in combination with any of the methods described above.

From the viewpoint of setting the maximum reflectance at a wavelength of 400 nm to 800 nm to 35% or more or within the above preferable range, the thermoplastic resin of each layer is preferably selected such that the difference in refractive index between the layer A and the layer C is 0.09 or more, more preferably 0.16 or more, still more preferably 0.18 or more, and particularly preferably 0.20 or more. The refractive index difference is preferably as large as possible and the upper limit thereof is not particularly limited, but the upper limit of the refractive index difference is 0.30 from the viewpoint of feasibility. The preferred difference in refractive index is the same in the second laminated film of the present invention when the layer A and the layer C are replaced with the layer a and the layer c, and the same in the third laminated film of the present invention when the layer A and the layer C are replaced with the layer having the highest refractive index and the layer having the lowest refractive index among the layer $\alpha$, the layer $\beta$, and the layer $\gamma$.

When the maximum reflectance at a wavelength of 400 to 800 nm indicates the above range, the reflection band in the reflection optical spectrum may be the main reflection band of the laminated film (corresponding to the broadest reflection band seen on the longest wavelength side, namely, the reflection band $\Pi$ described later), or may be the higher order reflection band seen in the 1/n wavelength band (hereinafter, n is referred to as an order, and n is a natural number) when the main reflection band is at a longer wavelength position. In the latter case, the occurrence of higher order reflection can be freely controlled by changing the thickness ratio of the laminated film of the present invention (the discharge amount ratio of the extruder). However, since the bandwidth of the higher order reflection is narrowed to 1/n with respect to the order with respect to the main reflection band, in the latter case, it is necessary to take measures such as increasing the number of layers and widening the main reflection band in order to realize reflection over the entire visible light region in order to show the target metallic tone. Therefore, in the latter case, there are disadvantages such as an increase in size of the laminating device and an increase in thickness of the laminated film due to an increase in the number of layers, and thus the former design is preferable.

In the second laminated film of the present invention, where the thermoplastic resin layers of three types are defined as layer a, layer b, and layer c in descending order of refractive index, it is necessary that ordered arrays in which both the thickness ratio a/b of the layer a to the layer b and the thickness ratio c/b of the layer c to the layer b in the ordered arrays are 1.40 or more are present 90% or more. When such an aspect is adopted, the layer b, which is a thermoplastic resin layer having a refractive index of an intermediate value between the layer a and the layer c and exhibiting intermediate properties between the layer a and the layer c, is relatively thin. By setting such thickness ratio conditions, first, similarly to the layer B in the first laminated film of the present invention, the layer b can serve as a buffer layer or an adhesive layer between the layer a and the layer c. Therefore, in the conventional technique of alternately laminating thermoplastic resin layers of two types, it is difficult to alternately laminate the layer a and the layer c without impairing interlayer adhesion, but by adopting such an aspect, it is possible to obtain a laminated film exhibiting a high reflectance due to a laminated configuration including the layer a and the layer c without impairing interlayer adhesiveness, and such a laminated film can be suitably used, for example, in applications for improving brightness of an image display device.

Furthermore, when both the thickness ratio a/b and the thickness ratio c/b in the ordered array are designed to be 1.40 or more, the layer b is relatively thinner than the layer a and the layer c, and the layer b can be sufficiently thinner with respect to the reflection wavelength of the laminated film. Therefore, the reflection at the interface between the layer b and the adjacent layer a or layer c is reduced to a negligible extent, and the effect due to the difference in refractive index between the layer a and the layer c is further enhanced, so that the reflectance with respect to the reflection wavelength is further improved. Owing to these points, thinning the layer b exhibiting an intermediate refractive index so as to satisfy the thickness ratio conditions is an important factor from the viewpoint of achieving both improvement in interlayer adhesion and high reflectance. The upper limit is not particularly provided, but when the layer b is made as thin as possible, the flow of the layer c is easily crushed by the polymer layer flows of the adjacent layer a and layer c, so that a desired laminated film including thin layer b cannot be stably obtained. For this reason, practically, both the thickness ratio a/b and the thickness ratio c/b are preferably 10 or less.

In addition, it is necessary for the second laminated film of the present invention that ordered arrays exhibiting those thickness ratios are present 90% or more. Here, "ordered arrays exhibiting those thickness ratios are present 90% or more" means that when the number of all ordered arrays constituting the laminated film is n, 0.9n or more ordered arrays exhibit those thickness ratios. When laminated films composed of the same thermoplastic resin layers are compared with each other, the fact that ordered arrays in which the thickness ratios are less than 1.4 are present means that there is unevenness in the thickness ratios among the respective ordered arrays, and there are variations in the wavelength exhibiting high reflectance and the wavelength not exhibiting a high reflectance in the reflection wavelength band. In particular, since the fact that the thickness ratios are less than 1.4 is a thickness ratio condition under which the interface between the layer b and the adjacent layer a or layer c is recognized, the reflection characteristics attained are invited to deteriorate by repeating that ordered array. As a result, for example, when the reflection band is the entire visible light band, a state where a specific color tone is not sufficiently reflected (a so-called color loss state) occurs, and thus the laminated film comes to have an appearance like a colored color foil rather than a metallic tone. Even when the main reflection band is in the heat ray region exceeding a wavelength of 800 nm, the 1/2 wavelength band or the 1/3 wavelength band corresponding to a higher order reflection band thereof may overlap the visible light band. Even in such a case, if the ordered arrays exhibiting those thickness ratios are present less than 90%, reflectance unevenness in a higher order reflection band occurs remarkably, and thus there is a problem that a color tone failure of color loss occur similarly. Therefore, in order to reduce the unevenness of reflectance due to wavelength in a specific wavelength band, it is essential that ordered arrays exhibiting those thickness ratios are present 90% or more. From the above viewpoint, it is more preferable that the ordered arrays exhibiting those thickness ratios are present 95% or more. The upper limit of the content of the ordered arrays exhibiting those thickness ratios is theoretically 100%.

This condition greatly depends on the layer thickness distribution design of the laminating device, but when the unevenness of the layer thickness distribution is large in the laminating device main body, the content of the ordered arrays satisfying the layer thickness ratios can be set to 90% or more by adjusting the discharge amount ratio of three extruders.

Further, it is important that the second laminated film of the present invention has a reflection band where a reflectance of 20% or more is exhibited continuously over a wavelength of 100 nm or more in a wavelength range of 300 to 2600 nm. The second laminated film of the present invention realizes a high reflectance by reducing the thickness of the layer b having the second highest refractive index value among the thermoplastic resins of three types to such an extent that the reflection characteristics are not affected. As a premise thereof, it is necessary to design, according to the interference reflection theoretical formula (1), the thickness of the ordered array and the thickness (thickness ratio) of the layer b with respect to the thickness of the ordered array in consideration of the wavelength to be reflected. The reflection band present in the visible light region may be the main reflection band of the laminated film (corresponding to the broadest reflection band seen on the longest wavelength side, namely, the reflection band Π described later), or may be the higher order reflection band seen in the 1/n wavelength band (hereinafter, n is referred to as an order and is a natural number) when the main reflection band is at a longer wavelength position. On the other hand, when the layer b is a film thin to the extent that the requirement of the thickness ratios is satisfied, in the wavelength band of light to be reflected, the laminated film exhibits the same degree of reflectance as the alternately laminated film of the layer a and the layer c in which the layer b is not present. In the case of an alternately laminated film, an aspect in which reflection is performed according to the thickness ratio design in the 1/2 wavelength band of the main reflection band or an aspect in which the reflection is suppressed can be adopted, but it is known that interference reflection cannot be theoretically suppressed in the 1/3 wavelength band of the main reflection band. For this reason, for example, in order to achieve an aspect in which light in the visible light region is highly reflected, it is necessary to have a reflection band in which a reflectance of 20% or more is exhibited continuously over a wavelength of 100 nm or more within a wavelength range of 300 nm or more and up to 2400 nm, which is a triple wavelength of 800 nm corresponding to a long-wavelength end of the visible light reflection region.

In the formula (1), k represents a natural number, λ represents a wavelength, Nx, Ny, and Nz represent refractive indexes in the x layer, the y layer, and the z layer, respectively, and dx, dy, and dz represent layer thicknesses in the x layer, the y layer, and the z layer, respectively.

[Mathematical formula 1]

$$k\lambda = 2(n_X d_X + n_Y d_Y + n_Z d_Z) \qquad (1)$$

(where, k is a natural number)

The above thickness ratios and reflection band design can be designed by the layer thickness distribution design of the laminating device and the thickness of the laminated film. The thickness of the laminated film can be appropriately adjusted according to the intended purpose by adjusting the take-up speed of the cast, the discharge amounts of the extruders, the stretch ratio, and the like according to the method for producing a laminated film described later.

It is necessary that the third laminated film of the present invention has a reflection band where a reflectance of 75% or more is exhibited continuously over 100 nm or more in a wavelength range of 400 to 800 nm. It is important that the third laminated film of the present invention exhibits high reflectance in the visible light region in order to exhibit an appearance strong in a specific color tone. For this purpose, in the wavelength range of 400 to 800 nm, a high reflectance as high as a reflectance of 75% or more, preferably 80% or more, is exhibited continuously over 100 nm or more is required. It is more preferable that a reflectance of 80% or more is exhibited continuously over the entire wavelength range of 400 to 800 nm. For example, when the reflectance unevenness is small and a high reflectance is exhibited in the wavelength range of 400 to 800 nm, the resulting laminated film exhibits a metallic-tone appearance. Examples of the index of the reflectance unevenness include a standard deviation $\sigma/R$ of the reflectances at respective wavelengths in that reflection band (the wavelength range of 400 to 800 nm) with respect to the average reflectance in that reflection wavelength band, and the smaller this value, the smaller the reflectance unevenness. In order to realize the reflection characteristics, it is effective to increase the number of layers that reflect a target wavelength band by increasing the number of ordered arrays, to moderate the inclination of the layer thickness distribution, and to select a combination of thermoplastic resins constituting the ordered arrays such that the difference in refractive index between the thermoplastic resin layer exhibiting the highest refractive index and the thermoplastic resin layer exhibiting the lowest refractive index is high, and these methods may be appropriately combined.

Furthermore, in the third laminated film of the present invention, it is necessary that 30% or more and 80% or less of the total number of thermoplastic resin layers constituting the ordered arrays are accounted for by thermoplastic resin layers having a layer thickness of 1 nm or more and 25 nm or less. Here, "30% or more and 80% or less of the total number of thermoplastic resin layers constituting the ordered arrays are accounted for by thermoplastic resin layers having a layer thickness of 1 nm or more and 25 nm or less" means that where the number of all layers constituting the ordered arrays of the laminated film is n, $0.3 \times n$ or more and $0.8 \times n$ or less layers are layers having a layer thickness of 1 nm or more and 25 nm or less. In the third laminated film of the present invention, in order to achieve both adhesion suitable for long-term use and high reflectance characteristics as compared with a laminated film based on a conventional alternately laminated structure, it is important to use of thermoplastic resin layers of three different types, and further reduce as much as possible the thickness of a thermoplastic resin layer having intermediate properties that can inhibit high reflectance of a laminated film (for example, a layer having the second highest refractive index value or the like corresponds thereto). Examples of such an aspect specifically include an aspect in which where three types of thermoplastic resin layers are denoted by layer $\alpha$, layer $\beta$, and layer $\gamma$, and the layer configuration is denoted by $(\alpha\beta\gamma\beta)x$, the thickness of the layer $\beta$ is reduced. Hereinafter, the layer to be thinned may be referred to as a thin film layer.

In particular, when light having a specific wavelength is reflected by the third laminated film of the present invention, it is important to design the thin film layer to have an optical thickness (refractive index $\times$ layer thickness) of 1/10 or less of that wavelength in order that the thin film layer is not recognized as an interface (in other words, the reflection characteristics are not affected). Since the third laminated film of the present invention has a reflection band in a wavelength range of 400 to 800 nm (a so-called visible light region), as long as the third laminated film includes a sufficiently much layer thickness that can satisfy that optical thickness of 1/10 or less at a wavelength of 400 nm, which corresponds to the lowest wavelength that can be the short-wavelength end of the reflection band, the third laminated film can have a laminated film configuration that obtains a target high reflectance even when the long-wavelength end of the reflection wavelength band is at any position of a wavelength of 400 nm or more. In addition, although the refractive index varies depending on the thermoplastic resin to be applied, when the thickness of the thin film layer is designed to be 25 nm or less in consideration of the refractive index of the thermoplastic resin described above, the intended high reflection characteristics of the third laminated film of the present invention can be sufficiently satisfied. The lower limit of the thickness of the thermoplastic resin layers, which account for 30% or more and 80% or less of the number of all the thermoplastic resin layers constituting ordered arrays, (in other words, the thickness of the thin film layer) is 1 nm, and if the lower limit is made smaller than this, the flow of the thin film layer is readily crushed due to the polymer fluidity of layers other than the thin film layer in the lamination step, and a laminated film having a desired configuration cannot be stably obtained. From the viewpoint of desired reflection characteristics and film formation stability, thermoplastic resin layers having a layer thickness of 1 nm or more and 25 nm or less are required to be 30% or more and 80% or less, more preferably 40% or more and 80% or less, and still more preferably 40% or more and 60% or less. Examples of the means for achieving the above range include adjustment of a layer thickness distribution design of a laminating device and adjustment of a discharge amount balance of three extruders, and these may be appropriately used in combination.

In the third laminated film of the present invention, where the layers are defined as layer $\alpha$, layer $\beta$, and layer $\gamma$ in descending order of dielectric constant (refractive index), it is preferable that ordered arrays in which the thickness ratio $\alpha/\beta$ of the layer $\alpha$ to the layer $\beta$ and the thickness ratio $\gamma/\beta$ of the layer $\gamma$ to the layer $\beta$ are 1.40 or more are present 90% or more.

Here, "ordered arrays in which the thickness ratio $\alpha/\beta$ of the layer $\alpha$ to the layer $\beta$ and the thickness ratio $\gamma/\beta$ of the layer $\gamma$ to the layer $\beta$ are 1.40 or more are present 90% or more" means that where the number of the ordered arrays constituting the laminated film is n, 0.9n or more ordered arrays exhibit the above thickness ratio. By satisfying this requirement, as described for the second laminated film of the present invention, the third laminated film of the present invention also suppresses the reflectance unevenness and becomes a laminated film exhibiting a high reflectance over a wide band. From the above viewpoint, the number of the ordered arrays indicating the above thickness ratio is more preferably 95% or more.

In the first laminated film of the present invention, it is preferable that thermoplastic resin layers having a layer thickness of 1 nm or more and 25 nm or less account for 30% or more and 80% or less in number of all the thermoplastic resin layers constituting the ordered arrays. The reason why such an aspect is preferred, the preferred range, and the means for achieving the above are as described in the third laminated film of the present invention.

As the reflection characteristics exhibited by the laminated film of the present invention, the average reflectance at a wavelength of 400 nm to 800 nm is preferably 50% or more and 100% or less. As the average reflectance described herein, a value obtained by averaging reflectances at wavelengths from 400 nm to 800 nm when measured with a sampling pitch of 1 nm in accordance with "Reflection Optical Spectrum Measurement" in the measurement method described later is used. By increasing the reflectance over the entire visible light region, a laminated film exhibiting a further metallic-tone appearance is obtained. From the above viewpoint, the average reflectance is preferably 70% or more, more preferably 75% or more, still more preferably 80% or more, and most preferably 90% or more.

The average reflectance can be increased by setting the number of ordered arrays to 50 or more, and using a thermoplastic resin layer exhibiting crystallinity preferable in these inventions or a thermoplastic resin layer made of an amorphous resin as a combination of thermoplastic resin layers having a high difference in refractive index (in selecting the thermoplastic resins, it is particularly effective to increase the difference in refractive index between the thermoplastic resin having the largest refractive index and the thermoplastic resin layer having the smallest refractive index constituting the ordered array). In addition, the average reflectance can be increased by controlling the thickness ratio of each layer within a range necessary/preferable in each invention. These methods may be used in combination as appropriate.

Even when the maximum reflectance and the average reflectance are increased, in order to exhibit a metallic tone, it is preferable to control the reflectance in the wavelength band to unevenness within a certain range over the entire visible light region. Specifically, where the average value of reflectances at the wavelengths of 400 nm to 800 nm is denoted by R [%] and the deviation of the reflectances is denoted by $\sigma$ [%], when the percentage of $\sigma/R$ is 10.0% or less, it is possible to exhibit a good metallic tone without coloring due to reflected color loss. From the above viewpoint, the percentage of $\sigma/R$ is more preferably 5.0% or less. In order to suppress the reflectance unevenness in the visible light reflection region, it becomes easy to achieve by designing the layer thickness distribution so as to be smoothly inclined, indicating a distribution in which the inclination of the layer thickness distribution monotonously and continuously increases, and selecting a combination of thermoplastic resins as main components of a layer having the highest refractive index (in the first and third laminated films of the present invention, the layer A or the layer $\alpha$ is preferable, and in the second laminated film of the present invention, the layer a is preferable) and a layer having the lowest refractive index (in the first and third laminated films of the present invention, the layer C and the layer $\gamma$ are preferable, and in the second laminated film of the present invention, the layer c is preferable) so as to achieve an increased refractive index difference (in particular, a refractive index difference of more than 0.20 is indicated). In addition, it is also effective to set the lamination ratio of each layer to the above-described range, and to increase the number of layers that reflect light of the same wavelength by increasing the number of ordered arrays (these methods may be used appropriately in combination).

The laminated film of the present invention preferably has a grid peeling rate of 10% or less in an adhesion test based on a cross-cut method defined in JIS K 5600-5-6: 1999. Hereinafter, the "grid peeling rate in adhesion test based on a cross-cut method defined in JIS K 5600-5-6: 1999" may be simply referred to as a peeling rate. Peeling of the laminated film is considered to be caused by both cohesion/material failure in which breakage occurs inside each thermoplastic resin and peeling occurs, and interfacial failure in which peeling occurs at an interface between thermoplastic resin layers, but peeling due to both can be captured in the cross-cut test. Both failures are phenomena that should not occur when the laminated film is used for a long time, and the fact that the peeling rate is 10% or less in the cross-cut test indicates that the laminated film has reliability that can withstand long-term use.

When the laminated film exhibits a peeling rate of 10% or less, the occurrence of breakage from the laminated film interface is reduced in long-term use, and for example, in the processing step, lifting due to peeling at the interface during film conveyance on the roll and cracking of a sectional portion in the cutting step are inhibited. As a result, for example, when a protective film is provided at a position different from the laminated film, it is possible to inhibit the occurrence of peeling at the laminated film interface due to the peeling strength at the time of peeling. In particular, in applications where bending is repeatedly performed, lifting at the interface is less likely to occur, and the physical properties and optical characteristics inherent to the present laminated film are stably maintained, so that the laminated film is suitable for long-term use. From the viewpoint described above, the peeling rate is more preferably 5% or less, and still more preferably 0%. In consideration of only the above viewpoint, the smaller the peeling rate is, the more preferable it is, and the most preferable aspect is an aspect in which the peeling rate is 0%. However, when the peeling rate of 0% is to be achieved, an ordered array is formed of thermoplastic resin layers having a similar chemical structure, so that the reflection characteristics of the resulting laminated film may be poor. In consideration of this point as well, it is also preferable to set the lower limit of the peeling rate to 1%.

Laminated configuration, resin design, and process conditions preferable for achieving such a low peeling rate will be described below.

A preferable laminated configuration for the laminated film of the present invention to obtain a low peeling rate may be, taking the first laminated film of the present invention as an example, inclusion of the ordered arrays of (ABCB)x and (ABCBCB)x having ordered arrays with a small number of types of interfaces as described above. Since there are only two types of interfaces, namely, an A-B interface and a B-C interface, it is sufficient to consider only the resin design of one layer among the layer A, the layer B, and the layer C and the other two adjacent layers, and it is easy to adopt the resin design described later in which interlayer peeling hardly occurs. For example, the second laminated film of the present invention can be similarly interpreted by replacing the layer A, the layer B, and the layer C with the layer a, the layer b, and the layer c, respectively, and the third laminated film of the present invention can be similarly interpreted by replacing the layer A, the layer B, and the layer C with the layer $\alpha$, the layer $\beta$, and the layer $\gamma$, respectively. The following description can also be interpreted in a similar manner with replacement with the requirements in the second and third laminated films of the present invention.

A preferred resin design for obtaining a low peeling rate in the present invention will be described. As the simplest method, it is conceivable to blend and extrude thermoplastic resins for forming thermoplastic resin layers disposed on both sides. However, when thermoplastic resins having different skeleton structures are blended, it is technically very difficult to maintain the transparency of the laminated film by finely dispersing the thermoplastic resins. Therefore, for adjacent thermoplastic resin layers forming an interface, a low peeling rate can be achieved by copolymerizing a thermoplastic resin for forming a thermoplastic resin layer of one side with a component for forming a skeleton structure contained in a thermoplastic resin for forming a thermoplastic resin layer of the adjacent layer, or dispersing that component as a low molecular weight component. The amount of the common component to be copolymerized or kneaded can be achieved by setting the amount of the component having a common chemical structure to 60 mol% or more and 95 mol% or less when the amount of the component constituting the thermoplastic resin is 100 mol% in comparison between the thermoplastic resin layers. The component amount at this time means that, for example, in the case of polyethylene terephthalate, the amount of different components among the thermoplastic resins constituting the adjacent thermoplastic resin layers is 5 mol% or more and 40 mol% or less in total based on the component of the thermoplastic resin constituting the thermoplastic resin layer on one side, considering that the overall dicarboxylic acid component is 50 mol% and the overall diol component is 50 mol% in total, that is, 100 mol% in total.

When the amount of the common component is less than 60 mol%, molecules contained in the respective thermoplastic resin layers hardly form an intermolecular interaction, and are poor in compatibility. This method is the simplest resin design, but since components having different basic skeletons coexist in the main thermoplastic resin constituting the layer, depending on the dispersion mixed condition, components having different basic skeletons exist as islands-in-the-sea structures (domains) in the main thermoplastic resin constituting the layer, and the turbidity (haze) may increase to impair the transparency of the laminated film. The problem of the domain can be solved by increasing the degree of dispersion between the thermoplastic resins, and specifically, the problem can be solved by using a kneading extruder including two or more screws, increasing the ratio of the screw rotation speed to the discharge amount at the time of additive kneading, or changing the arrangement of segments related to screw kneading to a form in which the screws are deeply meshed with each other, and increasing the kneading degree. Alternatively, it is also preferable to contain an additive having a common skeleton that enhances the interaction of the thermoplastic resin.

As another resin design for achieving a low peeling rate in the laminated film of the present invention, a formulation in which a terminal functional group component that reacts with an unreacted functional group component contained in the thermoplastic resin layer on the other side is contained in the thermoplastic resin layer on the adjacent one side can also be used. Specifically, this is a method in which an unreacted terminal group contained in a thermoplastic resin that forms a thermoplastic resin layer on one side or a terminal group contained in an additive added in advance in a thermoplastic resin layer on one side is reacted with a reactive additive to give a component having the same basic skeleton structure as that of an adjacent thermoplastic resin layer, thereby enhancing the interaction. The functional group for realizing such a reaction can be achieved, for example, by adding an additive containing a terminal group highly reactive with a carboxyl group such as a phenol group, an epoxy group, or an amino group as a reactive additive when the layer on one side contains a carboxyl group terminal, and adding an additive containing an inorganic filler or a metal component as a reactive additive when the layer on one side contains an alkoxysilyl group terminal. In the case of this method, as in the case of copolymerizing, alloying, or blending the thermoplastic resin, in addition to the problem of haze increase due to the dispersion state, the reaction may further proceed when heat is applied to the unreacted additive at the time before the lamination step, and the rheological characteristics may be changed to cause a problem of occurrence of lamination disorder.

Thus, as another aspect, there is a formulation in which one thermoplastic resin layer of thermoplastic resin layers adjacent to each other contains an unreacted functional group that reacts with an unreacted functional group component contained in the other thermoplastic resin layer. This method is preferable because the thermoplastic resin supplied from the individual extruder in the lamination step reacts only after coming into contact with the thermoplastic resin during the lamination step in the laminating device, so that the rheological behavior of the thermoplastic resin constituting each layer is not changed before the lamination step as in the previous method, and occurrence of lamination disorder is reduced and adhesion can be enhanced. In this method, the increase in haze tends to be small as compared with the design in which the terminal group contained in the added additive and the reactive additive are reacted in advance. As a combination of functional groups for realizing such a reaction, the above-described combination of functional groups can be used.

As a control factor for enhancing the interaction between adjacent thermoplastic resin layers, there is a difference in the compatibility parameter (SP value) of the thermoplastic resins constituting the adjacent thermoplastic resin layers. The compatibility parameter as referred to herein is a parameter related to energy inherent in the thermoplastic resin, and indicates that the thermoplastic resins having closer numerical values have higher affinity such as similar skeleton structures, and have higher adhesiveness at their interface. The compatibility parameter can be estimated by a calculation method such as Hansen, Hoy, and Fedors, but the compatibility parameter of the thermoplastic resin, which is an organic polymer material, can be calculated based on the molecular structure of the resin using the Fedors calculation method. By using this method, the compatibility parameter of the thermoplastic resin containing the structural unit derived from the copolymerization component can also be simply calculated according to the ratio of each structural unit. In the Fedors calculation method, the cohesion energy density and molar molecular volume of molecules depending on the type and number of substituents determine the compatibility parameters, and the compatibility parameter is estimated according to the formula (2). Here, $E_{coh}$ (cal/mol) represents cohesion energy, and V represents molar molecular volume (cm$^3$/mol).
[Mathematical formula 2]

$$\delta = \sqrt{E_{coh}/V} \qquad (2)$$

The compatibility parameter in the laminated film of the present invention is a numerical value obtained by rounding off the estimated value calculated on the basis of the Fedors equation to the second decimal place. This method is described in F. Fedors, Polym. Eng. Sci., 14 (2), 147 (1974).

In order for the adjacent thermoplastic resin layers to exhibit good adhesion, the compatibility parameters (SP values) of the adjacent thermoplastic resin layers are preferably designed with a numerical difference of 1.0 or less. The numerical difference of the compatibility parameters often can be reduced, as described above, for example, when the components contained in the thermoplastic resins that form the adjacent thermoplastic resin layers to form an interface are common in the range of 60 mol% or more and 95 mol% or less where the amount of the components constituting the thermoplastic resin is 100 mol%.

Subsequently, a lamination process that achieves a low peeling rate will be described. When a stretching process to be described later is taken as an example, the heat treatment step in a tenter is preferably performed at a temperature within a range that is lower than the melting point of the thermoplastic resin layer having the highest melting point among the thermoplastic resin layers constituting the laminated film and is equal to or higher than the melting point of the thermoplastic resin layer having the lowest melting point among the thermoplastic resin layers different from the thermoplastic resin layer. More preferably, the heat treatment is performed at a temperature equal to or higher than the melting point of the thermoplastic resin layer that exhibits the second highest melting point following the thermoplastic resin layer corresponding to an outermost layer. In the case where a thermoplastic resin layer different from a crystalline thermoplastic resin layer in the laminated film exhibits crystallinity or semi-crystallinity by performing the heat treatment in that temperature range, the crystal of the thermoplastic resin constituting this resin layer melts and becomes amorphous molecules, and the molecular motion is activated through receiving heat, and as a result, the polymers of the thermoplastic resins forming the thermoplastic resin layers adjacent at an interface are diffused with each other and the molecules are entangled with each other, and the compatibility between the two resins is enhanced. Specifically, in the case of a combination of the thermoplastic resin layers exhibiting crystallinity/semi-crystallinity/amorphousness, which is a preferable laminated configuration of the present invention, it is preferable that the thermoplastic resin layers have been treated at a heat treatment temperature between the melting point of the crystalline thermoplastic resin layer and the melting point of the semi-crystalline thermoplastic resin layer.

On the other hand, when the layer other than the thermoplastic resin layer corresponding to the outermost surface of the laminated film is an amorphous thermoplastic resin layer hat exhibits no melting point, the heat treatment preferably has been performed at a temperature that is lower than the melting point of the outermost thermoplastic resin layer but is as high as possible close to the melting point. That is, in the case of a combination of the thermoplastic resin layers exhibiting crystallinity/amorphousness/amorphousness, which is a preferable laminated configuration of the present invention, the thermoplastic resin layers preferably have been heat-treated at a temperature equal to or lower than the melting point of the crystalline thermoplastic resin layer, and specifically, the temperature is preferably in the temperature range of from the melting point of the crystalline thermoplastic resin layer -30°C to the melting point of the crystalline thermoplastic resin layer -5°C. In the case of a laminated film including a crystalline thermoplastic resin layer, the heat treatment temperature of the laminated film can be determined by the microcrystal melting temperature (Tmeta) when the thermal characteristics of the film are heated and measured by a differential scanning calorimeter (DSC) in the measurement method described later.

A low peeling rate can be achieved by combining a plurality of elements among the resin composition, laminated configuration, and process conditions previously described. In view of the above, for example, the first laminated film of the present invention preferably has an ordered array in which thermoplastic resin layers of three different types are arranged in the order of the layer A, the layer B, the layer C, and the layer B, in which these layers are in a combination in which the layer A is a thermoplastic resin layer containing a crystalline thermoplastic resin layer as a main component, the layer B is a thermoplastic resin layer containing a semi-crystalline or amorphous thermoplastic resin as a main component, the layer C is a thermoplastic resin layer containing an amorphous thermoplastic resin as a main component, and where the thermoplastic resin as the main component of the layer A is denoted by A and the thermoplastic resin as the main component of the layer C is denoted by thermoplastic resin C, the layer B contains a thermoplastic resin obtained by alloying, blending, or copolymerizing the thermoplastic resin A with the thermoplastic resin C as a main component, and the heat treatment temperature in the lateral stretching step is equal to or lower than the melting point of the layer A and equal to or higher than the melting point of the layer B. The phrase "having the blend resin as a main component" as described herein means that the thermoplastic resin forming the adjacent thermoplastic resin layer, that is, the thermoplastic resin A and the thermoplastic resin C in this example are blended and supplied at 5 : 95 to 95 : 5 (mass ratio) as a production method, and the thermoplastic resin is contained in an amount of more than 50 mass% and 100 mass% or less of the components constituting the layer B. That is, it is synonymous with that the layer B contains the thermoplastic resin A and the thermoplastic resin C in a total amount of more than 50 mass% and 100 mass% or less when the total amount of the layer B is 100 mass%. The second and third laminated films of the present invention can be similarly interpreted by replacing "layer A, layer B, layer C" with "layer a, layer b, layer c" and "layer $\alpha$, layer $\beta$, layer $\gamma$", respectively.

In the manufacture of the laminated film having ordered arrays of the present invention, the respective thermoplastic resins for forming thermoplastic resin layers of three different types for constituting the ordered arrays may be fed out from different flow paths using three or more extruders, respectively, and a laminate may be formed using a multi-manifold type feed block, a static mixer, or the like which is a known laminating device. In particular, in the case of highly precise lamination for controlling reflection band to a specific wavelength band is required, the accuracy of individual layer thickness control is very important, and thus, a method using a feed block having fine slits is preferable. When a laminate is formed using a slit-type feed block, the thickness and distribution of each layer can be achieved by changing the length and width of the slit to incline the pressure loss. Here, the length of the slit is the length of a comb tooth portion forming a flow path for allowing each thermoplastic resin layer to flow in the slit plate so as to form a constant ordered array. In addition, as a simple method of doubling the number of laminated layers, the lamination step with a laminating device can be combined with a division/merging step with a square mixer, but there may be a case where lamination disorder occurs due to the influence of a change in the flow path sectional area through which the resin flows in the process from division to merging. Therefore, it is preferable that a laminate having a desired number of laminated layers can be constructed in a feed block having fine slits.

The laminated film of the present invention can be designed to have a layer thickness distribution in which the layer thicknesses of different thermoplastic resin layers constituting the laminated film each monotonously increase from one side toward the opposite side, a layer thickness distribution in which the layer thicknesses each increase and then decrease from one side of the film toward the film center, a layer thickness distribution in which the layer thicknesses each decrease and then increase from one side of the film toward the film center, or the like. The inclined form of the layer thickness distribution can be designed to be one that continuously changes such as linear, equal ratio, and gradation sequence, or one in which about 10 to 50 layers have substantially the same layer thickness and the layer thickness changes stepwise.

Since the reflectance of the laminated film at a specific wavelength increases as the number of layers having the same layer thickness increases, a layer thickness distribution having a plurality of inclined distributions in which the layer thickness increases or decreases toward the film center is preferable. However, in a case where the same wavelength band is targeted with the same number of laminated layers, it is necessary to design a layer thickness distribution corresponding to the target reflection wavelength band with a smaller number of laminated layers as compared with a distribution having a monotonous increase/decrease in the distribution having a plurality of inclined distributions, and therefore, the inclination of the layer thickness distribution increases. As a result, there may arise a problem that enhanced color unevenness occurs when the laminated film is viewed due to an increase in the magnitude of undulation of the baseline of reflectance caused by either broadening of the end portion of the reflection band or the occurrence of an optical distance over which light interferes with each other between a plurality of inclination distributions. In order to avoid that problem, the layer thickness of each of the thermoplastic resin layers constituting the laminated film preferably exhibits a monotonously increasing layer thickness distribution. The monotonously increasing layer thickness distribution can be realized by, for example, design of a laminating device such as a feed block (specifically, adjustment of the length and width of slits in the feed block).

In the laminated film of the present invention, where in the wavelength range of 300 nm to 2600 nm, the reflection bandwidth of the widest reflection band $\Pi$ in which a reflectance of 20% or more is exhibited continuously over 100 nm or more is denoted by $\lambda$ [nm], the average reflectance in the reflection band is denoted by R [%], and the film thickness is denoted by t [$\mu$m], ($\lambda \cdot$R)/t is preferably 820 or more and 1400 or less. Here, determination is made using a reflection optical spectrum obtained by performing ten-point averaging processing on a reflection optical spectrum obtained by measuring at a pitch of 1 nm using a spectrophotometer in the reflection optical spectrum measurement described later in Examples. Although details will be described later, reflection optical spectrum data of 300 nm to 2600 nm can be obtained by acquiring reflectance data of 295 nm to 2605 nm in measurement with a spectrophotometer and averaging data of ten consecutive points.

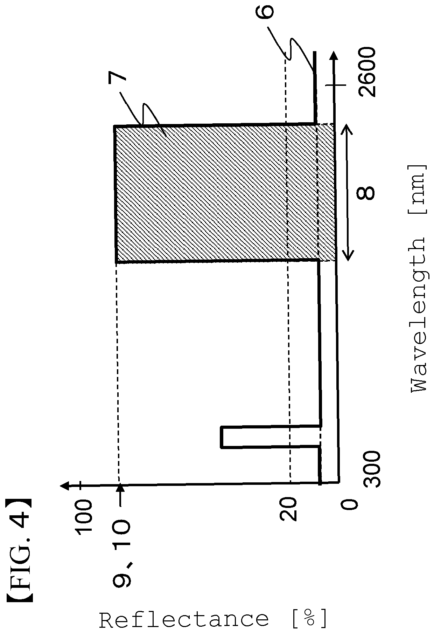

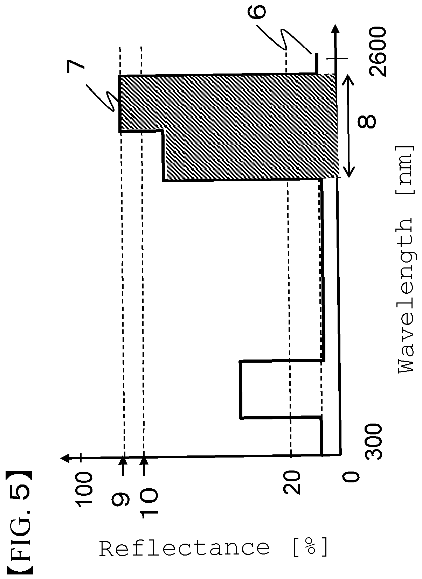

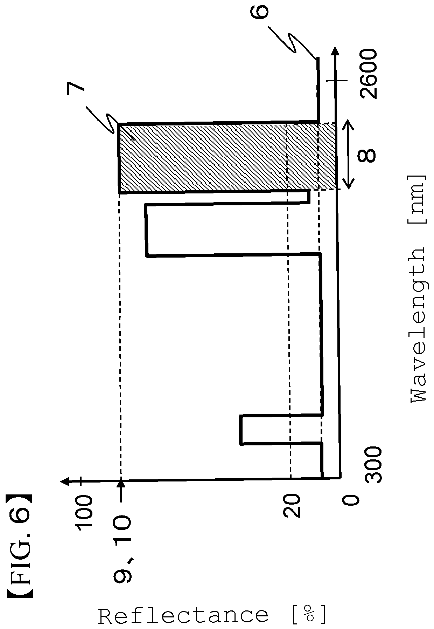

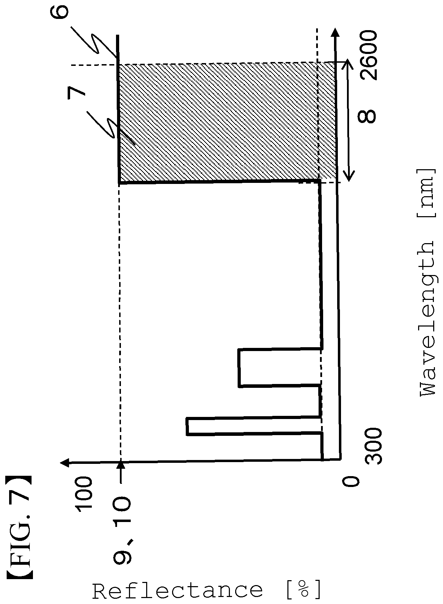

The widest reflection band $\Pi$ in which a reflectance of 20% or more is exhibited continuously over 100 nm or more will be described with reference to Figs. 4 to 7. In Figs. 4 to 7, reference signs 6 to 10 indicate in order a reflection optical spectrum, a reflection band $\Pi$, a reflection bandwidth $\lambda$, a maximum reflectance, and an average reflectance R, and the reflection optical spectrum of reference sign 6 is an optical spectrum obtained by performing ten-point averaging processing. As illustrated in Figs. 4 and 5, the wavelength band $\Pi$ refers to a wavelength band positioned on the longest wavelength side when there is a plurality of wavelength bands in which a reflectance of 20% or more is exhibited continuously over 100 nm or more in the wavelength band from 300 nm to 2600 nm in the optical spectrum subjected to the averaging processing. In Fig. 5 are illustrated an average reflectance and a maximum reflectance in a reflection band shape different from that in Fig. 4. As illustrated in Fig. 6, when the reflection wavelength band includes even a part of a region where a reflectance of less than 20% is exhibited, the wavelength band on the longer wavelength side where a reflectance of 20% or more is exhibited continuously over 100 nm with that region included as a boundary is defined as reflection band $\Pi$. In addition, as illustrated in Fig. 7, when a wavelength band in which a reflectance of 20% or more is exhibited is present on the longer wavelength side beyond 2600 nm, the wavelength band is defined as reflection band $\Pi$ when a reflectance of 20% or more is exhibited over 100 nm or more in a portion included in the wavelength band of 300 nm or more and 2600 nm or less. As a means for causing the laminated film of the present invention to have the reflection band $\Pi$, it is effective to select the thermoplastic resin of each layer such that the difference in refractive index between the thermoplastic resin layer having the largest refractive index in the ordered array and the thermoplastic resin layer having the smallest refractive index is 0.09 or more (more preferably 0.16 or more, still more preferably 0.18 or more, and particularly preferably 0.20 or more), and then set the number of the ordered arrays continuously included to 20 or more, more preferably 50 or more, and still more preferably 100 or more.

Where the reflection bandwidth in the wavelength band $\Pi$ is denoted by $\lambda$ [nm] and the average reflectance in the reflection band is denoted by R [%], $\lambda \cdot$R is represented by the area of the shaded region illustrated in Figs. 4 to 7. Although the area of this region substantially represents the performance of wide band and high reflectance of a laminated film, in the case of laminated films of the present invention, even if the laminated films are manufactured through the same lamination step, the effect of high reflectance and wide reflection band, which is the characteristic of the laminated films of the present invention composed of thermoplastic resin layers of three different types (or thermoplastic resin layers of three types differing in refractive index), band based on the configuration of the laminated films cannot be expressed only by the area of that region $\lambda \cdot$R because the wavelength band shifts according to the thickness of a laminated film. Then, in the present invention, the influence of the wavelength bandwidth change due to the thickness of the laminated film is canceled by dividing the area of the region by the thickness t, and thus the effect of high reflectance and wide reflection band based on the configuration of the laminated film is represented.

As for the area of the region, for example, in the case of a laminated film that uniformly reflects 90% over a wavelength band of 800 nm or more and 1200 nm or less, the area ($\lambda \cdot$R) indicates 36000, which is (1200 - 800)nm $\times$ 90%, by simple calculation. However, when the thickness of the laminated film is reduced to half, the wavelength band becomes 400 nm or more and 600 nm or less, and the area becomes 18000, which is (600 - 400)nm $\times$ 90%, and thus the area varies even with laminated films having the same laminated structure. Therefore, the effect of increasing the wide reflection band and the high reflectance by the laminated film configuration cannot be expressed. Thus, when divided by the film thickness of t $\mu$m for the former case, and divided by the half thickness of t/2 $\mu$m for the latter case, the calculation is ($\lambda \cdot$R)/t = 18000/t in both the cases, and even in the case of laminated films reflecting different wavelength bands, it becomes possible to compare the effects of achieving a wide reflection band and high reflectance based on the configuration of the laminated film without depending on the thickness of the laminated film.

The fact that ($\lambda \cdot$R)/t is 820 or more and 1400 or less indicates that the laminated film is a laminated film having both a high reflectance and a wide band reflection while having a low number of laminated layers (a small film thickness), which cannot be achieved by conventional techniques, especially a laminated film of (AB)m in which thermoplastic resin layers of two types are alternately laminated. The fact that ($\lambda \cdot$R)/t is 820 or more indicates that the thickness or the number of laminated layers of the laminated film for obtaining a certain high reflection and high reflection band is small, and leads to suppression of an increase in size of a manufacturing device, and realization of a laminated film conforming to a recent thinning tendency, for example, as an optical film for a display. Further, since the thickness of the laminated film is small, handleability at the time of post-processing and workability in sputter deposition or the like are also improved. On the other hand, the fact that $(\lambda \cdot R)/t$ is 1400 or less means that realization of a high reflectance and a wide reflection band is achieved with a smaller number of layers than in the conventional alternate lamination technique in consideration of interlayer adhesion and the thickness of the laminated film. In order to realize a high reflectance and a wide reflection band with an excessively small number of layers, it is necessary to increase the difference in refractive index between the thermoplastic resin layers, and for this purpose, it is essential to laminate thermoplastic resin layers made of thermoplastic resins having completely different skeleton structures. Therefore, there is a case where interlayer adhesion is poor when a laminated film is formed. From the above viewpoint, a more preferable range of $(\lambda \cdot R)/t$ is 950 or more and 1400 or less, and still more preferably 950 or more and 1200 or less.

These relationships can be achieved by employing a preferable laminated configuration having the above-described ordered array of (ABCB)x (the layer array in parentheses) or employing a preferable resin composition for realizing a low peeling rate. In addition, it is also effective that the layer B in the ordered array is not in an aspect in which a thermoplastic resin as a main component of the layer A and a thermoplastic resin as a main component of the layer C are mixed, but in an aspect in which a thermoplastic resin different from the main components of the layer A and the layer C is used as a main component. This is because, when thermoplastic resins having completely different skeleton structures are compatibilized by alloying or blending, it is difficult to uniformly disperse each component unless an appropriate compatibilizer is combined in an appropriate blending amount, and the mixed thermoplastic resin readily forms an islands-in-the-sea structure in the layer and this islands-in-the-sea structure may cause a decrease in reflectance due to diffusion of formed light. Note that (ABCB)x can be read as, for example, (abcb) $\times$ in the second laminated film of the present invention and $(\alpha\beta\gamma\beta) \times$ in the third laminated film of the present invention.

The laminated film of the present invention preferably has a reflection lightness L*SCE (D65) of 0.1% or more and 30% or less. By setting the reflection lightness L*SCE (D65) to 30% or less, diffused light is reduced when light incident on the laminated film is reflected, so that the laminated film is made more glossy. A laminated film having high glossiness has a luxurious feeling, and is suitably used for various decorations. In addition, since such a laminated film has not been subjected to processing of providing a metal layer such as vapor deposition or sputtering, the laminated film is also superior in electromagnetic wave permeability and recyclability, and thus can be suitably used for applications requiring both a metallic-tone design and electromagnetic wave transparency. From the above viewpoint, the reflection lightness L*(SCE) of the laminated film is more preferably 20% or less, and still more preferably 15% or less. The reflection lightness L*SCE (D65) can be measured with a spectrophotometer, and details thereof will be described later.

In order to adjust the reflection lightness L*SCE (D65) of the laminated film of the present invention to 30% or less, it is possible to adopt a method in which all the thermoplastic resin layers constituting the ordered array are layers containing a thermoplastic resin of one type or a layer in which thermoplastic resins exhibiting good compatibility are mixed, a method in which an additive having good compatibility is used to a layer containing a thermoplastic resin, or the like (these methods may be used appropriately in combination). This is because when the compatibility between the thermoplastic resins contained in the thermoplastic resin layer and the compatibility between the thermoplastic resins and the additive are good, generation of voids during stretching can be inhibited, and the increase in L*SCE (D65) can be inhibited. From the viewpoint of the windability of the laminated film, it is necessary to impart lubricity to a surface layer of the laminated film in order to prevent wrinkles, surface scratches, and the like at the time of winding the laminated film into a roll form, and therefore L*SCE (D65) practically indicates 0.1% or more. Note that SCE is an abbreviation of "Specular Component Exclude", and is a numerical value obtained by removing specular reflected light and measuring lightness of only diffuse reflected light. That is, L*SCE (D65) refers to the lightness of only the diffuse reflected light of the D65 light source.

The laminated film of the present invention preferably has a flexural rigidity of $0.5 \times 10^{-7}$ [N•m$^2$] or more and $5.2 \times 10^{-7}$ [N•m$^2$] or less. The flexural rigidity is an index representing strength per unit length with respect to bending, and the higher the value of the flexural rigidity is, the harder the film is, and the more easily the film is folded and wrinkled at the time of bending. The flexural rigidity per unit length is represented by $E \times I$, where E represents the Young's modulus [N/m$^2$] in the bending direction of an optically functional film, I represents the secondary moment of inertia of area per unit length, and is represented by the formula (3). This parameter is particularly strongly affected by the thickness h of the laminated film, and therefore, the thinner the film is, the more resistant to bending the film is. When the present laminated film is produced by the production method described later, the flexural rigidity is calculated for each of the longitudinal direction and the width direction of the laminated film, and the higher numerical value preferably satisfies $0.5 \times 10^{-7}$ [N•m$^2$] or more and $5.2 \times 10^{-7}$ [N•m$^2$] or less. From the above viewpoint, a more preferable range of the flexural rigidity is $0.5 \times 10^{-7}$ [N•m$^2$] or more and $3.0 \times 10^{-7}$ [N•m$^2$] or less. The flexural rigidity can be measured in accordance with JIS K-7161 (2014) and JIS K-7127 (1999), and the details thereof will be described later.

[Mathematical formula 3]

$$EI = E \times b \times d^3 / 12 \qquad (3)$$

In the formula (3), b represents a film width [m] of a measurement target, and d represents a film thickness [m].

The flexural rigidity of the laminated film of the present invention can be made to fall within the above-mentioned preferable range by using a crystalline/semicrystalline/amorphous resin combination or a crystalline/amorphous/amorphous resin combination in order to lower the elastic modulus, or by optimizing the layer thickness distribution design of the laminating device, the cast take-up property, and the stretching conditions, thereby manufacturing a laminated film having a reflection band in the visible light reflection region and having a film thickness of about 50 $\mu$m or less. These methods may be used appropriately in combination.

In the laminated film of the present invention, where in dynamic viscoelasticity tan$\delta$ measurement at 0°C or more and 180°C or less, a peak occurring at the highest temperature side is denoted by $P_H$, a peak occurring at the lowest temperature side is denoted by $P_L$, a temperature on the high temperature side indicating an intermediate value between a peak top value of $P_H$ and a high temperature side baseline is denoted by $T_H$ [°C], and a temperature on the low temperature side indicating an intermediate value between a peak top value of $P_L$ and a low temperature side baseline is denoted by $T_L$ [°C], $T_H - T_L$ is preferably 60 or more and 120 or less. In the dynamic viscoelasticity measurement, the softening behavior of the laminated film can be grasped by continuously applying vibration at a constant frequency while increasing the temperature. Since the laminated film of the present invention composed of thermoplastic resin layers of three types has a softening point for each thermoplastic resin constituting each thermoplastic resin layer, a response behavior of a loss tangent tan$\delta$ according to the softening point is obtained. Note that tan$\delta$ can be measured on the basis of Tensile vibration-Non-resonance method of JIS K 7244-4 (1999) (this method is referred to as dynamic viscoelasticity method), and details thereof will be described later.

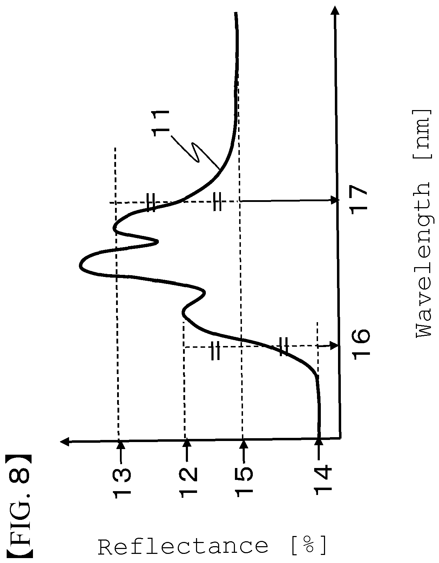

One example of a dynamic viscoelastic spectrum obtained with the laminated film of the present invention is shown in Fig. 8. In Fig. 8, reference sign 11 denotes a loss tangent tan$\delta$ spectrum obtained by dynamic viscoelasticity measurement, reference sign 12 denotes a peak $P_L$ [°C] occurring at the lowest temperature side, reference sign 13 denotes a peak $P_H$ [°C] occurring at the highest temperature side, reference sign 14 denotes a base line on the low temperature side, reference sign 15 denotes a base line on the high temperature side, reference sign 16 denotes a temperature $T_L$ [°C] on the low temperature side indicating an intermediate value between a peak top value of $P_L$ and a low temperature side baseline, and reference sign 17 denotes a temperature $T_H$ [°C] on the high temperature side indicating an intermediate value between a peak top value of $P_H$ and a high temperature side baseline. Fig. 8 shows an example of the spectrum when the softening points of the thermoplastic resins of three types are different, but in the case of a laminated film obtained by combining thermoplastic resins having close softening points, the number of peaks may be two or one. When there is no baseline at which the tan$\delta$ value is constant and the peak-derived slope continues even outside the measurement range, the upper limit of the measurement temperature range of 180°C or the lower limit of 0°C is adopted as $T_H$ or $T_L$.

The $T_H$-$T_L$ indicates a temperature range indicating the softening behavior of the laminated film, and the fact that this range is wide indicates that the temperature responsiveness of the laminated film is good in a wide temperature range. By using a laminated film having a $T_H$-$T_L$ of 60 or more and 120 or less, when the laminated film is composed of the same thermoplastic resin and when the laminated film is used for a molded member exhibiting a metallic tone as described later, improved molding followability is attained even at a low temperature in shaping, and a more homogeneous molded article can be obtained. This, however, does not apply in the comparison of laminated films differing in the type of thermoplastic resins because ease of stretching at the time of molding varies depending on the type of thermoplastic resin. Such a wide temperature response range can be achieved by selecting and laminating thermoplastic resins of three types differing in softening point, but when the softening point temperatures are greatly different, roll adhesion and stretching failure may occur in the film forming step depending on the combination of thermoplastic resins, and thus a resin combination having a $T_H$-$T_L$ of 60 or more and 90 or less is preferable.

Since the laminated film of the present invention has superior reflective properties with respect to visible light than conventional laminated films, the laminated film can be preferably used as a decorative film exhibiting a metallic tone or a colored metallic tone. For example, in automobile applications, the trend of weight reduction of electric vehicles is accelerating, and a portion where metal has been used has been increasingly resinified. Therefore, a metallic tone can be imparted to a front grille, a window molding, an emblem, or the like by integrally molding together with a molding resin. It can also be used for an interior member around an instrument panel for providing a luxurious feeling. In addition, the laminated film can also be used for back surface decoration of home electric appliances and electronic devices, a half mirror film, and the like. In addition to decorative application, the laminated film of the present invention can be used for display applications as a brightness improving film to be disposed immediately above a light guide plate of a backlight of a liquid crystal display, or as an optical reflecting film that reflects and uses only light with a specific wavelength such as red or green without allowing light escaping in a quantum dot display or an organic EL display using a specific light emitting element.

As a use method, it can be used by post-bonding to a product, or in-mold molding or insert molding as a molded body. That is, the molded body of the present invention is formed by using the laminated film of the present invention.

Specific preferable requirements in using the laminated film of the present invention for an in-vehicle member for automobile applications will be described below. The in-vehicle member of the present invention includes a protective layer, a print layer, an adhesive layer, and the laminated film of the present invention.

The protective layer refers to a layer provided for the purpose of imparting weather resistance, light resistance, scratch resistance (impact resistance), and the like to a viewed surface. The method for forming the protective layer is not particularly limited as long as the effect of the present invention is not impaired, and a method of laminating a resin sheet with an adhesive layer or the like interposed therebetween, a method of printing a printing coating material, a method of applying a hard coating material, a method of laminating a resin base material with an adhesive, a pressure-sensitive adhesive, or the like interposed therebetween, a method of integrating a resin by insert molding, or the like can be used.

For example, when the laminated film itself is a thin film, from the viewpoint of forming a protective layer while assisting the moldability of the laminated film, it is also preferable to superimpose a resin sheet as a protective layer on at least one side of the laminated film with a pressure-sensitive adhesive interposed therebetween. This is because when the laminated film itself is a thin film, the laminated film itself may be insufficient in stiffness to cause problems such as wrinkle defects during molding, and the problems can be reduced by bonding the laminated film to the resin sheet in advance with the interposition of the pressure-sensitive adhesive.

The resin to be used for the protective layer is not particularly limited, and for example, such resins as a polybutadiene-based resin, a polystyrene-based resin, a polypropylene-based resin, an acryl-based resin, a polyacrylonitrile-styrene-based copolymer resin, a polyacrylonitrile-butadiene-styrene-based copolymer resin, a polycarbonate-based resin, and a polyacrylonitrile-ethylene-propylene-styrene-based copolymer resin are used. The resin to be used for the resin base material may contain colorants such as dyes, inorganic pigments, and organic pigments, various additives, for example, antioxidants, antistatic agents, crystal nucleating agents, inorganic particles, organic particles, viscosity reducing agents, heat stabilizers, lubricants, infrared absorbers, ultraviolet absorbers, and doping agents for refractive index adjustment, and the like. In the case of automobile applications, it is preferable to use a polycarbonate-based resin, an acrylic resin, a composite thereof, or the like because impact resistance, hardness, and heat resistance are required.

In the in-vehicle member of the present invention, the thickness of the protective layer is preferably 200 $\mu$m or more and 1 cm or less in order to obtain sufficient strength as a molded body suitable for the in-vehicle member. On the other hand, the thickness of the protective layer is more preferably 200 $\mu$m or more and 5 mm or less, and still more preferably 200 $\mu$m or more and 2 mm or less from the viewpoint of a trend of reducing the thickness and weight as an in-vehicle member. The thicknesses of the layers constituting the in-vehicle member and the laminated film can be measured by observing, with a digital microscope, a section produced when the in-vehicle member is cut in parallel with the thickness direction (direction perpendicular to the film plane) of the laminated film, and details thereof will be described later.

The adhesive layer in the in-vehicle member of the present invention refers to a layer laminated to prevent peeling and the like at an interface with the print layer or the protective layer when the laminated film of the present invention is integrally molded. The adhesive layer is preferably provided on at least one side of the laminated film, and can be bonded to a mating member to form an in-vehicle member. The component constituting the adhesive layer is not particularly limited, but it is preferable that an adhesive layer including an acrylurethane copolymerized resin and two or more crosslinking agents is provided.

Examples of the acrylic monomer for forming an acrylurethane copolymerized resin constituting the adhesive layer preferably used for the in-vehicle member of the present invention include alkyl acrylates (examples of the alkyl group include methyl, ethyl, n-propyl, n-butyl, isobutyl, t-butyl, 2-ethylhexyl, and cyclohexyl), hydroxy group-containing monomers such as 2-hydroxylethyl acrylate, 2-hydroxylethyl methacrylate, 2-hydroxypropyl acrylate, and 2-hydroxypropyl methacrylate; amino group-containing monomers such as acrylamide, methacrylamide, N-methylmethacrylamide, N-methylacrylamide, N-methylolacrylamide, N-methylolmethacrylamide, N,N-diethylaminoethyl acrylate, and N,N-diethylaminoethyl methacrylate, glycidyl group-containing monomers such as glycidyl acrylate and glycidyl methacrylate, and monomers containing a carboxyl group or a salt thereof such as acrylic acid, methacrylic acid, and salts thereof (sodium salt, potassium salt, ammonium salt, etc.).

The urethane component that can be used for the adhesive layer of the in-vehicle member of the present invention may be a resin obtained by reacting a polyhydroxy compound and a polyisocyanate compound by a known polymerization method of a urethane resin such as emulsion polymerization or suspension polymerization. Examples of the polyhydroxy compound for constituting the urethane component include polyethylene glycol, polypropylene glycol, polyethylene-polypropylene glycol polytetramethylene glycol, hexamethylene glycol, tetramethylene glycol, 1,5-pentanediol, diethylene glycol, triethylene glycol, polycaprolactone, polyhexamethylene adipate, polyhexamethylene sebacate, polytetramethylene adipate, polytetramethylene sebacate, trimethylolpropane, trimethylolethane, pentaerythritol, polycarbonate diol, and glycerin.

The crosslinking agent for obtaining the adhesive layer in the present invention preferably copolymerize a crosslinkable functional group, and for example, a melamine-based crosslinking agent, an isocyanate-based crosslinking agent, an aziridine-based crosslinking agent, an epoxy-based crosslinking agent, a methylolated or alkylolated urea-based crosslinking agent, an acrylamide-based crosslinking agent, a polyamide-based crosslinking agent, an oxazoline-based crosslinking agent, a carbodiimide-based crosslinking agent, various silane coupling agents, various titanate-based coupling agents, and the like can be used.

In addition, since the component of the adhesive layer is likely to be charged if it is present alone, as a result, foreign matters may be mixed between the laminated film and the print layer or the protective layer due to static electricity and may cause a problem of appearance defects. Therefore, the component of the adhesive layer preferably includes a conductive polymer from the viewpoint of antistatic properties. Examples of the conductive polymer include polypyrrole, polyaniline, polyacetylene, polythiophene-vinylene, polyphenylene sulfide, poly-p-phenylene, and polyheterocycle-vinylene, and (3,4-ethylenedioxythiophene) (PEDOT) is particularly preferable.

The thickness of the adhesive layer of the present invention is preferably 0.5 $\mu$m or more and 30 $\mu$m or less from the viewpoint of achieving both adhesiveness and film appearance. When the thickness of the adhesive layer of the present invention is less than 0.5 $\mu$m, adhesion may be impaired. On the other hand, when the thickness of the adhesive layer of the present invention exceeds 30 $\mu$m, film appearance may be impaired due to thickness unevenness of the adhesive layer. A preferable range of the thickness of the adhesive layer of the present invention is 0.7 $\mu$m or more and 20 $\mu$m or less, more preferably 1 $\mu$m or more and 10 $\mu$m or less, and still more preferably 2 $\mu$m or more and 5 $\mu$m or less.

In the in-vehicle member of the present invention, the thickness of the laminated film of the present invention is preferably 20 $\mu$m or more and 200 $\mu$m or less. The thickness is more preferably 20 $\mu$m or more and 70 $\mu$m or less because the laminated film of the present invention is characterized by exhibiting a high reflectance at a smaller thickness.

In the in-vehicle member of the present invention, the print layer refers to a colored layer provided on a side of a visible-light-permeable laminated film opposite from the viewed side of the molded body in order to produce a desired color tone for use in automobile interior materials or exterior materials. The print layer is preferably composed of a single color of a standard product called a standard color, a set color, a general color, or the like of a print coating material. By adopting such a colored layer, it is possible to form the printing layer at low cost while improving the yield due to the reduction of the man-hours as compared with a print coating material obtained by mixing the print coating material and a colorless and transparent standard product called Medium, Victoria, or the like to adjust color density, namely, a print coating material obtained by mixing two or more colors selected from among standard products called a standard color, a set color, a general color, or the like of print coating materials to adjust the color to a prescribed color.

The print coating material is not particularly limited as long as the effect of the present invention is not impaired, and examples thereof include those obtained by adding a colorant such as a dye, an inorganic pigment, or an organic pigment to a light-transmissive resin such as a polyester-based resin, a polyolefin-based resin, an acrylic resin, a urethane-based resin, a fluorine-based resin, a polyvinyl acetate-based resin, a vinyl chloride-vinyl acetate copolymer-based resin, or an ethylene-vinyl acetate copolymer-based resin copolymer.

The method for forming the print layer is not particularly limited as long as the effect of the present invention is not impaired, and for example, coating, printing, or the like can be used. For example, printing methods such as a gravure printing method and a screen printing method can be used as well as coating methods such as a roll coating method, a gravure coating method, and a comma coating method. The thickness of the print layer formed by coating or printing is preferably 1 $\mu$m or more and 100 $\mu$m or less, more preferably 2 $\mu$m or more and 40 $\mu$m or less, and still more preferably 2 $\mu$m or more and 20 $\mu$m or more from the viewpoint of color tone retention after molding and designability. On the other hand, as the reflectance exhibited by the laminated film of the present invention increases, the amount of light transmitted through the laminated film decreases, so that the coloring effect by the print layer can be minimized as much as possible, and as a result, there arises an advantage that the print layer can be thinned.

The laminated film of the present invention is characterized in that wide band reflection and high reflectance in a visible light region can be realized owing to the use of thermoplastic resins of three different types. In consideration of this characteristic of wide band reflection, in the in-vehicle member of the present invention, the thickness ratio of the thickest portion to the thinnest portion of the laminated film of the present invention is preferably 1.2 times or more and 2.5 times or less, and more preferably 1.2 times or more and 1.5 times or less. In general, when an optical reflective film having a laminated structure as in the present invention is used as a molded article, a portion where the laminated film is thinned occurs due to elongation during molding. When a conventional laminated film having a reflection band in a visible light region is used for this application, it has been a problem that a shift of the reflection band toward a short wavelength side and coloring accompanying the shift occur. Then, the application of a laminated film having a wide reflection band can afford an aspect in which even when the reflection band is shifted to the shorter wavelength side due to thinning after molding, the average reflectance in the visible light region is maintained and the metallic-tone appearance is not damaged.

In the in-vehicle member of the present invention, the thickness ratio of the thickest portion to the thinnest portion of the laminated film can be measured and calculated by the following procedure. First, the inside of an in-vehicle member is cut in parallel with the thickness direction of the laminated film (direction perpendicular to the film plane) at ten arbitrary points, and then the thickness of the laminated film at each point is measured by observing the laminated state using a digital microscope. Thereafter, a value obtained by dividing the maximum value of the obtained value by the minimum value is obtained, and this is defined as a thickness ratio of the thickest portion to the thinnest portion of the laminated film of the present invention in the in-vehicle member (a detailed measurement method will be described later). In order that the in-vehicle member satisfies the thickness ratio and the entire in-vehicle member has a uniform metallic-tone appearance without coloring or the like, it is preferable that the reflection band of the laminated film has a reflection band over the entire visible-light band, and the long-wavelength end of the reflection band exhibits a longer wavelength side than 950 nm, namely, the reflection band exhibits 550 nm or more. Such a laminated film can be achieved by designing a laminating device.

Since the laminated film of the present invention can realize high reflectance, the in-vehicle member of the present invention can be an in-vehicle member having a light-shielding region having a light permeability of 20% or less. Since the laminated film of the present invention itself exhibits a high reflectance, it is not necessary to provide a thick print layer for exhibiting designability on the entire molded body as in the conventional case. Therefore, it is possible to provide a light-shielding region in which the laminated film is laminated as an in-vehicle member without performing a print screen processing step. Furthermore, depending on designability, an in-vehicle member having a light-shielding region and a light-permeable region at the same time may be required. By using the laminated film of the present invention and thinning the print layer as much as possible, there is no loss of light permeability due to light absorption of the print layer, and it is easy to simultaneously provide a region having high light permeability in addition to the light-shielding region where the laminated film is laminated, as an in-vehicle member. Specifically, since the print layer can be thinned as described above, it is possible to provide an in-vehicle member having a light-permeable region in which visible light absorption is suppressed and the light permeability is 80% or more.

A preferred aspect of a vehicle using an in-vehicle member having the characteristics described above will be described below. The vehicle described in the present invention collectively refers to an automobile traveling on a road, a motorized bicycle, a light vehicle, and an industrial vehicle used in a railway vehicle, a factory, and the like. In particular, in automobiles, mounting of an advanced driver assistance system (ADAS) for the purpose of improving safety is promoted, and radars using high-frequency electromagnetic waves, light detection and ranging (LiDAR) using near infrared rays, and the like are mounted as transmission devices that play a role of the advanced driver assistance system. Conventionally, since an in-vehicle member in which a metallic housing, a metal vapor-deposited film, or the like is molded is used, it has been difficult to combine such an in-vehicle member with those transmission devices for ADAS due to the electromagnetic wave shielding property and near-infrared reflectivity unique to metal.

Then, the in-vehicle member using the laminated film of the present invention can be preferably used in combination with a radar using a high frequency electromagnetic wave or LiDAR from the viewpoint of having a metallic-tone appearance exhibiting reflection in a visible light region as a molded body, and further having superior visible light reflection characteristics and being capable of controlling reflection characteristics with respect to a near-infrared reflection band.

The vehicle of the present invention includes the in-vehicle member of the present invention and a millimeter wave radar that exhibits a peak intensity at any of frequencies of 22 GHz to 26 GHz, 58 GHz to 62 GHz, and 76 to 80 GHz. Normally, a radar using an electromagnetic wave in a frequency band having a different transmission distance is used depending on a distance to a moving object such as a surrounding vehicle, a bicycle, or a person to be detected in each of the front, side, and rear of a vehicle. However, the in-vehicle member of the present invention does not have shielding performance for any high-frequency electromagnetic wave, and thus can exhibit superior electromagnetic wave permeability in combination with a radar in any frequency band. Specifically, in the case of an automobile, the in-vehicle member of the present invention can be suitably used as an exterior member of a front grille, an emblem portion, and a radar cover portion.

Furthermore, the vehicle of the present invention may be an aspect in which the vehicle includes a radar cover that transmits infrared rays and the radar cover includes the in-vehicle member of the present invention. By means of controlling the infrared ray reflection performance and reflection band of the laminated film by a thickness or a layer thickness distribution so as not to have reflection performance at a near-infrared wavelength used by LiDAR, application to a vehicle using LiDAR is also made possible.

Next, the image display device of the present invention will be described. The image display device of the present invention includes a screen protective layer, a light source, a transistor, and the laminated film of the present invention. The image display device refers to a device for displaying an image, and examples thereof include a liquid crystal image display device, an organic EL display, and a quantum dot display.

The protective layer in the image display device refers to a member for protecting the image display device from an external environment including temperature and humidity. The material and thickness of the member constituting the protective layer are not particularly limited as long as the member has weather resistance, transparency, strength, and the like necessary for the image display device to which the member is applied, but the material is preferably an optical grade glass material or a plastic material. The protective layer is preferably transparent from the viewpoint of visibility. The thickness of the protective layer generally may be 0.2 mm or more and 20 mm or less, and is preferably 0.5 mm or more and 5 mm or less. When the protective layer has a thickness of 0.2 mm or more, the protective layer has sufficient strength, and generation of cracks is inhibited. On the other hand, when the thickness of the protective layer is 20 mm or less, an image display device in accordance with the recent trend of thickness reduction is afforded. The protective layer may have, on the top side (visible side) thereof, a processed layer having various functions such as an anti-glare property, oil repellency, antifouling property, self-repairing property, blue light cutting, and a hard coat, or a surface-treated film subjected to the processing laminated thereon. The surface-treated film may be a single-layer film or a film having a laminated structure in which a plurality of resins is laminated.

The light source in the screen display device, in the case of a liquid crystal image display device, refers to a direct type backlight, a long-life and high-brightness edge type backlight including LED lights arranged in a row and a light guide plate, and the like. In the case of an organic EL display, the light source refers to a self-luminous display panel unit having a configuration in which a layer composed of molecules transporting holes or electrons and light-emitting molecules exhibiting three colors, namely red, green, and blue, exhibiting fluorescence or phosphorescence is sandwiched between electrode layers. In the case of a quantum dot display, the light source refers to a blue LED light unit disposed on the back face of a quantum dot sheet containing semiconductor components that are excite and emit light in red and green.

The transistor in the image display device, in the case of a liquid crystal image display device, refers to a microfabricated thin film transistor (TFT) for aligning a liquid crystal by applying a voltage to the liquid crystal. In the case of an organic EL display, the transistor refers to a transistor formed on a CMOS substrate using a single crystal silicon wafer. The transistor portion may employ any form among a transistor using amorphous silicon, LTPS using polycrystalline silicon, or IGZO using a four-element compound of indium, gallium, zinc and oxygen.

In the image display device of the present invention, the laminated film of the present invention can be preferably applied as a brightness increasing film that specularly reflects light emitted to the back face and retroreflects the light toward the viewing side by being applied to the back face of the light source of the image display device. In recent years, for the purpose of expanding application places of displays, image display devices have been used not only in applications such as TVs, PC displays, and mobile phones but also in in-vehicle devices and industrial devices. As an in-vehicle device, in addition to a conventional navigation device, the application of an image display device has been spread to applications such as an instrument panel, which is a facial panel of a speedometer, a warning lamp or the like assembled to a dashboard, and a back monitor that displays an image behind a vehicle. Among them, there is a demand for a display device with which design is emphasized, and a display region may be manufactured by punching the display region into a shape having rounded corners, a shape having a complicated curved surface, a shape having a hole in the central portion, or the like instead of the conventional planar rectangular shape. When punching into such a special shape, a laminated film designed to have a high reflectance based on the conventional alternately laminated structure has a problem that the laminated film cannot withstand the punching process because of insufficient interlayer adhesion thereof. Therefore, as in the laminated film of the present invention, a laminated film that uses thermoplastic resins of three different types and achieves interlayer adhesion enough to withstand punching can be suitably utilized for a screen display device having a display region having a shape other than a rectangle. That is, in the image display device of the present invention, the display region preferably has a shape other than a rectangle.

Hereinafter, the lighting device of the present invention will be described. The lighting device of the present invention has the laminated film of the present invention on the back side of a light source. For the purpose of improving the illuminance of LED lighting using a light emitting diode, lighting using an electrothermal lamp, and the like, by covering the inner surface of a frame covering the lamp with the laminated film of the present invention (in other words, by disposing the laminated film on the back surface of a light source), light emitted from the lamp toward the frame can be reflected to the front surface, so that the illuminance can be improved. Since the lamp frame is not generally on a plane but often has a curved three-dimensional improvement, in the lighting device of the present invention, the laminated film of the present invention preferably has a three-dimensional shape. The three-dimensional shape as referred to herein indicates a state in which the length of the longest side in a rectangular parallelepiped formed so as to surround the laminated film after molding is 0.9 times or less the length of the long side of the laminated film used.

The solar battery module of the present invention is formed by using the laminated film of the present invention. Specifically, the laminated film of the present invention can be utilized for the application in which of the sunlight, light having permeated through gaps without being absorbed by cells is reflected to the front surface and caused to be incident again, so that the efficiency of visible light utilization by cells is increased. Specifically, the laminated film of the present invention having reflective properties with respect to visible light can be applied to an immediately above face of the back sheet portion of a solar battery module or an aluminum frame portion provided on the side face of the solar battery module.

Next, a preferred method for producing the laminated film of the present invention will be described below. Of course, the present invention should not be construed as being limited to such an example. All of the first, second, and third laminated films of the present invention can be produced by the same method as long as thermoplastic resin layers are combined so as to satisfy the requirements of the laminated films.

The thermoplastic resin to constitute each thermoplastic resin layer of the laminated film is prepared in the form of pellets or the like. The pellets are dried in hot air or under vacuum as necessary, and then fed to separate extruders. When an additive is contained in the thermoplastic resin, powder, granule, and liquid additives may be kneaded and dispersed in the process of the main extrusion, or master pellets in which the additive is dispersed in the thermoplastic resin in advance may be supplied. Each of the thermoplastic resins melted in the extruder by heating to a temperature equal to or higher than the melting point is made uniform as to the extrusion amount by a gear pump or the like, and is freed of any foreign matters or denatured resin through a filter or the like. These thermoplastic resins are discharged in a sheet form from a die after a desired laminate is formed through a laminating device. Then, the molten sheet-like material discharged from the die is extruded onto a cooling body such as a casting drum and cooled and solidified to form a cast sheet. In this process, it is preferable to bring the sheet into close contact with the cooling body such as a casting drum by an electrostatic force using a wire-like, tape-like, needle-like, or knife-like electrode, and to rapidly cool and solidify the sheet. It is also preferable to employ a method of bringing the sheet into close contact with the cooling body such as a casting drum by blowing air from a slit-like, spot-like, or planar device, and rapidly cooling and solidifying the sheet, or bringing the sheet into close contact with the cooling body using a nip roll, and rapidly cooling and solidifying the sheet. A liquid having good wettability such as liquid surfactant water or liquid paraffin can be supplementally applied to the surface of the casting drum to impart adhesion.

The respective thermoplastic resins to form the thermoplastic resin layers of three different types to constitute a laminated film (in the case of the first and third laminated films of the present invention; this term is read as "thermoplastic resin layers of three types differing in refractive index" in the case of the second laminated film of the present invention) are fed out from different flow paths using three or more extruders, and sent into a multilayer laminating device before being discharged in a sheet form. Examples of usable multilayer laminating device include a multi-manifold die, a feed block, and a static mixer. In particular, in order to efficiently obtain the multilayer lamination structure, a feed block having fine slits is preferably used. Since the device is not extremely large, use of such a feed block produces less generation amount of foreign matters by thermal deterioration, and enables highly precise lamination even when an extremely large number of layers are laminated. Moreover, the precision of lamination in the width direction is also significantly improved as compared with conventional techniques. In this device, since the thickness of each layer can be adjusted by the shape of the slit (length, width), any layer thickness can be achieved. The molten multilayer laminated sheet thus formed into a desired layer configuration is guided to a die, and a cast sheet is obtained as described above.

The obtained cast sheet is preferably, subsequently biaxially stretched in the longitudinal direction and the width direction. The stretching may be sequentially biaxially stretched or simultaneously biaxially stretched. Further, the cast film may be re-stretched in the longitudinal direction and/or the width direction. Here, the longitudinal direction refers to a running direction of the film, and the width direction refers to a direction orthogonal to the longitudinal direction in the film plane.

First, the case of sequential biaxial stretching will be described. Here, the stretching in the longitudinal direction refers to uniaxial stretching for imparting molecular orientation in the longitudinal direction to the sheet, and the stretching is usually performed by a circumferential speed difference of rolls, and may be performed in one step or in multiple steps using a plurality of roll pairs. The stretch ratio varies depending on the type of the resin, but is usually preferably 2 to 10 times, and for example, when polyethylene terephthalate or polyethylene naphthalate, which is a thermoplastic resin for forming a crystalline thermoplastic resin layer preferably used for the laminated film of the present invention, is used, 2 to 7 times is particularly preferably used. The stretching temperature is preferably set within the range from the glass transition temperature to the glass transition temperature + 100°C of the thermoplastic resin layer having the highest glass transition temperature among the thermoplastic resin layers constituting the laminated film. When the film is strongly oriented in the stretching step in the longitudinal direction, neck-down in the film width direction occurs, and thus a sufficient film width cannot be obtained, and thickness unevenness and transmission spectrum unevenness in the longitudinal direction and/or the width direction after stretching in the width direction may increase.

The uniaxially-stretched laminated sheet thus obtained is subjected to a surface treatment such as a corona treatment, a frame treatment, or a plasma treatment as necessary, and then an easily adhesive layer having functions such as slipperiness, adhesiveness, and antistatic properties is applied by in-line coating. In the in-line coating step, the easily adhesive layer may be applied to one surface of the laminated film, or may be applied simultaneously or sequentially to both surfaces of the laminated film.

Subsequently, the uniaxially-stretched laminated sheet is stretched in the width direction. The stretching in the width direction refers to stretching for imparting orientation in the width direction to the sheet, and is usually performed by conveying the sheet while holding both ends in the width direction with clips using a tenter. The stretch ratio varies depending on the type of the resin, but is usually preferably 2 to 10 times, and for example, when polyethylene terephthalate or polyethylene naphthalate, which is a thermoplastic resin for forming a crystalline thermoplastic resin layer preferably used for the laminated film of the present invention, is used, 2 to 7 times is particularly preferably used. The stretching temperature is preferably from the glass transition temperature to the glass transition temperature + 120°C of the resin having the highest glass transition temperature among the resins constituting the laminated film.

The laminated film thus biaxially stretched is heat-treated in a tenter at a temperature equal to or higher than the stretching temperature and equal to or lower than the melting point of the thermoplastic resin layer having the highest melting point among the thermoplastic resin layers constituting the laminated film, uniformly cooled slowly, and then cooled to room temperature and wound up. In addition, as necessary, a relaxation treatment or the like may be performed together in the longitudinal direction and/or the width direction at the time of slow cooling from the heat treatment in order to impart thermal dimensional stability.

Subsequently, the case of simultaneous biaxial stretching will be described. In the case of simultaneous biaxial stretching, the obtained cast sheet is subjected to a surface treatment such as a corona treatment, a flame treatment, or a plasma treatment as necessary, and then functions such as slipperiness, adhesiveness, and antistatic properties may be imparted to the film by in-line coating. In the in-line coating step, the adhesive layer may be applied to one surface of the laminated unit, or may be applied simultaneously or sequentially to both surfaces of the laminated film.

Then, the cast sheet is led to a simultaneous biaxial tenter, conveyed with both end portions in the width direction of the sheet being held with clips, and stretched in the longitudinal direction and the width direction simultaneously and/or in stages. Examples of a simultaneous biaxial stretching machine include those of a pantograph type, a screw type, a drive motor type, and a linear motor type. A simultaneous biaxial stretching machine of a drive motor type or a linear motor type is preferable because the machine is capable of changing the stretch ratio arbitrarily and capable of performing the relaxation treatment at any place. The stretch ratio varies depending on the type of the resin, but the area ratio is usually preferably 6 to 50, and when polyethylene terephthalate or polyethylene naphthalate, which is a thermoplastic resin to form a crystalline thermoplastic resin layer preferably used for the laminated film of the present invention, is used, the area ratio is particularly preferably 8 to 30. The stretching speed may be the same speed, or the film may be stretched in the longitudinal direction and the width direction at different speeds. The stretching temperature is preferably from the glass transition temperature to the glass transition temperature + 120°C of the thermoplastic resin layer having the highest glass transition temperature among the thermoplastic resin layers constituting the laminated film.

The sheet simultaneously biaxially stretched as described above is preferably subsequently subjected to a heat treatment for imparting planarity and dimensional stability in the tenter at a temperature equal to or higher than the stretching temperature and equal to or lower than the melting point. In the heat treatment, it is preferable to perform a relaxation treatment in the longitudinal direction instantaneously immediately before and/or immediately after the film enters the heat treatment zone in order to reduce the distribution of the main orientation axis in the width direction. After being heat-treated in this manner, the film is gradually cooled down uniformly, and then cooled to room temperature and wound up. A relaxation treatment in the longitudinal direction and/or the width direction may be performed as necessary during the gradual cooling from the heat treatment. In addition, a relaxation treatment may be instantaneously performed in the longitudinal direction immediately before and/or immediately after the sheet enters the heat treatment zone.

The laminated film obtained as described above is trimmed to a necessary width through a winding device, and wound in a roll state so as not to cause winding wrinkles. At the time of winding the film, both ends of the film may be embossed to improve the winding shape.

The thickness of the laminated film of the present invention is not particularly limited, but is preferably 20 μm or more and 100 μm or less. The thickness is preferably 70 μm or less, more preferably 50 μm or less in consideration of the tendency of various functional films to be thinned. Although there is no lower limit, it is practically preferable that the thickness is 20 μm or more in order to stabilize the roll windability and form a film without breakage.

The method for adjusting the thickness of the laminated film is not particularly limited, but since it is preferable to adjust the thickness without changing the stretch ratios in the conveyance direction and the width direction, it is preferable to adjust the thickness by increasing or decreasing the take-up speed of the cooling body such as the casting drum. To suppress film width shrinkage occurring at this time, it is preferable to appropriately adjust a gap between the die and the cooling body. When the film width cannot be made constant, for example, the stretch ratio in the width direction can be made constant by adjusting the distance between clips in the tenter.

A hard coat layer including a curable resin as a main component may be laminated on the outermost surface of the laminated film of the present invention to add functions such as scratch resistance, dimensional stability, adhesiveness and adhesion. When the laminated film is conveyed by roll-to-roll for mounting on a product, scratches due to rubbing between the roll and the film can be prevented from occurring on the surface of the laminated film. Further, even when the resin oligomer component in the laminated film or various additives that can be added to the laminated film may bleed out in the high temperature heat treatment, the hard coat layer having a high crosslinking density can exhibit the precipitation suppressing effect by providing the hard coat layer on the outermost surface. In addition, by laminating the curable resin layer, a dimensional change of the film due to heat treatment can be suppressed, and an increase in film thickness due to thermal shrinkage and a change in optical characteristics such as a transmission spectrum of the laminated film associated therewith can be suppressed. On the other hand, optically, it is preferable to provide a thermosetting resin layer exhibiting a refractive index lower than the refractive index of the thermoplastic resin layer exhibiting crystallinity of the surface of the laminated film because the difference in refractive index between the thermosetting resin layer and the air interface is reduced, so that surface reflection can be suppressed and the reflectance of the entire laminated film can be increased.

In addition to the hard coat layer, an abrasion resistant layer, an antireflection layer, a color correction layer, an ultraviolet absorbing layer, a tacky layer, a gas barrier layer to which a metal oxide or the like is added, a print layer, or the like may be formed as a layer exhibiting functionality. These layers may be a single layer or a multilayer, and one layer may have a plurality of functions.

EXAMPLES

The present invention will now be described by way of examples thereof; however, the present invention is not restricted thereto. The respective characteristics were measured by the following methods.

(Method for Measuring Properties and Method for Evaluating Effects)

Methods for measuring properties and methods for evaluating effects in the present invention are as follows.

(1) Differential Scanning Calorimetry (DSC)

A differential scanning calorimeter EXSTAR DSC 6220 manufactured by Hitachi High-Technologies Corporation was used. Measurement and temperature reading were performed according to JIS K 7122 (1987). Specifically, the temperature of about 5 mg of a sample was raised on an aluminum receiving pan from 25°C to 300°C at a rate 10 °C/min. At a temperature higher than the glass transition temperature Tg (°C) at the intersection of the baseline during the temperature raising from room temperature and the tangent at the infection point of the step transition portion, the microcrystal melting temperature Tmeta (°C) at which a minute endothermic peak different from the melting point was exhibited was read. Further, after the temperature raising, the sample was rapidly cooled with liquid nitrogen, and then the temperature was raised under condition the same as those described above. At this time, an enthalpy of fusion Tm (J/g), which corresponds to the area of the endothermic peak (melting point) confirmed at the highest temperature side, was read.

(2) Layer Configuration

The layer thickness distribution of the laminated film was determined by transmission electron microscope (TEM) observation of a sample sliced using an ultramicrotome. Specifically, using a transmission electron microscope JEM-1400 Plus (manufactured by JEOL Ltd.), a section of the laminated film (a section in the thickness direction, namely, a direction perpendicular to the film plane) was observed under the condition of an acceleration voltage of 100 kV, and a sectional image was acquired to measure the layer configuration (the number of laminated layers, ordered arrays, and the layer thickness distribution) and the thickness of each layer. To obtain a large contrast difference between the layers, a dyeing technique using an electron dye ($RuO_4$ or the like) was used. In accordance with the thickness of each layer, observation was performed at a direct magnification of 40,000 when the thin film layer thickness was less than 100 nm, at a direct magnification of 20,000 when the thin film layer thickness was 100 nm or more and less than 500 nm, and at a magnification of 1000 to 10,000 depending on the thickness when the thin film layer thickness was 500 nm or more, and the layer thickness distribution was analyzed. The number of laminated layers, the ordered array, the thickness of each layer, and the layer thickness distribution were determined on the basis of the contrast difference of the obtained image.

(3) Layer Interface (Contrast Difference)

The sectional image obtained by the transmission electron microscope observation of (2) was converted into a compressed image file (JPEG) format, and position-brightness data was acquired through a line profile along the thickness direction of the laminated film using ImagePro-10 produced by Media Cybernetics, Inc. Thereafter, a five-point moving averaging processing was performed on the profile obtained by plotting the relationship between the position and the brightness using spreadsheet software "Excel" (registered trademark) 2016. In the averaging processing, brightness averaging processing was performed on five consecutive measurement positions, and similar calculation was performed by changing the position one by one and performing continuous processing, thereby acquiring a position-brightness profile subjected to the averaging processing. In the obtained average-processed position-brightness profile, a position surrounded by an inflection point at which the inclination changes from positive to negative or from negative to positive was determined as one layer. For each layer obtained by this method, subsequently, position-brightness data was acquired with respect to a planar direction (direction perpendicular to a thickness direction) of the laminated film. After calculating the average value and the standard deviation of the brightness obtained for each layer, it was determined that adjacent two layers were different when the difference between the average values of the brightness of the adjacent two layers was larger than any of the standard deviations of the brightness of the adjacent thermoplastic resin layers. In addition, the difference (distance) in position between the inflection points was calculated as the layer thickness of each layer.

(4) Thickness Ratio

The thickness ratio of the respective ordered arrays constituting the laminated film was calculated using the layer thicknesses of the respective layers calculated by the methods described in (2) and (3). Specifically, the thickness ratio A/B and the thickness ratio C/B were calculated from the total value of the layer thicknesses of all the layers A and all the layers C included in the ordered arrays, based on the total value of the layer thicknesses of all the layers B included in the ordered arrays, focusing on the ordered arrays of the portion excluding the outermost layer of the laminated film. The thickness ratios were calculated as described above for the respective ordered arrays contained in the laminated film, and the average values thereof were defined as the final thickness ratios A/B and C/B.

(5) Reflection Optical Spectrum Measurement

A sample was cut out in a 4 cm square from the center in a width direction of the laminated film, and one side of the laminated film was subjected to a back surface blackening treatment using a black lacquer spray. In the back surface blackening treatment, overcoating was performed three times to completely block light. Using a spectrophotometer U-4100 manufactured by Hitachi High-Tech Science Corporation, an aluminum oxide plate was fixed as a reflection member to the opening on the back side of the integrating sphere. In addition, as an absolute reflectance measurement unit using specular reflection, an attached 12° specular reflection accessory (P/N134-0104) was installed immediately before the integrating sphere, the sample subjected to back surface blackening was firmly attached to the unit with the untreated side of the sample facing the unit, a reflection optical spectrum in a wavelength range of 295 nm to 2605 nm was continuously measured, and data at ten consecutive points was averaged, affording reflection spectral data of 300 nm to 2600 nm. In the measurement, the scan speed was set to 600 nm/min, and the sampling pitch was set to 1 nm. On the basis of the obtained reflection optical spectrum, reading was performed where the widest reflection band in which a reflectance 20% or more was exhibited continuously over 100 nm or more was defined as $\Pi$, the reflection bandwidth of this wavelength band $\Pi$ was defined as $\lambda$, and the average reflectance of the reflection band was defined as R. In addition, the maximum reflectance and the average reflectance at a wavelength of 400 to 800 nm, the reflection band in which a reflectance of 20% or more was exhibited continuously over 100 nm or more in the range of a wavelength of 300 to 2600 nm (and the presence or absence of this reflection band), and the reflection band in which a reflectance of 75% or more was exhibited continuously over 100 nm or more in the range of a wavelength of 400 to 800 nm (and the presence or absence of this reflection band) were also read similarly from the reflection optical spectrum obtained, and whether or not a reflectance of 80% or more was exhibited continuously over the entire wavelength range of 400 to 800 nm was determined from the same spectrum. Further, the standard deviation $\sigma$ of the reflectance in a reflection band was calculated, and the reflectance unevenness in the reflection band was calculated as $\sigma/R \times 100$ in percentage.

(6) Crosscut Peeling Rate

Evaluation was performed according to an adhesion (cross-cut) test method specified in JIS K 5600-5-6 (1999). Using a cross cut guide CCJ-1 with an interval of 1 mm manufactured by COTEC, 11 vertical and horizontal orthogonal cuts were made at an angle of 20 to 30° with an NT cutter to create a 100 square grid. "Cellotape" (registered trademark) manufactured by NICHIBAN Co., Ltd. having a width of 24 mm was stuck to the grids, the tape was quickly peeled off at an angle of about 60°, and the number of completely peeled grids was read. This operation was repeated 10 times, and the average value of the number of peeled grids was obtained to calculate the peeling rate.

(7) Haze

A haze meter (HGM-2DP) manufactured by Suga Test Instruments Co., Ltd. was used. A sample was cut out in a size of 10 cm $\times$ 10 cm from the center in the film width direction, and the total light transmittance and the haze value were measured in accordance with the former JIS K 7105 (1994). The measurements were carried out at three points at equal intervals in the film width direction, and the average values were taken as the measurement results.

(8) Electron Energy Loss Spectroscopy (EELS Measurement)

Before the measurement, the main orientation axis direction of the laminated film to be measured was determined using a retardation measuring device (KOBRA-WPR) manufactured by Oji Scientific Instruments Co., Ltd. The in-plane phase difference measurement was performed using this retardation measuring device, and the direction coinciding with the obtained numerical value of the orientation angle was determined as the main orientation axis direction. A cut sample of a section (section in the thickness direction) to be measured was prepared by an ultrathin section method using an ultramicrotome with respect to the main orientation axis direction. The dielectric constant of the prepared sectional cut sample was measured using an atomic resolution analytical electron microscope ARM200F manufactured by JEOL Ltd. Specifically, a high angle annular dark-field scanning transmission electron microscopy (HAADF-STEM) image was acquired at an acceleration voltage of 80 kV and a beam spot size of 0.2 mmφ, and then multipoint analysis (60 × 60 pixels, 20 nm/pixel) was performed on the layer to be measured at 50 msec, and thus data of energy loss and electron beam intensity were acquired. The same operation was performed at three points for each of the thermoplastic resins in the laminated film, and data with an improved S/N ratio were acquired. From the obtained spectrum, background correction caused by elastic scattering and removal of a multiple scattering effect were performed, and then a dielectric function of each layer was calculated by Kramers-Kronig conversion expressed by the formula (4). The integration range in the Kramers-Kronig conversion was set to 0 to 200eV. On the basis of the dielectric function of the formula (4), the real part and the imaginary part of the dielectric constant were calculated from the formulas (5) and (6), respectively, and then the dielectric constant was calculated from the formula (7) of the square root of the sum of squares of these. The dielectric constants at a loss energy of 2.5 eV of the respective thermoplastic resin layers were calculated by the above method, and then the dielectric constant ratio was determined from the ratio of the largest dielectric constant to the smallest dielectric constant.

In the formulas (4) to (7), Re denotes a real part, Im denotes an imaginary part, $\varepsilon$ denotes a dielectric constant (average value), $\varepsilon(\omega)$ denotes a dielectric function, $\varepsilon_1$ denotes a dielectric constant real part, $\varepsilon_2$ denotes an imaginary part of a dielectric constant, and $\omega$ and $\omega'$ denote angular frequencies.

[Mathematical formula 4]

$$Re\left[\frac{1}{\varepsilon(\omega)}\right] = 1 - \frac{2}{\pi} P \int_0^\infty Im\left[\frac{1}{\varepsilon(\omega)}\right]\frac{\omega'}{\omega'^2 - \omega^2} d\omega' \qquad (4)$$

[Mathematical formula 5]

$$\varepsilon_1(\omega) = \frac{Re\left[\frac{1}{\varepsilon(\omega)}\right]}{Re\left[\frac{1}{\varepsilon(\omega)}\right]^2 + Im\left[\frac{1}{\varepsilon(\omega)}\right]^2} \qquad (5)$$

[Mathematical formula 6]

$$\varepsilon_2(\omega) = \frac{Im\left[\frac{1}{\varepsilon(\omega)}\right]}{Re\left[\frac{1}{\varepsilon(\omega)}\right]^2 + Im\left[\frac{1}{\varepsilon(\omega)}\right]^2} \qquad (6)$$

[Mathematical formula 7]

$$\varepsilon = \sqrt{(\varepsilon_1)^2 + (\varepsilon_2)^2} \qquad (7)$$

(9) Reflection Lightness L*(SCE)

A sample was cut out in a 4 cm square from the center in a width direction of the laminated film, and one side of the laminated film was subjected to a back surface blackening treatment using a black lacquer spray. In the back surface blackening treatment, overcoating was performed three times to block light. Using a spectrophotometer CM3600d manufactured by Konica Minolta Sensing, Inc., calibration was performed using the attached white calibration plate and zero calibration box, and then the lightness L* (SCE) of the reflected color tone of the sample subjected to the back surface blackening was measured. Specifically, an MVD attachment having a measurement diameter of 8 mm was attached, and the lightness L* (SCE) was read when the light source was a D65 light source and the light incident surface was a back surface un-blackened surface. The same measurement was performed at three points randomly selected in a 4 cm square laminated sample surface, and the average value was taken as the L*SCE (D65) of the laminated film measured.

(10) Flexural Rigidity

In accordance with JIS K 7161 (2014) and JIS K 7127 (1999), measurement was performed under the following conditions. A laminated film was cut into a rectangular shape of 10 mm × 200 mm with the longitudinal direction as a long side to be used as a sample. Subsequently, the sample was pulled at a room temperature of 23°C, a distance between chucks of 5 cm, and a pulling rate of 300 mm/min using a film-strength elongation automatic measuring instrument "TENSILON" (registered trademark) AMF/RTA-100 manufactured by Orientec Co., Ltd., and the Young's modulus in the longitudinal direction was measured. A sample having a long side in the width direction was also measured in the same manner, and the measurement was taken as the Young's modulus in the width direction. The above measurement was performed five times for each of the longitudinal direction and the width direction of each laminated film, and of the average values of the obtained measurements, the higher one was defined as the Young's modulus E of the laminated film. The flexural rigidity of the laminated film is represented by the product EI of the Young's modulus E and the secondary moment of inertia of area I. That is, the flexural rigidity EI of the laminated film is represented by the following formula (3), where b denotes the width of the measurement sample and d denotes the film thickness. A value calculated by applying the Young's modulus E measured by the above method to the following formula was defined as flexural rigidity.

[Mathematical formula 8]

$$E I = E \times b \times d^3 / 1 2 \qquad (3)$$

In the formula (3), b denotes a film width [m] of a measurement target, and d denotes a film thickness [m].

(11) Dynamic Viscoelasticity tan$\delta$ Measurement

On the basis of Tensile vibration-Non-resonance method of JIS K 7244-4 (1999) (this method is referred to as dynamic viscoelasticity method), a loss elastic modulus spectrum was acquired using the dynamic viscoelasticity measuring device "DMS6100" manufactured by Seiko Instruments Inc. The detailed measurement conditions were as follows.

Measurement mode "tension", distance between chucks "20 mm", width of test piece "10 mm", frequency "10 Hz", strain amplitude "10 $\mu$m", minimum tension "20 mN", force amplitude initial value "40 mN", measurement temperature " from 250°C to 180°C", and temperature raising rate "2 °C/min".

(12) Long-Term Reliability Test

A thermo-hygrostat (LHL-114) manufactured by ESPEC CORP. was used. A 10 cm square sample was cut out from an obtained laminated film, and the sample was left standing in the thermo-hygrostat with the sample sandwiched between two sheets of plain paper. After the standing treatment for 500 hours, the cross-cut peeling rate described in (6) and the haze value change ($\Delta$haze) described in (7) were evaluated, and determined as A to D as follows.

A: The change in peeling rate was 1% or less, and the $\Delta$haze was 0.1% or less.
B: The sample did not correspond to A, the change in peeling rate was 5% or less, and the $\Delta$haze was 0.5% or less.
C: The sample corresponded to neither A nor B, the change in peeling rate was 10% or less, and the $\Delta$haze was 1.0% or less.
D: The sample corresponded to none of A, B, and C.

(13) Electromagnetic Wave Permeability

A diluted ink was adjusted by mixing a solvent based ink "UPX" black (480) manufactured by MINO GROUP Co., Ltd. and a dilution solvent "UPX standard dilution solvent" manufactured by MINO GROUP Co., Ltd. at a ratio of 100 : 20 (mass ratio), and a print layer having a thickness of 4 $\mu$m was provided on the entire surface of one side of a laminated film with a screen printing machine using a 250 mesh screen plate. Subsequently, using a high-pressure molding machine, the printed laminated sheet was heated to 180°C and shaped such that the print layer side three-dimensionally formed a convex shape (100 mm $\times$ 100 mm) at a pressure of 100 bar, and then unnecessary portions were removed. Next, the laminate obtained by partially shaping and removing unnecessary portions was placed in a mold of an injection molding machine, a molten polycarbonate resin (301-22 manufactured by Sumika Polycarbonate Ltd) was injected onto a surface opposite from the print layer, and welded and integrated, affording a molded article (corresponding to an in-vehicle member; hereinafter, simply referred to as molded article). The thickness of the polycarbonate resin layer at this time was set to about 1 mm. On the back side of the molded article was placed a 76 GHz MIMO radar module T18PE_01120112_2R5D_76G manufactured by S-Takaya Electronics Industry Co., Ltd., and the relative intensity [dB] of the electromagnetic wave allowed to pass through the molded body, reflected from the wall surface linearly separated by 3 m, and bounced back was measured. The determination was made as follows on the basis of the measurement results with and without the molded article. Of the evaluation results, A is the best.

A: The electromagnetic wave relative intensity was less than 10 dB.
B: The change amount of the electromagnetic wave relative intensity was 10 dB or more.

(14) Near-Infrared Radar Permeability

A molded body was prepared by the same method as the method for producing a molded article described in the section (13) except that no print layer of the laminated film was provided. Using a spectrophotometer U-4100 manufactured by Hitachi High-Tech Science Corporation, an attached relative transmission unit was attached to the obtained molded body and an aluminum oxide plate was fixed as a reflection member to the opening on the back side of the integrating sphere. The molded article was fixed in close contact with the front side of the integrating sphere, and the average transmittance at a wavelength of 900 nm to 1600 nm was measured to simulate and verify the radar permeability of the molded body as follows. Among the evaluation results, A is the best, and C was treated as a characteristic that is difficult to apply to a radar cover of LiDAR.

A: The average transmittance was 80% or more.
B: The average transmittance was 30% or more and less than 80%.
C: The average transmittance was less than 30%.

(15) Measurement of Light Permeability of Molded Article

Using a spectrophotometer U-4100 manufactured by Hitachi High-Tech Science Corporation, the average transmittance at a wavelength of 400 nm to 800 nm was measured for the planar portion of the convex portion of the molded article prepared in the section (13), and the light permeability of the molded article at the place where the laminated film was molded was evaluated.

(16) Thickness of Each Layer Constituting Molded Article

The thicknesses of the layers constituting the molded article prepared in the section (13) and the laminated film were measured by observing, with a digital microscope VHX-5000 manufactured by KEYENCE CORPORATION, the laminated state of a section produced by cutting the molded article in parallel with the thickness direction of the laminated film (the direction perpendicular to the film plane). A high magnification lens capable of observation at a maximum magnification of 5000 times was attached, and observation was performed at an observation magnification of 1000 times when the layer thickness was 10 $\mu$m or more, and at an observation magnification of 5000 times when the layer thickness was less than 10 $\mu$m.

(17) Thickness Ratio of Thickest Portion to Thinnest Portion of Laminated Film in Molded Article (Index of Molding Followability)

In the molded article prepared in the section (13), the thickness ratio of the thickest portion to the thinnest portion of the laminated film was measured and calculated by the following procedure. First, the inside of the molded article was cut in parallel with the thickness direction of the laminated film (direction perpendicular to the film plane) at ten arbitrary points, and then the thickness of the laminated film at each point was measured by observing the laminated state using a digital microscope VHX-5000 manufactured by KEYENCE CORPORATION. The value obtained by dividing the maximum value of the obtained values by the minimum value was defined as the thickness ratio of the thickest portion to the thinnest portion of the laminated film in the molded article. The observation magnification with the digital microscope was set as described in the section (16). In addition, when the ten arbitrary points for the section observation were selected, in order to correctly grasp the thickness ratio, at least three points were selected from a portion with strong elongation such as an end portion of the molded article, and at least three points were selected from a portion with weak elongation where flatness was maintained.

(18) Measurement of Front Brightness of Display

As a display for evaluation, a light source unit KD-65X9500B manufactured by Sony Corporation was used. A laminated film was placed immediately below the backlight attached to the light source unit, and the display was assembled again, affording a display for evaluation. Brightness was evaluated at five points in total, namely, a center (reference sign 19) of the light source unit (reference sign 18); a point located on a straight line passing through the center of the light source unit and parallel to a long side of the light source unit, and located at the middle between an edge and the center of the light source unit (two points, reference sign 20); and a point located on a straight line passing through the center of the light source unit and parallel to a short side of the light source unit, and located at the middle between an edge and the center of the light source unit (two points, reference sign 21) using a luminance colorimeter BM-7 manufactured by TOPCON TECHNOHOUSE CORPORATION, and an average value was adopted as brightness data. Furthermore, a relative brightness value was calculated with the brightness before the laminated film was inserted taken as 100%, and the front brightness was evaluated according to the following criteria.

A: A relative brightness value of more than 110% was obtained.
B: A relative brightness value of more than 105% and 110% or less was obtained.
C: A relative brightness value of more than 102.5% and 105% or less was obtained.
D: A relative brightness value of 102.5% or less was obtained.

The thermoplastic resins, additives, and water-based coating agent X used in Examples of the present invention will be described below. The amount of a copolymerization component of the polyester resin described herein represents the copolymerization amount with respect to 100 mol% of the acid component and 100 mol% of the diol component.

<Thermoplastic Resin>

Resin 1: Crystalline homopolyethylene terephthalate resin (refractive index: 1.66) exhibiting a glass transition temperature of 78°C, a melting point of 254°C, and an enthalpy of fusion of 40 J/g
Resin 2: Crystalline polyethylene terephthalate resin (refractive index: 1.63) obtained by copolymerizing 10 mol% of isophthalic acid, exhibiting a glass transition temperature of 79°C, a melting point of 230°C, and an enthalpy of fusion of 12 J/g
Resin 3: Semi-crystalline polyethylene terephthalate resin (refractive index: 1.61) obtained by copolymerizing 15 mol% of isophthalic acid, exhibiting a glass transition temperature of 77°C, a melting point of 217°C, and an enthalpy of fusion of 2 J/g
Resin 4: Crystalline polyethylene naphthalate resin (refractive index: 1.73) obtained by copolymerizing 5 mol% of polyethylene glycol having a molecular weight of 400, exhibiting a glass transition temperature of 97°C, a melting point of 254°C, and an enthalpy of fusion of 33 J/g
Resin 5: Amorphous polyethylene terephthalate resin (refractive index: 1.57) obtained by copolymerizing 33 mol% of cyclohexanedimethanol, exhibiting a glass transition temperature of 80°C
Resin 6: Amorphous polyethylene terephthalate resin (refractive index: 1.55) obtained by copolymerizing 20 mol% of spiroglycol, exhibiting a glass transition temperature of 77°C
Resin 7: Crystalline acid-modified ethylene-propylene copolymer resin (refractive index: 1.53) exhibiting a melting point of 133°C
Resin 8: Amorphous homo-polymethylene methacrylate resin (refractive index: 1.49) exhibiting a glass transition temperature of 101°C
Resin 9: Crystalline polymethaxylenediamine adipamide resin (refractive index: 1.52) exhibiting a glass transition temperature of 86°C and a melting point of 237°C
Resin 10: Amorphous thermoplastic resin (refractive index: 1.61) obtained by alloy-kneading the resin 4 and the resin 8 at a volume concentration ratio of 50 : 50 and exhibiting a glass transition temperature of 99°C
Resin 11: Crystalline polyethylene terephthalate resin (refractive index: 1.63) obtained by copolymerizing 8 mol% of dimethyl 5-sulfoisophthalate, exhibiting a glass transition temperature of 78°C and a melting point of 253°C.

The refractive index as referred to here is an in-plane refractive index measured by the following procedure. First, for a thermoplastic resin exhibiting a melting point, a 25 $\mu$m-thick biaxially stretched monolayer film prepared by the production method described in Example 1 using this thermoplastic resin was obtained (note that in the production of the biaxially stretched monolayer film, the stretching temperature was set to the glass transition temperature of each thermoplastic resin + 10°C (80°C for the resin 7 exhibiting no glass transition temperature), and the thickness was adjusted by the take-up speed of the cast drum). Thereafter, the obtained biaxially stretched monolayer film was subjected to in-plane retardation measurement using a retardation measuring device (KOBRA-WPR) manufactured by Oji Scientific Instruments Co., Ltd., and a direction coinciding with the obtained numerical value of the orientation angle was defined as the main orientation axis direction. Subsequently, for each of the main orientation axis direction and the direction orthogonal to the main orientation axis in the film plane, the refractive index exhibited when a laser having a wavelength of 632.8 nm was applied was read using a prism coupler SPA-4000 manufactured by Sairon Technology, Inc., the average value thereof was adopted as the refractive index of each thermoplastic resin, and this was regarded as the refractive index of each thermoplastic resin layer. For an amorphous resin, the same measurement as described above was performed on a cast sheet prepared by the production method described in Example 1, and the average value obtained was taken as the refractive index of each thermoplastic resin (each thermoplastic resin layer).

<Additive>

Acrylic polymer exhibiting an epoxy value of 1.4 meq/g with an average molecular weight of 2900 g/mol.

<Water-Based Coating Agent X>

Silica colloidal particles having a particle size of 100 nm were added to a material obtained by mixing the following polyester resin 1 (100 parts by mass), reactive compound 1 (30 parts by mass), and reactive compound 2 (30 parts by mass) in an amount of 0.5 parts by mass with respect to 100 parts by mass of a binder resin corresponding to a mixture of the resin and the compounds, the solid concentration was adjusted with water as a solvent so as to be 5 parts by mass, and then 0.03 parts by mass of a surfactant was added with respect to 100 parts by mass of the total of water and mixed, affording a coating composition.

Polyester Resin 1:

An aqueous dispersion of a polyester resin formed of the following copolymerization composition was obtained by the following procedure. The following copolymerization component and 0.1 parts of potassium titanium oxalate as a catalyst were added to a reactor, and a temperature was raised to 200°C while being stirred and mixed at normal pressure in a nitrogen atmosphere. Subsequently, the reaction temperature was gradually raised to 250°C over 4 hours to complete the transesterification reaction. The polyester resin in an amount of 15 parts by mass and 85 parts by mass of water were added to a dissolution tank and dispersed at a temperature of 80 to 95°C over 2 hours under stirring to obtain a 15% aqueous dispersion of the polyester resin.

(Copolymerization Composition)

· Dicarboxylic Acid Component

Dimethyl 2,6-naphthalenedicarboxylate: 88 mol%
Dimethyl sodium 5-sulfoisophthalate: 12 mol%

· Diol Component

Compound obtained by adding 2 mol of ethylene oxide to 1 mol of bisphenol S: 86 mol%
1,3-Propanediol: 14 mol%

Reactive Compound 1:
Carbodiimide water-based crosslinking agent ("CARBODILITE" (registered trademark) V-04 manufactured by Nisshinbo Chemical Inc.)
Reactive Compound 2:
Oxazoline-containing polymer aqueous dispersion ("EPOCROS" (registered trademark) WS-500 manufactured by NIPPON SHOKUBAI CO., LTD.).

(Example 1)

As the respective thermoplastic resins constituting the thermoplastic resin layers A, B, and C, the resins 1, 2, and 5 were used, respectively. The respective thermoplastic resins prepared were separately charged into three twin screw extruders in a pellet form, and melted and kneaded at 270°C, 270°C, and 280°C, respectively. The kneading conditions were all set such that the screw rotation speed with respect to the discharge amount was 0.7. Subsequently, the thermoplastic resins were filtered separately through seven FSS type leaf disc filters, and while being metered by gear pumps, joined together in a feed block with 601 slits whose temperature was adjusted to 270°C. Thus, a 601-layered laminate was formed in such configuration that the thickness ratio of A/B was 0.98, the thickness ratio C/B was 1.02, layers were laminated with ordered arrays of layer A/layer B/layer C/layer B in the thickness direction, and both surface layers were the layer A. Here, the slit length and the slit width in the feed block were designed such that the layer thickness monotonously increased from the outermost surface on one side toward the outermost surface on the opposite side except for both outermost layers. Thereafter, the laminate passed through the feed block was supplied to a T-die and formed into a sheet, and then rapidly cooled and solidified on a casting drum having a surface temperature maintained at 25°C while an electrostatic application voltage of 8 kV was applied with a wire to obtain an unstretched laminated cast sheet. The obtained laminated cast sheet was heated with a group of rolls set at 70 to 80°C, and then stretched 3.3 times in the longitudinal direction while being rapidly heated from both surfaces of the film by a radiation heater within a stretching section length of 100 mm, and then once cooled. Subsequently, both surfaces of the obtained laminated uniaxially stretched film were subjected to corona discharge treatment in air, the wet tension of the base film was set to 55 mN/m, and then the treated surfaces of both surfaces of the film were coated with a water-based coating agent X to be an easily slipping layer (hereinafter, performing coating means the above procedure) with a #4 metabar to form a transparent, easily slipping and easily adhesive layer. Further, the uniaxially laminated film was guided to a tenter, preheated with hot air at 85°C, and then stretched 3.6 times in the film width direction at a temperature of 90°C. The biaxially stretched film was heat-fixed with hot air at 200°C immediately after lateral stretching, subjected to a 5% relaxation treatment in the width direction immediately before the outlet of the tenter, and then wound up. Further, using the obtained laminated film, a molded article was prepared by the method described in the section (13) of "Method for Measuring Properties and Method for Evaluating Effects". The evaluation results of the obtained laminated film and molded body are shown in Table 1-2.

(Examples 2 to 16, 19 to 25, 27, 28, 31 and 32, and Comparative Examples 1, 2 and 4)

Laminated films and molded bodies were obtained in the same manner as in Example 1 except that the resins of the respective layers, the additives, the number of layers to be laminated of a feed block, the extruder discharge amount (thickness ratio in an ordered array), the film formation conditions, and the film thickness were varied as described in Tables 1-1, 2-1, and 3-1. The evaluation results of the obtained laminated films and molded bodies are shown in Tables 1-2, 2-2, and 3-2. The thickness of a laminated film was adjusted by the take-up speed of a cast drum.

(Examples 17 and 18)

A laminated film was obtained in the same manner as in Example 16 except that an epoxy end modifier for improving adhesion was compounded in advance in a thermoplastic resin described in Table 2-1 at a prescribed addition concentration, and the obtained product was used as a thermoplastic resin constituting a thermoplastic resin layer. The evaluation results of the obtained laminated films are shown in Table 2-2.

(Example 26)

A laminated film was obtained in the same manner as the production method described in Example 20 except, in Example 20, using a 601-layers laminating device in which two slit plates having 301 slits as a feed block were provided and the slit length and the slit width in the feed block were designed such that the layer thickness monotonously increased from the outermost surface on one side toward the middle layer (301th layer) except for both the outermost layers and the middle layer (301th layer), and the layer thickness monotonously decreased from the middle layer toward the opposite outermost layer. It was confirmed by transmission electron microscope observation that both the surface layers and the middle layer exhibited thick film layers of 5 $\mu$m. The evaluation results of the obtained laminated film are shown in Table 3-2.

(Examples 29 and 30)

As the respective thermoplastic resins constituting the thermoplastic resin layers A, B, and C in Example 1, the resins described in Table 3-1 were used. Furthermore, as a laminating device, a feed block including three slit plates having the number of slits described in Table 3-1 was used, the feed block being designed with a lamination having an ordered array of layer A/layer B/layer C in the thickness direction and with a layer thickness distribution in which the layer thickness monotonously increased from the outermost layer on one side toward the outermost layer on the opposite side. Laminated films were obtained in the same manner as in Example 1 except that the extruder discharge amount (the thickness ratio in an ordered array) and the film formation conditions (stretch ratio, stretching temperature, heat treatment conditions) were changed as shown in Table 3-1. The evaluation results of the obtained laminated film are shown in Table 3-2.

(Comparative Example 3)

As the respective thermoplastic resins constituting the thermoplastic resin layer A and the thermoplastic resin layer B, the resin 4 and the resin 8 were sequentially used. In addition, the resins were joined with a feed block with 301 slits adjusted to a temperature of 270°C, thereby forming a 301-layers laminate in which the thickness ratio A/B was 0.86, the layers were laminated in an alternately ordered array in the thickness direction, and both surface layers were the layer A. Here, the slit length and the slit width in the feed block were designed such that the layer thickness monotonously increased from the outermost surface on one side toward the outermost surface on the opposite side except for both outermost layers. A laminated film was obtained in the same manner as in Example 1 except that the other film formation conditions was changed as described in Table 1-1. The evaluation results of the obtained laminated film are shown in Table 1-2.

(Example 33 and Comparative Example 5)

An optical tacky film TD06-A25 manufactured by TOMOEGAWA CO., LTD. was bonded to the laminated films described in Example 21 and the laminated film described in Comparative Example 4, affording laminated films with a tacky layer. Each of the laminated film with a tacky layer was bonded without wrinkles to the inner surface of a light cover of a stand light B096K1YZB9 manufactured by GOLWIS, and thus a lighting device for evaluation was produced. As a light source, an LED light LDA3N-G-3T3 having a color temperature of 5000 K (daytime white) manufactured by IRIS OHYAMA Inc. was used. The illuminance of the light before and after bonding the laminated films was measured at a position 1 m away from the light with an illuminance spectrophotometer CL-500A manufactured by KONICA MINOLTA, INC., and the illuminance was read. As compared with the case of using the laminated film of Comparative Example 4 (Comparative Example 5), the illuminance was improved by 10% by using the laminated film of Example 21 (Example 31), and the illuminance improvement effect due to the increase in reflectance could be confirmed.

[Table 1-1-1]

| | | | | Example 1 | Example 2 | Example 3 | Example 4 | Example 5 |
|---|---|---|---|---|---|---|---|---|
| Laminated film | Resin | Layer A, layer a, layer $\alpha$ | - | Resin 1 | Resin 1 | Resin 4 | Resin 4 | Resin 4 |
| | | Layer B, layer b, layer $\beta$ | - | Resin 2 | Resin 2 | Resin 2 | Resin 2 | Resin 2 |
| | | Layer C, layer c, layer $\gamma$ | - | Resin 5 | Resin 5 | Resin 5 | Resin 6 | Resin 6 |
| | | Dielectric constant ratio | - | 1.13 | 1.13 | 1.24 | 1.27 | 1.27 |
| | | In descending order of dielectric constants of layers A, B, and C | - | A > B > C | A > B > C | A > B > C | A > B > C | A > B > C |
| | Additive | Additive layer | Layer | - | - | - | - | - |
| | | Addition concentration | mass% | - | - | - | - | - |
| | Film configuration | Number of laminated layers | Layer | 601 | 301 | 301 | 301 | 301 |
| | | Repeating unit | - | ABCB | ABCB | ABCB | ABCB | ABCB |
| | | Ordered array | Number | 150 | 75 | 75 | 75 | 75 |
| | | Film thickness t | $\mu$m | 36 | 26 | 26 | 26 | 26 |
| | | Layer thickness distribution | - | Monotonic increase | Monotonic increase | Monotonic increase | Monotonic increase | Monotonic increase |
| | | Thickness ratio A/B | - | 0.98 | 0.98 | 0.96 | 0.94 | 0.60 |
| | | Thickness ratio C/B | - | 1. 02 | 1. 02 | 1. 04 | 1. 06 | 1. 06 |
| | | Thickness ratio A/C | - | 0.96 | 0.96 | 0.92 | 0.89 | 0.57 |
| | | Ratio of ordered arrays exhibiting thickness ratio of 1.4 or more | % | 0 | 0 | 0 | 0 | 0 |
| | | Ratio of layer thickness of 1 nm to 25 nm | % | 16 | 14 | 14 | 14 | 5 |
| | | Maximum refractive index difference | - | 0.09 | 0.09 | 0.16 | 0.18 | 0.18 |
| | Difference in compatibility parameter (maximum) | | $(cal/cm^3)^{1/2}$ | 0.2 | 0.2 | 0.2 | 0.7 | 0.7 |

(continued)

| Film formation conditions | | | | Example 1 | Example 2 | Example 3 | Example 4 | Example 5 |
|---|---|---|---|---|---|---|---|---|
| | Extrusion temperature | Layer A | °C | 270 | 270 | 280 | 280 | 280 |
| | | Layer B | °C | 270 | 270 | 270 | 270 | 270 |
| | | Layer C | °C | 280 | 280 | 280 | 270 | 270 |
| | Stretching ratio (length/width) | | Times/times | 3.3/3.6 | 3.3/3.6 | 3.6/3.6 | 3.6/3.6 | 3.6/3.6 |
| | Longitudinal stretching temperature | | °C | 85 | 85 | 105 | 105 | 105 |
| | Lateral stretching temperature | | °C | 90 | 90 | 105 | 105 | 105 |
| | Heat treatment temperature | | °C | 200 | 200 | 200 | 200 | 200 |

[Table 1-1-2]

| | | | | Example 6 | Example 7 | Example 8 | Example 9 | Example 10 |
|---|---|---|---|---|---|---|---|---|
| Laminated film | Resin | Layer A, layer a, layer α | - | Resin 4 | Resin 4 | Resin 4 | Resin 4 | Resin 4 |
| | | Layer B, layer b, layer β | - | Resin 2 | Resin 2 | Resin 2 | Resin 2 | Resin 2 |
| | | Layer C, layer c, layer γ | - | Resin 6 | Resin 6 | Resin 6 | Resin 6 | Resin 6 |
| | | Dielectric constant ratio | - | 1.27 | 1.27 | 1.27 | 1.27 | 1.27 |
| | | In descending order of dielectric constants of layers A, B, and C | - | A > B > C | A > B > C | A > B > C | A > B > C | A > B > C |
| | Additive | Additive layer | Layer | - | - | - | - | - |
| | | Addition concentration | mass% | - | - | - | - | - |
| | Film configuration | Number of laminated layers | Layer | 301 | 301 | 301 | 301 | 301 |
| | | Repeating unit | - | ABCB | ABCB | ABCB | ABCB | ABCB |
| | | Ordered array | Number | 75 | 75 | 75 | 75 | 75 |
| | | Film thickness t | μm | 26 | 26 | 26 | 26 | 26 |
| | | Layer thickness distribution | - | Monotonic increase | Monotonic increase | Monotonic increase | Monotonic increase | Monotonic increase |
| | | Thickness ratio A/B | - | 0.93 | 1.30 | 1.50 | 2.00 | 3.00 |
| | | Thickness ratio C/B | - | 0.70 | 1.50 | 1.50 | 2.00 | 3.00 |
| | | Thickness ratio A/C | - | 1.33 | 0.87 | 1.00 | 1.00 | 1.00 |
| | | Ratio of ordered arrays exhibiting thickness ratio of 1.4 or more | % | 0 | 94 | 98 | 98 | 98 |
| | | Ratio of layer thickness of 1 nm to 25 nm | % | 4 | 29 | 35 | 50 | 50 |
| | | Maximum refractive index difference | - | 0.18 | 0.18 | 0.18 | 0.18 | 0.18 |
| | Difference in compatibility parameter (maximum) | | $(cal/cm^3)^{1/2}$ | 0.7 | 0.7 | 0.7 | 0.7 | 0.7 |

EP 4 501 629 A1

| | | | | Example 6 | Example 7 | Example 8 | Example 9 | Example 10 |
|---|---|---|---|---|---|---|---|---|
| Film formation conditions | Extrusion temperature | Layer A | °C | 280 | 280 | 280 | 280 | 280 |
| | | Layer B | °C | 270 | 270 | 270 | 270 | 270 |
| | | Layer C | °C | 270 | 270 | 270 | 270 | 270 |
| | Stretching ratio (length/width) | | Times/times | 3.6/3.6 | 3.6/3.6 | 3.6/3.6 | 3.6/3.6 | 3.6/3.6 |
| | Longitudinal stretching temperature | | °C | 105 | 105 | 105 | 105 | 105 |
| | Lateral stretching temperature | | °C | 105 | 105 | 105 | 105 | 105 |
| | Heat treatment temperature | | °C | 200 | 200 | 200 | 200 | 200 |

[Table 1-1-3]

| | | | | Comparative Example 1 | Comparative Example 2 | Comparative Example 3 | Comparative Example 4 |
|---|---|---|---|---|---|---|---|
| Laminated film | Resin | Layer A, layer a, layer $\alpha$ | - | Resin 1 | Resin 1 | Resin 4 | Resin 4 |
| | | Layer B, layer b, layer $\beta$ | - | Resin 2 | Resin 2 | Resin 8 | Resin 2 |
| | | Layer C, layer c, layer $\gamma$ | - | Resin 5 | Resin 5 | - | Resin 6 |
| | | Dielectric constant ratio | - | 1.13 | 1.13 | 1.35 | 1.27 |
| | | In descending order of dielectric constants of layers A, B, and C | - | A > B > C | A > B > C | A > B | A > B > C |
| | Additive | Additive layer | Layer | - | - | - | - |
| | | Addition concentration | mass% | - | - | - | - |
| | Film configuration | Number of laminated layers | Layer | 301 | 301 | 301 | 301 |
| | | Repeating unit | - | ABCB | ABCB | AB | ABCB |
| | | Ordered array | Number | 75 | 75 | 150 | 75 |
| | | Film thickness t | $\mu$m | 26 | 26 | 80 | 26 |
| | | Layer thickness distribution | - | Monotonic increase | Monotonic increase | Monotonic increase | Monotonic increase |
| | | Thickness ratio A/B | - | 0.98 | 0.98 | - | 0.50 |
| | | Thickness ratio C/B | - | 1.02 | 1.02 | - | 0.60 |
| | | Thickness ratio A/C | - | 0.96 | 0.96 | 0.86 | 0.83 |
| | | Ratio of ordered arrays exhibiting thickness ratio of 1.4 or more | % | 0 | 0 | 0 | 0 |
| | | Ratio of layer thickness of 1 nm to 25 nm | % | 14 | 14 | 0 | 0 |
| | | Maximum refractive index difference | - | 0.09 | 0.09 | 0.24 | 0.18 |
| | Difference in compatibility parameter (maximum) | | $(cal/cm^3)^{1/2}$ | 0.2 | 0.2 | 1.8 | 0.7 |

(continued)

| Film forma-tion condi-tions | Extrusion temperature | Layer A | °C | Comparative Example 1 | Comparative Example 2 | Comparative Example 3 | Comparative Example 4 |
|---|---|---|---|---|---|---|---|
| | | | | 270 | 270 | 280 | 280 |
| | | Layer B | °C | 270 | 270 | 270 | 270 |
| | | Layer C | °C | 280 | 280 | - | 270 |
| | Stretching ratio (length/width) | | Times/times | 3.3/3.5 | 3.3/3.5 | 3.6/3.6 | 3.6/3.6 |
| | Longitudinal stretching temperature | | °C | 85 | 85 | 110 | 105 |
| | Lateral stretching temperature | | °C | 90 | 90 | 115 | 105 |
| | Heat treatment temperature | | °C | 200 | 200 | 200 | 200 |

[Table 1-2-1]

| | | | | Example 1 | Example 2 | Example 3 | Example 4 | Example 5 |
|---|---|---|---|---|---|---|---|---|
| Evaluation results | Spectroscopic characteristics | Maximum reflectance at wavelength of 400 to 800 nm | % | 46 | 35 | 71 | 82 | 78 |
| | | Average reflectance at wavelength of 400 to 800 nm | % | 28 | 17 | 56 | 69 | 64 |
| | | Band Π · Reflection wavelength band | nm | 400 to 800 | 400 to 700 | 400 to 800 | 400 to 800 | 400 to 800 |
| | | Band Π · Wavelength bandwidth λ | nm | 400 | 300 | 400 | 400 | 400 |
| | | Band Π · Average reflectance R | % | 28 | 17 | 56 | 69 | 64 |
| | | Presence or absence of reflection band continuously exhibiting reflectance of 75% or more over 100 nm or more | - | × | × | × | × | × |
| | | Band Π · Reflectance change σ/R | % | 22.5 | 25.0 | 12.3 | 8.4 | 9.8 |
| | | (λ·R)/t | % | 311 | 196 | 862 | 1062 | 985 |
| | | Presence or absence of band exhibiting reflectance of 20% or more over range of 100 nm or more | - | ○ | ○ | ○ | ○ | ○ |
| | | Whether the reflectance of 80% or more is exhibited over the entire region of wavelength of 400 to 800 nm | - | × | × | × | × | × |
| | Adhesion | Crosscut peeling rate | % | 0 | 0 | 0 | 0 | 0 |
| | | Peeling rate after long-term reliability test | % | A | A | A | A | A |

(continued)

|  |  |  | | Example 1 | Example 2 | Example 3 | Example 4 | Example 5 |
|---|---|---|---|---|---|---|---|---|
| | Physical properties | Reflection lightness L* (SCE) | % | 12 | 12 | 13 | 13 | 13 |
| | | Flexural rigidity | N·m² | 1.3E-07 | 4.8E-08 | 5.5E-08 | 5.4E-08 | 5.4E-08 |
| | | Dynamic viscoelasticity measurement $T_H$-$T_L$ | °C | 56 | 56 | 67 | 73 | 73 |
| | Evaluation of molded article | Light permeability @ place of laminated film attachment | % | 58 | 66 | 35 | 22 | 24 |
| | | Thickness ratio of thickest portion to thinnest portion of laminated film | - | 1.2 | 1.2 | 1.2 | 1.2 | 1.2 |
| | | Electromagnetic wave permeability | - | A | A | A | A | A |
| | | Radar permeability | - | A | A | A | A | A |
| | Evaluation of screen display device | Brightness measurement | - | D | D | D | D | D |

[Table 1-2-2]

|  |  | | | Example 6 | Example 7 | Example 8 | Example 9 | Example 10 |
|---|---|---|---|---|---|---|---|---|
| | | Maximum reflectance at wavelength of 400 to 800 nm | % | 79 | 83 | 85 | 88 | 88 |
| | | Average reflectance at wavelength of 400 to 800 nm | % | 66 | 73 | 75 | 76 | 77 |
| | | Band Π · Reflection wavelength band | nm | 400 to 800 | 400 to 800 | 400 to 800 | 400 to 800 | 400 to 800 |
| | | Band Π · Wavelength bandwidth λ | nm | 400 | 400 | 400 | 400 | 400 |
| | | Band Π · Average reflectance R | % | 66 | 73 | 75 | 76 | 77 |

(continued)

| | | | | Example 6 | Example 7 | Example 8 | Example 9 | Example 10 |
|---|---|---|---|---|---|---|---|---|
| Evaluation results | Spectroscopic characteristics | Presence or absence of reflection band continuously exhibiting reflectance of 75% or more over 100 nm or more | - | × | ○ | ○ | ○ | ○ |
| | | Band Π · Reflectance change $\sigma$/R | % | 10.1 | 7.4 | 7.2 | 6.9 | 6.7 |
| | | ($\lambda$·R)/t | % | 1015 | 1123 | 1154 | 1169 | 1185 |
| | | Presence or absence of band exhibiting reflectance of 20% or more over range of 100 nm or more | - | ○ | ○ | ○ | ○ | ○ |
| | | Whether the reflectance of 80% or more is exhibited over the entire region of wavelength of 400 to 800 nm | - | × | × | × | × | × |
| | Adhesion | Crosscut peeling rate | % | 0 | 0 | 0 | 0 | 0 |
| | | Peeling rate after long-term reliability test | % | A | A | A | A | A |
| | Physical properties | Reflection lightness L* (SCE) | % | 13 | 13 | 13 | 13 | 13 |
| | | Flexural rigidity | N·m$^2$ | 5.4E-08 | 5.4E-08 | 5.4E-08 | 5. 4E-08 | 5. 4E-08 |
| | | Dynamic viscoelasticity measurement $T_H$-$T_L$ | °C | 73 | 73 | 73 | 71 | 70 |
| | Evaluation of molded article | Light permeability @ place of laminated film attachment | % | 21 | 20 | 16 | 16 | 15 |
| | | Thickness ratio of thickest portion to thinnest portion of laminated film | - | 1.2 | 1.2 | 1.2 | 1.2 | 1.2 |
| | | Electromagnetic wave permeability | - | A | A | A | A | A |
| | | Radar permeability | - | A | A | A | A | A |

(continued)

|  |  |  |  | Example 6 | Example 7 | Example 8 | Example 9 | Example 10 |
|---|---|---|---|---|---|---|---|---|
|  | Evaluation of screen display device | Brightness measurement | - | D | C | C | C | C |

[Table 1-2-3]

| | | | | Comparative Example 1 | Comparative Example 2 | Comparative Example 3 | Comparative Example 4 |
|---|---|---|---|---|---|---|---|
| Evaluation results | Spectroscopic characteristics | Maximum reflectance at wavelength of 400 to 800 nm | % | 34 | 34 | 100 | 69 |
| | | Average reflectance at wavelength of 400 to 800 nm | % | 24 | 23 | 99 | 55 |
| | | Band Π · Reflection wavelength band | nm | 400 to 800 | 400 to 780 | 400 to 800 | 400 to 800 |
| | | Band Π · Wavelength bandwidth λ | nm | 400 | 380 | 400 | 400 |
| | | Band Π · Average reflectance R | % | 24 | 23 | 99 | 55 |
| | | Presence or absence of reflection band continuously exhibiting reflectance of 75% or more over 100 nm or more | - | × | × | ○ | × |
| | | Band Π · Reflectance change σ/R | % | 26.0 | 29.0 | 0.7 | 11.5 |
| | | (λ·R)/t | % | 369 | 336 | 495 | 846 |
| | | Presence or absence of band exhibiting reflectance of 20% or more over range of 100 nm or more | - | ○ | ○ | ○ | ○ |
| | | Whether the reflectance of 80% or more is exhibited over the entire region of wavelength of 400 to 800 nm | - | × | × | ○ | × |
| | Adhesion | Crosscut peeling rate | % | 0 | 0 | 84 | 0 |
| | | Peeling rate after long-term reliability test | % | A | A | D | A |
| | Physical properties | Reflection lightness L* (SCE) | % | 12 | 12 | 32 | 13 |
| | | Flexural rigidity | N·m$^2$ | 4.8E-08 | 4.8E-08 | 1.8E-06 | 5.4E-08 |
| | | Dynamic viscoelasticity measurement $T_H$-$T_L$ | °C | 56 | 56 | 50 | 74 |
| | Evaluation of molded article | Light permeability @ place of laminated film attachment | % | 61 | 62 | 0 | 36 |
| | | Thickness ratio of thickest portion to thinnest portion of laminated film | - | 1.2 | 1.2 | 1.5 | 1.2 |
| | | Electromagnetic wave permeability | - | A | A | A | A |
| | | Radar permeability | - | A | A | A | A |
| | Evaluation of screen display device | Brightness measurement | - | D | D | A | D |

49

In the table, flexural rigidity is represented by exponential (E) expression. For example, 1.3E-07 in Example 1 represents $1.3 \times 10^{-7}$, and other Examples and Comparative Examples in Tables 1-2, 2-2, and 3-2 are similarly interpreted.

[Table 2-1-1]

| | | | | Example 11 | Example 12 | Example 13 | Example 14 | Example 15 |
|---|---|---|---|---|---|---|---|---|
| Laminated film | Resin | Layer A, layer a, layer α | - | Resin 4 | Resin 4 | Resin 4 | Resin 4 | Resin 4 |
| | | Layer B, layer b, layer β | - | Resin 2 | Resin 2 | Resin 3 | Resin 3 | Resin 3 |
| | | Layer C, layer c, layer γ | - | Resin 6 | Resin 6 | Resin 8 | Resin 8 | Resin 8 |
| | | Dielectric constant ratio | - | 1.27 | 1.27 | 1.35 | 1.35 | 1.35 |
| | | In descending order of dielectric constants of layers A, B, and C | - | A > B > C | A > B > C | A > B > C | A > B > C | A > B > C |
| | Additive | Additive layer | Layer | - | - | - | - | - |
| | | Addition concentration | mass% | - | - | - | - | - |
| | Film configuration | Number of laminated layers | Layer | 301 | 601 | 301 | 49 | 101 |
| | | Repeating unit | - | ABCB | ABCB | ABCB | ABCB | ABCB |
| | | Ordered array | Number | 75 | 150 | 75 | 12 | 25 |
| | | Film thickness t | μm | 26 | 36 | 26 | 10 | 15 |
| | | Layer thickness distribution | - | Monotonic increase | Monotonic increase | Monotonic increase | Monotonic increase | Monotonic increase |
| | | Thickness ratio A/B | - | 5.00 | 0.94 | 0.93 | 0.93 | 0.93 |
| | | Thickness ratio C/B | - | 5.00 | 1.06 | 1.08 | 1.08 | 1.08 |
| | | Thickness ratio A/C | - | 1.00 | 0.89 | 0.86 | 0.86 | 0.86 |
| | | Ratio of ordered arrays exhibiting thickness ratio of 1.4 or more | % | 98 | 0 | 0 | 0 | 0 |
| | | Ratio of layer thickness of 1 nm to 25 nm | % | 50 | 14 | 14 | 0 | 0 |
| | | Maximum refractive index difference | - | 0.18 | 0.18 | 0.24 | 0.24 | 0.24 |
| | Difference in compatibility parameter (maximum) | | $(cal/cm^3)^{1/2}$ | 0.7 | 0.7 | 0.7 | 1.3 | 1.3 |

(continued)

| Film forma-tion condi-tions | | | | Example 11 | Example 12 | Example 13 | Example 14 | Example 15 |
|---|---|---|---|---|---|---|---|---|
| | Extrusion temperature | Layer A | °C | 280 | 280 | 280 | 280 | 280 |
| | | Layer B | °C | 270 | 270 | 270 | 270 | 270 |
| | | Layer C | °C | 270 | 270 | 270 | 270 | 270 |
| | Stretching ratio (length/width) | | Times/times | 3.6/3.6 | 3.6/3.6 | 3.6/3.6 | 3.6/3.6 | 3.6/3.6 |
| | Longitudinal stretching temperature | | °C | 105 | 105 | 110 | 110 | 110 |
| | Lateral stretching temperature | | °C | 105 | 105 | 115 | 115 | 115 |
| | Heat treatment temperature | | °C | 200 | 200 | 200 | 200 | 200 |

[Table 2-1-2]

| | | | | Example 16 | Example 17 | Example 18 | Example 19 | Example 20 |
|---|---|---|---|---|---|---|---|---|
| Laminated film | Resin | Layer A, layer a, layer $\alpha$ | - | Resin 4 | Resin 4 | Resin 4 | Resin 4 | Resin 4 |
| | | Layer B, layer b, layer $\beta$ | - | Resin 3 | Resin 3 | Resin 3 | Resin 10 | Resin 3 |
| | | Layer C, layer c, layer $\gamma$ | - | Resin 8 | Resin 8 | Resin 8 | Resin 8 | Resin 8 |
| | | Dielectric constant ratio | - | 1.35 | 1.35 | 1.35 | 1.35 | 1.35 |
| | | In descending order of dielectric constants of layers A, B, and C | - | A > B > C | A > B > C | A > B > C | A > B > C | A > B > C |
| | Additive | Additive layer | Layer | - | Layer C | Layer B | - | - |
| | | Addition concentration | mass% | - | 5 | 5 | - | - |
| | Film configuration | Number of laminated layers | Layer | 601 | 601 | 601 | 601 | 601 |
| | | Repeating unit | - | ABCB | ABCB | ABCB | ABCB | ABCB |
| | | Ordered array | Number | 150 | 150 | 150 | 150 | 150 |
| | | Film thickness t | $\mu$m | 36 | 36 | 36 | 36 | 36 |
| | | Layer thickness distribution | - | Monotonic in-crease | Monotonic in-crease | Monotonic in-crease | Monotonic in-crease | Monotonic in-crease |
| | | Thickness ratio A/B | - | 0.93 | 0.93 | 0.93 | 0.93 | 0.93 |
| | | Thickness ratio C/B | - | 1.08 | 1.08 | 1.08 | 1.08 | 1.08 |
| | | Thickness ratio A/C | - | 0.86 | 0.86 | 0.86 | 0.86 | 0.86 |
| | | Ratio of ordered arrays exhibiting thickness ratio of 1.4 or more | % | 0 | 0 | 0 | 0 | 0 |
| | | Ratio of layer thickness of 1 nm to 25 nm | % | 15 | 15 | 15 | 15 | 15 |
| | | Maximum refractive index difference | - | 0.24 | 0.24 | 0.24 | 0.24 | 0.24 |
| | Difference in compatibility parameter (maximum) | | $(cal/cm^3)^{1/2}$ | 1.3 | 1.2 | 1.2 | 0.7 | 1.3 |

(continued)

| Film forma-tion condi-tions | Extrusion temperature | Layer A | °C | 280 | 280 | 280 | 280 | 280 |
| | | Layer B | °C | 270 | 270 | 270 | 270 | 270 |
| | | Layer C | °C | 270 | 270 | 270 | 270 | 270 |
| | Stretching ratio (length/width) | | Times/times | 3.6/3.6 | 3.6/3.6 | 3.6/3.6 | 3.6/3.6 | 3.6/3.6 |
| | Longitudinal stretching temperature | | °C | 110 | 110 | 110 | 110 | 110 |
| | Lateral stretching temperature | | °C | 115 | 115 | 115 | 115 | 115 |
| | Heat treatment temperature | | °C | 200 | 200 | 200 | 200 | 220 |

Column headers: Example 16 | Example 17 | Example 18 | Example 19 | Example 20

[Table 2-1-3]

| | | | | Example 21 | Example 22 | Example 23 | Example 24 |
|---|---|---|---|---|---|---|---|
| Laminated film | Resin | Layer A, layer a, layer α | - | Resin 4 | Resin 4 | Resin 4 | Resin 4 |
| | | Layer B, layer b, layer β | - | Resin 3 | Resin 3 | Resin 3 | Resin 3 |
| | | Layer C, layer c, layer γ | - | Resin 8 | Resin 8 | Resin 8 | Resin 8 |
| | | Dielectric constant ratio | - | 1.35 | 1.35 | 1.35 | 1.35 |
| | | In descending order of dielectric constants of layers A, B, and C | - | A > B > C | A > B > C | A > B > C | A > B > C |
| | Additive | Additive layer | Layer | - | - | - | - |
| | | Addition concentration | mass% | - | - | - | - |
| | Film configuration | Number of laminated layers | Layer | 601 | 601 | 601 | 601 |
| | | Repeating unit | - | ABCB | ABCB | ABCB | ABCB |
| | | Ordered array | Number | 150 | 150 | 150 | 150 |
| | | Film thickness t | μm | 36 | 36 | 36 | 36 |
| | | Layer thickness distribution | - | Monotonic increase | Monotonic increase | Monotonic increase | Monotonic increase |
| | | Thickness ratio A/B | - | 1.30 | 1.50 | 2.00 | 3.00 |
| | | Thickness ratio C/B | - | 1.50 | 1.50 | 2.00 | 3.00 |
| | | Thickness ratio A/C | - | 0.87 | 1.00 | 1.00 | 1.00 |
| | | Ratio of ordered arrays exhibiting thickness ratio of 1.4 or more | % | 55 | 94 | 98 | 98 |
| | | Ratio of layer thickness of 1 nm to 25 nm | % | 32 | 35 | 50 | 50 |
| | | Maximum refractive index difference | - | 0.24 | 0.24 | 0.24 | 0.24 |
| | Difference in compatibility parameter (maximum) | | $(cal/cm^3)^{1/2}$ | 1.3 | 1.3 | 1.3 | 1.3 |

(continued)

| | | | | Example 21 | Example 22 | Example 23 | Example 24 |
|---|---|---|---|---|---|---|---|
| Film formation conditions | Extrusion temperature | Layer A | °C | 280 | 280 | 280 | 280 |
| | | Layer B | °C | 270 | 270 | 270 | 270 |
| | | Layer C | °C | 270 | 270 | 270 | 270 |
| | Stretching ratio (length/width) | | Times/times | 3.6/3.6 | 3.6/3.7 | 3.6/3.8 | 3.6/3.6 |
| | Longitudinal stretching temperature | | °C | 110 | 110 | 110 | 110 |
| | Lateral stretching temperature | | °C | 115 | 115 | 115 | 115 |
| | Heat treatment temperature | | °C | 220 | 220 | 220 | 220 |

[Table 2-2-1]

| | | | | Example 11 | Example 12 | Example 13 | Example 14 | Example 15 |
|---|---|---|---|---|---|---|---|---|
| | Spectroscopic characteristics | Maximum reflectance at wavelength of 400 to 800 nm | % | 89 | 95 | 93 | 35 | 63 |
| | | Average reflectance at wavelength of 400 to 800 nm | % | 78 | 86 | 84 | 26 | 46 |
| | | Band Ⅱ · Reflection wavelength band | nm | 400 to 800 | 400 to 800 | 400 to 800 | - | 400 to 800 |
| | | Band Ⅱ · Wavelength bandwidth λ | nm | 400 | 400 | 400 | - | 400 |
| | | Band Ⅱ · Average reflectance R | % | 78 | 86 | 84 | - | 46 |
| | | Presence or absence of reflection band continuously exhibiting reflectance of 75% or more over 100 nm or more | - | ○ | ○ | ○ | × | × |
| | | Band Ⅱ · Reflectance change σ/R | % | 6.5 | 5.6 | 4.6 | - | 26.6 |
| | | (λ·R)/t | % | 1200 | 956 | 1292 | - | 1227 |
| | | Presence or absence of band exhibiting reflectance of 20% or more over range of 100 nm or more | - | ○ | ○ | ○ | × | ○ |

(continued)

|  |  |  |  | Example 11 | Example 12 | Example 13 | Example 14 | Example 15 |
|---|---|---|---|---|---|---|---|---|
| Evaluation results |  |  | Whether the reflectance of 80% or more is exhibited over the entire region of wavelength of 400 to 800 nm | - | × | × | × | × | × |
|  | Adhesion |  | Crosscut peeling rate | % | 0 | 0 | 14 | 16 | 17 |
|  |  |  | Peeling rate after long-term reliability test | % | A | A | C | C | C |
|  | Physical properties |  | Reflection lightness L* (SCE) | % | 13 | 13 | 28 | 28 | 28 |
|  |  |  | Flexural rigidity | N·m$^2$ | 5.4E-08 | 1.4E-07 | 5.9E-08 | 3.3E-09 | 1.1E-08 |
|  |  |  | Dynamic viscoelasticity measurement $T_H$-$T_L$ | °C | 69 | 73 | 77 | 78 | 78 |
|  | Evaluation of molded article |  | Light permeability @ place of laminated film attachment | % | 15 | 10 | 11 | - | 43 |
|  |  |  | Thickness ratio of thickest portion to thinnest portion of laminated film | - | 1.2 | 1.2 | 1.2 | 1.2 | 1.2 |
|  |  |  | Electromagnetic wave permeability | - | A | A | A | A | A |
|  |  |  | Radar permeability | - | A | A | A | A | A |
|  | Evaluation of screen display device |  | Brightness measurement | - | C | B | C | D | D |

[Table 2-2-2]

|  |  |  |  | Example 16 | Example 17 | Example 18 | Example 19 | Example 20 |
|---|---|---|---|---|---|---|---|---|
|  |  | Maximum reflectance at wavelength of 400 to 800 nm | % | 99 | 99 | 99 | 54 | 99 |
|  |  | Average reflectance at wavelength of 400 to 800 nm | % | 94 | 94 | 94 | 38 | 94 |

(continued)

| | | | | Example 16 | Example 17 | Example 18 | Example 19 | Example 20 |
|---|---|---|---|---|---|---|---|---|
| Evaluation results | Spectroscopic characteristics | Band Π · Reflection wavelength band | nm | 400 to 800 | 400 to 800 | 400 to 800 | 400 to 800 | 400 to 800 |
| | | Band Π · Wavelength bandwidth λ | nm | 400 | 400 | 400 | 400 | 400 |
| | | Band Π · Average reflectance R | % | 94 | 94 | 94 | 38 | 94 |
| | | Presence or absence of reflection band continuously exhibiting reflectance of 75% or more over 100 nm or more | - | ○ | ○ | ○ | × | ○ |
| | | Band Π · Reflectance change σ/R | % | 1.1 | 1.1 | 1.1 | 1.1 | 1.1 |
| | | (λ·R)/t | % | 1044 | 1044 | 1044 | 422 | 1044 |
| | | Presence or absence of band exhibiting reflectance of 20% or more over range of 100 nm or more | - | ○ | ○ | ○ | ○ | ○ |
| | | Whether the reflectance of 80% or more is exhibited over the entire region of wavelength of 400 to 800 nm | - | ○ | ○ | ○ | × | ○ |
| | Adhesion | Crosscut peeling rate | % | 19 | 2 | 0 | 0 | 1 |
| | | Peeling rate after long-term reliability test | % | C | B | B | B | A |
| | Physical properties | Reflection lightness L* (SCE) | % | 28 | 19 | 24 | 56 | 16 |
| | | Flexural rigidity | N·m$^2$ | 1. 6E-07 | 1. 6E-07 | 1. 6E-07 | 1. 6E-07 | 1. 6E-07 |
| | | Dynamic viscoelasticity measurement $T_H$-$T_L$ | °C | 78 | 78 | 78 | 59 | 78 |

(continued)

|  |  |  |  | Example 16 | Example 17 | Example 18 | Example 19 | Example 20 |
|---|---|---|---|---|---|---|---|---|
| Evaluation of molded article | | Light permeability @ place of laminated film attachment | % | 3 | 3 | 3 | 8 | 3 |
| | | Thickness ratio of thickest portion to thinnest portion of laminated film | - | 1.2 | 1.2 | 1.2 | 1.2 | 1.2 |
| | | Electromagnetic wave permeability | - | A | A | A | A | A |
| | | Radar permeability | - | A | A | A | A | A |
| Evaluation of screen display device | | Brightness measurement | - | B | B | B | D | B |

[Table 2-2-3]

|  |  |  |  | Example 21 | Example 22 | Example 23 | Example 24 |
|---|---|---|---|---|---|---|---|
| Spectroscopic characteristics | | Maximum reflectance at wavelength of 400 to 800 nm | % | 100 | 100 | 100 | 100 |
| | | Average reflectance at wavelength of 400 to 800 nm | % | 97 | 97 | 98 | 98 |
| | | Band $\Pi$ · Reflection wavelength band | nm | 400 to 800 | 400 to 800 | 400 to 800 | 400 to 800 |
| | | Band $\Pi$ · Wavelength bandwidth $\lambda$ | nm | 400 | 400 | 400 | 400 |
| | | Band $\Pi$ · Average reflectance R | % | 97 | 98 | 98 | 98 |
| | | Presence or absence of reflection band continuously exhibiting reflectance of 75% or more over 100 nm or more | - | ○ | ○ | ○ | ○ |
| | | Band $\Pi$ · Reflectance change $\sigma$/R | % | 0.9 | 0.8 | 0.8 | 0.8 |
| | | $(\lambda \cdot R)/t$ | % | 1078 | 1089 | 1089 | 1089 |

(continued)

| | | | | Example 21 | Example 22 | Example 23 | Example 24 |
|---|---|---|---|---|---|---|---|
| Evaluation results | | | Presence or absence of band exhibiting reflectance of 20% or more over range of 100 nm or more | - | ○ | ○ | ○ | ○ |
| | | | Whether the reflectance of 80% or more is exhibited over the entire region of wavelength of 400 to 800 nm | - | ○ | ○ | ○ | ○ |
| | Adhesion | | Crosscut peeling rate | % | 1 | 1 | 1 | 1 |
| | | | Peeling rate after long-term reliability test | % | A | A | A | A |
| | Physical properties | | Reflection lightness L* (SCE) | % | 15 | 15 | 14 | 13 |
| | | | Flexural rigidity | N·m$^2$ | 1. 6E-07 | 1. 6E-07 | 1. 6E-07 | 1. 6E-07 |
| | | | Dynamic viscoelasticity measurement $T_H$-$T_L$ | °C | 77 | 77 | 75 | 75 |
| | Evaluation of molded article | | Light permeability @ place of laminated film attachment | % | 1 | 1 | 1 | 1 |
| | | | Thickness ratio of thickest portion to thinnest portion of laminated film | - | 1.2 | 1.2 | 1.2 | 1.2 |
| | | | Electromagnetic wave permeability | - | A | A | A | A |
| | | | Radar permeability | - | A | A | A | A |
| | Evaluation of screen display device | | Brightness measurement | - | B | A | A | A |

[Table 3-1-1]

| | | | | Example 25 | Example 26 | Example 27 | Example 28 | Example 29 |
|---|---|---|---|---|---|---|---|---|
| Laminated film | Resin | Layer A, layer a, layer α | - | Resin 4 | Resin 4 | Resin 4 | Resin 4 | Resin 1 |
| | | Layer B, layer b, layer β | - | Resin 3 | Resin 3 | Resin 3 | Resin 11 | Resin 5 |
| | | Layer C, layer c, layer γ | - | Resin 8 | Resin 8 | Resin 7 | Resin 9 | Resin 6 |
| | | Dielectric constant ratio | - | 1.35 | 1.35 | 1.31 | 1.3 | 1.17 |
| | | In descending order of dielectric constants of layers A, B, and C | - | A > B > C | A > B > C | A > B > C | A > B > C | A > B > C |
| | Additive | Additive layer | Layer | - | - | - | - | - |
| | | Addition concentration | mass% | - | - | - | - | - |
| | Film configuration | Number of laminated layers | Layer | 601 | 601 | 601 | 601 | 799 |
| | | Repeating unit | - | ABCB | ABCB | ABCB | ABCB | ABC |
| | | Ordered array | Number | 150 | 150 | 150 | 150 | 266 |
| | | Film thickness t | μm | 36 | 41 | 36 | 36 | 77 |
| | | Layer thickness distribution | - | Monotonic increase | Increase/ decrease 2 stages | Monotonic increase | Monotonic increase | Monotonic increase |
| | | Thickness ratio A/B | - | 5.00 | 0.93 | 0.93 | 0.93 | 1.00 |
| | | Thickness ratio C/B | - | 5.00 | 1.08 | 1.08 | 1.08 | 0.70 |
| | | Thickness ratio A/C | - | 1.00 | 0.86 | 0.86 | 0.86 | 1.43 |
| | | Ratio of ordered arrays exhibiting thickness ratio of 1.4 or more | % | 98 | 0 | 0 | 0 | 0 |
| | | Ratio of layer thickness of 1 nm to 25 nm | % | 50 | 15 | 15 | 15 | 0 |
| | | Maximum refractive index difference | - | 0.24 | 0.24 | 0.20 | 0.21 | 0.11 |
| | Difference in compatibility parameter (maximum) | | $(cal/cm^3)^{1/2}$ | 1.3 | 1.3 | 2.1 | 1.4 | 0.3 |

| | | | | Example 25 | Example 26 | Example 27 | Example 28 | Example 29 |
|---|---|---|---|---|---|---|---|---|
| Film formation conditions | Extrusion temperature | Layer A | °C | 280 | 280 | 280 | 280 | 270 |
| | | Layer B | °C | 270 | 270 | 270 | 270 | 280 |
| | | Layer C | °C | 270 | 270 | 270 | 270 | 270 |
| | Stretching ratio (length/width) | | Times/times | 3.6/3.6 | 3.6/3.6 | 3.6/3.6 | 3.6/3.6 | 3.3/3.3 |
| | Longitudinal stretching temperature | | °C | 110 | 110 | 105 | 105 | 85 |
| | Lateral stretching temperature | | °C | 115 | 115 | 105 | 105 | 90 |
| | Heat treatment temperature | | °C | 220 | 220 | 220 | 220 | 200 |

[Table 3-1-2]

| | | | | Example 30 | Example 31 | Example 32 |
|---|---|---|---|---|---|---|
| Laminated film | Resin | Layer A, layer a, layer α | - | Resin 4 | Resin 4 | Resin 4 |
| | | Layer B, layer b, layer β | - | Resin 3 | Resin 3 | Resin 3 |
| | | Layer C, layer c, layer γ | - | Resin 8 | Resin 8 | Resin 8 |
| | | Dielectric constant ratio | - | 1.17 | 1.17 | 1.17 |
| | | In descending order of dielectric constants of layers A, B, and C | - | A > B > C | A > B > C | A > B > C |
| | Additive | Additive layer | Layer | - | - | - |
| | | Addition concentration | mass% | - | - | - |
| | Film configuration | Number of laminated layers | Layer | 700 | 701 | 601 |
| | | Repeating unit | - | ABC | ABCB | ABCB |
| | | Ordered array | Number | 233 | 175 | 150 |
| | | Film thickness t | μm | 72 | 47 | 50 |
| | | Layer thickness distribution | - | Monotonic increase | Monotonic increase | Monotonic increase |
| | | Thickness ratio A/B | - | 1.00 | 2.00 | 4.50 |
| | | Thickness ratio C/B | - | 0.80 | 2.00 | 1.00 |
| | | Thickness ratio A/C | - | 1.25 | 1.00 | 4.50 |
| | | Ratio of ordered arrays exhibiting thickness ratio of 1.4 or more | % | 0 | 94 | 0 |
| | | Ratio of layer thickness of 1 nm to 25 nm | % | 0 | 40 | 58 |
| | | Maximum refractive index difference | - | 0.24 | 0.24 | 0.24 |
| | Difference in compatibility parameter (maximum) | | $(cal/cm^3)^{1/2}$ | 1.3 | 1.3 | 1.3 |
| Film formation conditions | Extrusion temperature | Layer A | °C | 280 | 280 | 280 |
| | | Layer B | °C | 270 | 270 | 270 |
| | | Layer C | °C | 270 | 270 | 270 |
| | Stretching ratio (length/width) | | Times/times | 3.6/3.6 | 3.6/3.6 | 3.6/3.6 |
| | Longitudinal stretching temperature | | °C | 105 | 105 | 105 |
| | Lateral stretching temperature | | °C | 105 | 105 | 105 |
| | Heat treatment temperature | | °C | 220 | 220 | 220 |

[Table 3-2-1]

| | | | | Example 25 | Example 26 | Example 27 | Example 28 | Example 29 |
|---|---|---|---|---|---|---|---|---|
| Evaluation results | Spectroscopic characteristics | Maximum reflectance at wavelength of 400 to 800 nm | % | 100 | 97 | 99 | 99 | 69 |
| | | Average reflectance at wavelength of 400 to 800 nm | % | 99 | 90 | 93 | 92 | 64 |
| | | Band $\Pi$ · Reflection wavelength band | nm | 400 to 800 | 400 to 800 | 400 to 800 | 400 to 800 | 400 to 1200 |
| | | Band $\Pi$ · Wavelength bandwidth $\lambda$ | nm | 400 | 400 | 400 | 400 | 800 |
| | | Band $\Pi$ · Average reflectance R | % | 99 | 90 | 93 | 92 | 66 |
| | | Presence or absence of reflection band continuously exhibiting reflectance of 75% or more over 100 nm or more | - | ○ | ○ | ○ | ○ | × |
| | | Band $\Pi$ · Reflectance change $\sigma$/R | % | 0.5 | 5.4 | 1.3 | 1.4 | 2.1 |
| | | $(\lambda \cdot R)/t$ | % | 1100 | 878 | 1033 | 1022 | 686 |
| | | Presence or absence of band exhibiting reflectance of 20% or more over range of 100 nm or more | - | ○ | ○ | ○ | ○ | ○ |
| | | Whether the reflectance of 80% or more is exhibited over the entire region of wavelength of 400 to 800 nm | - | ○ | ○ | ○ | ○ | × |
| | Adhesion | Crosscut peeling rate | % | 1 | 3 | 10 | 9 | 0 |
| | | Peeling rate after long-term reliability test | % | A | A | C | C | A |

(continued)

| | | | | Example 25 | Example 26 | Example 27 | Example 28 | Example 29 |
|---|---|---|---|---|---|---|---|---|
| | Physical properties | Reflection lightness L* (SCE) | % | 13 | 18 | 23 | 19 | 12 |
| | | Flexural rigidity | N·m² | 1. 6E-07 | 2.3E-07 | 1. 5E-07 | 1.5E-07 | 1.3E-06 |
| | | Dynamic viscoelasticity measurement $T_H$-$T_L$ | °C | 74 | 78 | 120 | 91 | 51 |
| | Evaluation of molded article | Light permeability @ place of laminated film attachment | % | 0 | 6 | 4 | 5 | 27 |
| | | Thickness ratio of thickest portion to thinnest portion of laminated film | - | 1.2 | 1.2 | 1.3 | 1.3 | 1.1 |
| | | Electromagnetic wave permeability | - | A | A | A | A | A |
| | | Radar permeability | - | A | A | A | A | B |
| | Evaluation of screen display device | Brightness measurement | - | A | B | B | B | D |

[Table 3-2-2]

| | | | | Example 30 | Example 31 | Example 32 |
|---|---|---|---|---|---|---|
| Evaluation results | Spectroscopic characteristics | Maximum reflectance at wavelength of 400 to 800 nm | % | 98 | 100 | 92 |
| | | Average reflectance at wavelength of 400 to 800 nm | % | 92 | 96 | 85 |
| | | Band Ⅱ · Reflection wavelength band | nm | 400 to 1400 | 400 to 1080 | 400 to 1210 |
| | | Band Ⅱ · Wavelength bandwidth $\lambda$ | nm | 1000 | 680 | 810 |
| | | Band Ⅱ · Average reflectance R | % | 92 | 95 | 78 |
| | | Presence or absence of reflection band continuously exhibiting reflectance of 75% or more over 100 nm or more | - | ○ | ○ | ○ |
| | | Band Ⅱ · Reflectance change $\sigma/R$ | % | 1.2 | 1.2 | 1.0 |
| | | $(\lambda \cdot R)/t$ | % | 1278 | 1374 | 1264 |
| | | Presence or absence of band exhibiting reflectance of 20% or more over range of 100 nm or more | - | ○ | ○ | ○ |
| | | Whether the reflectance of 80% or more is exhibited over the entire region of wavelength of 400 to 800 nm | - | ○ | ○ | × |
| | Adhesion | Crosscut peeling rate | % | 1 | 1 | 1 |
| | | Peeling rate after long-term reliability test | % | A | A | A |
| | Physical properties | Reflection lightness L* (SCE) | % | 14 | 15 | 15 |
| | | Flexural rigidity | N·m$^2$ | 1.2E-06 | 3.5E-07 | 4.2E-07 |
| | | Dynamic viscoelasticity measurement $T_H$-$T_L$ | °C | 78 | 78 | 78 |
| | Evaluation of molded article | Light permeability @ place of laminated film attachment | % | 5 | 3 | 15 |
| | | Thickness ratio of thickest portion to thinnest portion of laminated film | - | 1.2 | 1.2 | 1.2 |
| | | Electromagnetic wave permeability | - | A | A | A |
| | | Radar permeability | - | B | A | B |
| | Evaluation of screen display device | Brightness measurement | - | B | A | B |

INDUSTRIAL APPLICABILITY

Since the laminated film of the present invention has an ordered array composed of thermoplastic resin layers of three different types, it is possible to laminate thermoplastic resin layers having completely different skeleton structures and greatly differing in refractive index without allowing the occurrence of interlayer peeling thanks to the effect of the third thermoplastic resin layer serving as a buffer layer. As a result, it can be expected to expand the range of new functional addition beyond a trade-off frame, namely, interlayer peeling and optical characteristics of high reflectance and wide band, as compared with the conventional technique by which only thermoplastic resins having the same type of skeleton structure can be laminated. Furthermore, since interlayer peeling hardly occurs, an optical film suitable for long-term practical use can be obtained, and the optical film can be used for a long period of time without allowing the inherent optical characteristics to be impaired even in applications where the optical film is used for a long period of time, such as decorative molded films for automobiles and home electric appliances and optical films for displays.

DESCRIPTION OF REFERENCE SIGNS

1: Spectrum indicating relationship between depth in thickness direction of laminated film having ABCB ordered arrays and change of contrast (gray level)
2: Layer thickness of layer A
3: Layer thickness of layer B
4: Layer thickness of layer C
5: Layer thickness of interface layer of laminated film having AB alternately laminated array
6: Reflection optical spectrum
7: Reflection band $\Pi$
8: Wavelength bandwidth $\lambda$ of reflection band $\Pi$
9: Maximum reflectance of reflection band $\Pi$
10: Average reflectance R of reflection band $\Pi$
11: Loss tangent $\tan\delta$ spectrum in dynamic viscoelasticity measurement
12: Peak $P_L$ occurring on the lowest temperature side
13: Peak $P_H$ occurring on the highest temperature side
14: Low temperature side baseline
15: High temperature side baseline
16: Low temperature side temperature $T_L$ indicating an intermediate value between the peak top value of $P_L$ and the low temperature side baseline
17: High temperature side temperature $T_H$ indicating an intermediate value between the peak top value of $P_H$ and the high temperature side baseline
18: Light source unit
19: Center of light source unit
20: Point located on a straight line passing through the center of the light source unit and parallel to a long side of the light source unit, and located at the middle between an edge and the center of the light source unit
21: Point located on a straight line passing through the center of the light source unit and parallel to a short side of the light source unit, and located at the middle between an edge and the center of the light source unit

**Claims**

1. A laminated film continuously comprising three or more ordered arrays composed of thermoplastic resin layers of three different types, wherein the laminated film simultaneously satisfies the following conditions X and Y,

Condition X: where thermoplastic resin layers of three different types are denoted by layer A, layer B, and layer C, the thickness ratio A/B of the layer A to the layer B in an ordered array is 0.60 or more and 5.00 or less, and a thickness ratio C/B of the layer C to the layer B in an ordered array is 0.70 or more and 5.00 or less;
Condition Y: a maximum reflectance at a wavelength of 400 to 800 nm is 35% or more and 100% or less.

2. A laminated film continuously comprising three or more ordered arrays each composed of thermoplastic resin layers of three types differing in refractive index, wherein where the three types of thermoplastic resin layers are denoted by layer a, layer b, and layer c in descending order with respect to refractive index, ordered arrays exhibiting a thickness ratio a/b of the layer a to the layer b of 1.40 or more and a thickness ratio c/b of the layer c to the layer b of 1.40 or more exist 90% or more in all the ordered arrays, and the laminate film has a reflection band that exhibits a reflectance of 20% or more continuously over 100 nm or more in a wavelength range of 300 to 2600 nm.

3. A laminated film continuously comprising three or more ordered arrays each composed of thermoplastic resin layers of three different types, wherein the laminated film has a reflection band continuously exhibiting a reflectance of 75% or more over 100 nm or more in a wavelength range of 400 to 800 nm, and thermoplastic resin layers having a layer thickness of 1 nm or more and 25 nm or less account for 30% or more and 80% or less in number of all the thermoplastic resin layers constituting the ordered arrays.

4. The laminated film according to claim 1, wherein a thickness ratio A/C of the layer A to the layer C in the ordered array is 0.70 or more and 1.40 or less.

5. The laminated film according to claim 2, wherein the layers b are located every other layer in a thickness direction.

6. The laminated film according to claim 1 or 4, wherein a dielectric constant at a loss energy of 2.5 eV measured by electron energy loss spectroscopy (EELS measurement) is larger in a descending order of the layer A, the layer B, and the layer C.

7. The laminated film according to claim 3, wherein where the three types of thermoplastic resin layers are denoted by layer $\alpha$, layer $\beta$, and layer $\gamma$, a dielectric constant at a loss energy of 2.5 eV measured by electron energy loss spectroscopy (EELS measurement) is larger in a descending order of the layer $\alpha$, the layer $\beta$, and the layer $\gamma$.

8. The laminated film according to claim 3 or 7, wherein ordered arrays exhibiting a thickness ratio $\alpha/\beta$ of the layer $\alpha$ to the layer $\beta$ of 1.40 or more and a thickness ratio $\gamma/\beta$ of the layer $\gamma$ to the layer $\beta$ of 1.40 or more exist 90% or more in all the ordered arrays.

9. The laminated film according to any one of claims 1 to 8, wherein a grid peeling rate in an adhesion test based on a cross-cut method defined in JIS K 5600-5-6:1999 is 10% or less.

10. The laminated film according to any one of claims 1 to 9, wherein the laminated film has an average reflectance of 50% or more and 100% or less at a wavelength of 400 nm to 800 nm.

11. The laminated film according to any one of claims 1 to 10, wherein where $\lambda$ [nm] is a reflection bandwidth of a widest reflection band $\Pi$ where a reflectance of 20% or more is continuously exhibited over 100 nm or more in a wavelength range of 300 to 2600 nm, R [%] is an average reflectance in the reflection band, and t [$\mu$m] is a film thickness, $(\lambda \cdot R)/t$ is 820 or more and 1400 or less.

12. The laminated film according to any one of claims 1, 4, 6, and 9 to 11, wherein the ordered array is an array in which the layer A, the layer B, the layer C, and the layer B are located in this order.

13. The laminated film according to any one of claims 1, 2, 4 to 6, and 9 to 12, wherein thermoplastic resin layers having a layer thickness of 1 nm or more and 25 nm or less account for 30% or more and 80% or less in number of all the thermoplastic resin layers constituting the ordered arrays.

14. The laminated film according to any one of claims 1 to 13, wherein a dielectric constant ratio of a thermoplastic resin layer having the highest refractive index and a thermoplastic resin layer having the lowest refractive index obtained at a loss energy of 2.5 eV by electron energy loss spectroscopy (EELS measurement) is 1.10 or more and 1.60 or less.

15. The laminated film according to any one of claims 1 to 14, wherein the laminated film has a transmission lightness L*SCE (D65) of 0.1% or more and 30% or less.

16. The laminated film according to any one of claims 1 to 15, wherein a thickness of each layer contained in the ordered arrays exhibits a distribution in which the thickness monotonously increases from one surface toward an opposite surface.

17. The laminated film according to any one of claims 1 to 16, wherein at least one of the thermoplastic resin layers of three different types is a thermoplastic resin layer exhibiting crystallinity.

18. The laminated film according to claim 17, wherein a thermoplastic resin that is a main component of the thermoplastic resin layer exhibiting crystallinity is polyethylene terephthalate or polyethylene naphthalate.

19. The laminated film according to any one of claims 1 to 18, wherein the thermoplastic resin layers of three different types are a combination of thermoplastic resin layers exhibiting crystallinity/semi-crystallinity/amorphousness or crystallinity/amorphousness/amorphousness.

20. The laminated film according to claim 19, wherein the thermoplastic resin layer exhibiting amorphousness is mainly composed of either an acrylic or a polyester having an alicyclic structure.

21. The laminated film according to any one of claims 1 to 20, wherein the laminated film has a flexural rigidity of $0.5 \times 10^{-7}$ [N·m$^2$] or more and $5.2 \times 10^{-7}$ [N·m$^2$] or less.

22. The laminated film according to any one of claims 1 to 21, wherein where in dynamic viscoelasticity tan$\delta$ measurement at 0°C or more and 180°C or less, a peak occurring at the highest temperature side is denoted by $P_H$, a peak occurring at the lowest temperature side is denoted by $P_L$, a temperature on the high temperature side indicating an intermediate value between a peak top value of the PH and a high temperature side baseline is denoted by $T_H$ [°C], and a temperature on the low temperature side indicating an intermediate value between a peak top value of the PL and a low temperature side baseline is denoted by $T_L$ [°C], $T_H$ - $T_L$ is 60 or more and 120 or less.

23. An in-vehicle member comprising a protective layer, a print layer, an adhesive layer, and the laminated film according to any one of claims 1 to 22.

24. The in-vehicle member according to claim 23, wherein the laminated film has a thickness of 20 $\mu$m or more and 200 $\mu$m or less, and the protective layer has a thickness of 200 $\mu$m or more and 1 cm or less.

25. The in-vehicle member according to claim 23 or 24, wherein a thickness ratio of a thickest portion to a thinnest portion of the laminated film is 1.2 times or more and 2.5 times or less.

26. The in-vehicle member according to any one of claims 23 to 25, including a light-shielding region having a light permeability of 20% or less.

27. The in-vehicle member according to any one of claims 23 to 26, including a light-permeable region having a light permeability of 80% or more.

28. A vehicle comprising the in-vehicle member according to any one of claims 23 to 27, and a millimeter wave radar that exhibits a peak intensity at any of frequencies of 22 GHz to 26 GHz, 58 GHz to 62 GHz, and 76 GHz to 80 GHz.

29. A vehicle comprising a radar cover that transmits infrared rays, wherein the radar cover includes the in-vehicle member according to any one of claims 23 to 27.

30. An image display device comprising a screen protective layer, a light source, a transistor, and the laminated film according to any one of claims 1 to 22.

31. The image display device according to claim 30, wherein a display region has a shape other than a rectangle.

32. A lighting device having the laminated film according to any one of claims 1 to 22 on a back side of a light source.

33. The lighting device according to claim 32, wherein the laminated film has a three-dimensional shape.

34. A solar battery module comprising the laminated film according to any one of claims 1 to 22.

[FIG. 1]

[FIG. 2]

[FIG. 3]

EP 4 501 629 A1

【FIG. 4】

【FIG. 5】

EP 4 501 629 A1

【FIG. 6】

【FIG. 7】

EP 4 501 629 A1

【FIG. 8】

Reflectance [%]

13

12

15

14

11

16

17

Wavelength [nm]

[FIG. 9]

<div align="center">

**INTERNATIONAL SEARCH REPORT**

</div>

| | International application No. |
|---|---|
| | **PCT/JP2023/008766** |

**A.    CLASSIFICATION OF SUBJECT MATTER**

*B32B 27/00*(2006.01)i; *B32B 7/023*(2019.01)i
FI:    B32B27/00 B; B32B7/023

According to International Patent Classification (IPC) or to both national classification and IPC

**B.    FIELDS SEARCHED**

Minimum documentation searched (classification system followed by classification symbols)

B32B7/023; B32B27/00; G02B5/26-5/28

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C.    DOCUMENTS CONSIDERED TO BE RELEVANT**

| Category* | Citation of document, with indication, where appropriate, of the relevant passages | Relevant to claim No. |
|---|---|---|
| A | JP 3067863 B2 (MINNESOTA MINING & MFG. CO.) 24 July 2000 (2000-07-24)<br>entire text | 1-34 |
| A | JP 2019-511400 A (3M INNOVATIVE PROPERTIES CO.) 25 April 2019 (2019-04-25)<br>entire text | 1-34 |
| A | WO 2012/176627 A1 (KONICA MINOLTA HOLDINGS, INC.) 27 December 2012 (2012-12-27)<br>entire text | 1-34 |
| A | WO 2016/148141 A1 (TORAY INDUSTRIES, INC.) 22 September 2016 (2016-09-22)<br>entire text | 1-34 |
| A | JP 2019-168264 A (TOYODA GOSEI CO., LTD.) 03 October 2019 (2019-10-03)<br>entire text | 1-34 |
| A | US 2020/0171803 A1 (SABIC GLOBAL TECHNOLOGIES B.V.) 04 June 2020 (2020-06-04)<br>entire text | 1-34 |

☑ Further documents are listed in the continuation of Box C.          ☑ See patent family annex.

| | |
|---|---|
| *    Special categories of cited documents:<br>"A"    document defining the general state of the art which is not considered to be of particular relevance<br>"E"    earlier application or patent but published on or after the international filing date<br>"L"    document which may throw doubts on priority claim(s) or which is cited to establish the publication date of another citation or other special reason (as specified)<br>"O"    document referring to an oral disclosure, use, exhibition or other means<br>"P"    document published prior to the international filing date but later than the priority date claimed | "T"    later document published after the international filing date or priority date and not in conflict with the application but cited to understand the principle or theory underlying the invention<br>"X"    document of particular relevance; the claimed invention cannot be considered novel or cannot be considered to involve an inventive step when the document is taken alone<br>"Y"    document of particular relevance; the claimed invention cannot be considered to involve an inventive step when the document is combined with one or more other such documents, such combination being obvious to a person skilled in the art<br>"&"    document member of the same patent family |

| Date of the actual completion of the international search | Date of mailing of the international search report |
|---|---|
| **02 May 2023** | **16 May 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2023/008766**

| C. | DOCUMENTS CONSIDERED TO BE RELEVANT | |
|---|---|---|
| Category* | Citation of document, with indication, where appropriate, of the relevant passages | Relevant to claim No. |
| A | WO 2020/244219 A1 (XIN YAND SUNNY OPTICS CO., LTD.) 10 December 2020 (2020-12-10)<br>entire text | 1-34 |

Form PCT/ISA/210 (second sheet) (January 2015)

**INTERNATIONAL SEARCH REPORT**

International application No.

**PCT/JP2023/008766**

**Box No. III    Observations where unity of invention is lacking (Continuation of item 3 of first sheet)**

This International Searching Authority found multiple inventions in this international application, as follows:

(1) The number of inventions set forth in the claims of the international application is three and the claims are classified into the following inventions:
invention 1; claims 1, 4, 6 and 9-34,
invention 2; claims 2 and 5, and
invention 3; claims 3, 7 and 8.

(2) For the reasons indicated below, this international application is considered to not conform to the requirement for unity of invention (Regulations under the PCT, Rule 13 (PCT Rules 13.1, 13.2, and 13.3)).

1. Determination of main invention
    The invention in claim 1 has the STF of a "multilayer film characterized in that the multilayer film has three or more regular arrays in series of three different thermoplastic resin layers and fulfills the conditions X and Y indicated below at the same time: condition X: provided that the three different thermoplastic resin layers are layers A, B and C, the thickness ratio A/B of the layer A to the layer B in the regular array is 0.60-5.00 inclusive and the thickness ratio C/B of the layer C to the layer B in the regular array is 0.70-5.00 inclusive; and condition Y: the maximum reflectance in the wavelength 400-800 nm is 35%-100% inclusive".
    Claims 4, 6 and 9-34 have the same STF as the above STF, and are thus classified as the main invention.
    Claims 2, 3, 5, 7 and 8 do not share a same or corresponding STF with the above STF, and are not inventions that are substantially identical thereto or similarly closely related thereto, and are thus not classified as the main invention.

2. Additional invention 1
    Additional invention 1 is identified for claims 2, 3, 5, 7 and 8 except for the inventions in claims 1, 4, 6 and 9-34 classified as the main invention.
    The invention in claim 2 has the STF of a "multilayer film characterized in that the multilayer film has three or more regular arrays in series of three different thermoplastic resin layers with different refractive indices, the multilayer film has 90% or more regular arrays that have, provided that the three thermoplastic resin layers are referred to as layers a, b and c in order of refractive index, the thickness ratio a/b of the layer a to the layer b in the regular array and the thickness ratio c/b of the layer c to the layer b of 1.40 or more, and the multilayer film has a reflex zone exhibiting a reflectance of 20% or more continuously over 100 nm or more in the wavelength range of 300-2,600 nm".
    Claim 5 has the same STF as the STF of claim 2, and is thus classified as additional invention 1.
    It is clear that claims 3, 7 and 8 do not share a same or corresponding STF with the STF of claim 2, and are also not inventions that are substantially identical thereto or similarly closely related thereto.
    Consequently, claims 3, 7 and 8 do not share a same or corresponding STF with the STF of claim 2, and are also not inventions that are substantially identical thereto or similarly closely related thereto, and are thus not classified as additional invention 1.

3. Additional invention 2
Additional invention 2 is identified for claims 3, 7 and 8 except for the inventions in the claims classified as either the main invention or additional invention 1.
    The invention in claim 3 has the STF of a "multilayer film characterized in that the multilayer film has three or more regular arrays in series of three different thermoplastic resin layers, the multilayer film has a reflex zone exhibiting a reflectance of 75% or more continuously over 100 nm or more in the wavelength range of 400-800 nm, and 30%-80% inclusive of all thermoplastic resin layers forming the regular arrays are thermoplastic resin layers having a thickness of 1 nm-25 nm inclusive".
    Claims 7 and 8 have the same STF as the STF of claim 3 and are thus classified as additional invention 2.

4. Number of inventions
    Consequently, the number of additional inventions is two, and the number of inventions in the claims is calculated to be three by adding one, which is the number of main invention, to the number of additional inventions.

Form PCT/ISA/210 (continuation of first sheet) (January 2015)

**EP 4 501 629 A1**

**INTERNATIONAL SEARCH REPORT**

| International application No. |
| --- |
| **PCT/JP2023/008766** |

| **Box No. III** | **Observations where unity of invention is lacking (Continuation of item 3 of first sheet)** |
| --- | --- |

1. ☑ As all required additional search fees were timely paid by the applicant, this international search report covers all searchable claims.

2. ☐ As all searchable claims could be searched without effort justifying additional fees, this Authority did not invite payment of additional fees.

3. ☐ As only some of the required additional search fees were timely paid by the applicant, this international search report covers only those claims for which fees were paid, specifically claims Nos.:

4. ☐ No required additional search fees were timely paid by the applicant. Consequently, this international search report is restricted to the invention first mentioned in the claims; it is covered by claims Nos.:

**Remark on Protest**   ☐ The additional search fees were accompanied by the applicant's protest and, where applicable, the payment of a protest fee.

☐ The additional search fees were accompanied by the applicant's protest but the applicable protest fee was not paid within the time limit specified in the invitation.

☑ No protest accompanied the payment of additional search fees.

Form PCT/ISA/210 (continuation of first sheet) (January 2015)

**INTERNATIONAL SEARCH REPORT**
Information on patent family members

International application No.

**PCT/JP2023/008766**

| Patent document cited in search report | | | Publication date (day/month/year) | Patent family member(s) | | | Publication date (day/month/year) |
|---|---|---|---|---|---|---|---|
| JP | 3067863 | B2 | 24 July 2000 | US | 5103337 | A | |
| | | | | TW | 204397 | B | |
| | | | | KR | 10-1992-0002326 | A | |
| | | | | JP | 4-313704 | A | |
| | | | | EP | 469732 | A2 | |
| | | | | CA | 2047603 | A1 | |
| JP | 2019-511400 | A | 25 April 2019 | US | 2019/0111666 | A1 | |
| | | | | WO | 2017/172564 | A2 | |
| | | | | EP | 3436263 | A2 | |
| | | | | CN | 108883617 | A | |
| | | | | KR | 10-2018-0132752 | A | |
| WO | 2012/176627 | A1 | 27 December 2012 | US | 2014/0192413 | A1 | |
| | | | | EP | 2725395 | A1 | |
| | | | | CN | 103635838 | A | |
| WO | 2016/148141 | A1 | 22 September 2016 | CN | 107407755 | A | |
| | | | | KR | 10-2017-0126460 | A | |
| | | | | TW | 201641274 | A | |
| JP | 2019-168264 | A | 03 October 2019 | US | 2019/0293485 | A1 | |
| | | | | CN | 110297226 | A | |
| US | 2020/0171803 | A1 | 04 June 2020 | WO | 2019/038640 | A1 | |
| | | | | EP | 3678862 | A1 | |
| | | | | CN | 111032347 | A | |
| | | | | KR | 10-2020-0043387 | A | |
| WO | 2020/244219 | A1 | 10 December 2020 | US | 2022/0120949 | A1 | |
| | | | | KR | 10-2022-0002319 | A | |
| | | | | JP | 2022-541974 | A | |
| | | | | EP | 3982172 | A1 | |
| | | | | CN | 110082849 | A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2013210598 A
- JP 2004503402 W
- JP H08503312 W

- US 5360659 A
- JP 2018205615 A